# EUROPEAN PATENT APPLICATION

(11) **EP 2 184 642 A2**
(43) Date of publication of application: **12.05.2010**
(21) Application number: 09012390.2
(22) Date of filing: 30.09.2009
(51) Int. Cl.: G03F 7/027, G03F 7/11, B41C 1/10, G03F 7/32

(54) **Lithographic printing plate precursor and method of preparing lithographic printing plate**

(30) Priority: 30.09.2008 JP 2008255517
(71) Applicant: FUJIFILM Corporation, Minato-ku Tokyo (JP)
(72) Inventor: Oohashi, Hidekazu, Shizuoka (JP)
(74) Representative: HOFFMANN EITLE

(57) **Abstract**

A lithographic printing plate precursor capable of being developed with a developer having pH of from 2 to 11, including, in the following order: a support; au undercoat layer containing a polymer compound having at least a unit containing a support-adsorbing group and a unit containing a hydrophilic group; and a photosensitive layer containing a pigment which does not adsorb to the polymer compound.

## Description

### FIELD OF THE INVENTION

The present invention relates to a lithographic printing plate precursor capable of being developed with an aqueous developer having pH of 2o 11, particularly to a lithographic printing plate precursor which provides a lithographic printing plate excellent in view of stain and remaining color and a method of preparing a lithographic printing plate using the lithographic printing plate precursor.

### BACKGROUND OF THE INVENTION

Heretofore, a lithographic printing plate precursor comprises a photosensitive resin layer provided on a support having a hydrophilic surface. As for a method of preparing a lithographic printing plate, the lithographic printing plate precursor is ordinarily subjected to open frame exposure (mask exposure) via a lith film and then removal of the non-image area with a developer having high pH to obtain a desired printing plate. However, with the recent digitized techniques, a computer-to-plate (CTP) technique of directly conducting exposure process on the surface of the lithographic printing plate precursor by scanning according to digitized image data with highly convergent light, for example, a laser beam, without using a lith film has been developed. Photosensitive lithographic printing plates (lithographic printing plate precursors) adapted for the technique have also been developed.

As the lithographic printing plate precursors suitable for exposure with a laser beam, lithographic printing plate precursors having a polymerizable photosensitive layer are exemplified. In the polymerizable photosensitive layer, it is easily enable to increase sensitivity by appropriately selecting a polymerization initiator or a polymerization initiation system (hereinafter also simply referred to as an "initiator" and an "initiation system", respectively) in comparison with other conventional photosensitive layers.

As the laser light source, for example, a semiconductor laser of 405 nm or 830 nm or an FD-YAG laser can be used. In recent years, a CTP system equipped with a semiconductor laser of 405 nm has become widespread in view of system cost and handling properties.

In the hitherto known plate making process of lithographic printing plate precursor, after the exposure as described above, the step of removing the unnecessary image-recording layer by dissolving, for example, with a developer is required. However, it is one of the subjects to save or simplify such an additional wet treatment. Particularly, since disposal of liquid wastes discharged accompanying the wet treatment has become a great concern throughout the field of industry in view of the consideration for global environment in recent years, the demand for the solution of the above-described subject has been increased more and more.

As one of simple plate-making methods in response to the above-described requirement, a simple development processing with an aqueous weak alkaline to weak acidic solution has been proposed. In such a development processing, an aqueous solution having pH of 11 or less is ordinarily used. For instance, in U.S. Patent Publication No. 2004/0013968 is described a processing method of lithographic printing plate precursor which comprises exposing imagewise with an infrared laser a lithographic printing plate precursor comprising a hydrophilic support and an oleophilic heat-sensitive layer which contains a radical-polymerizable ethylenically unsaturated monomer, a radical polymerization initiator and an infrared absorbing dye, is hardened with infrared laser exposure and is developable with an aqueous developer containing 60% by weight or more of water and having pH of 2.0 to 10.0, and removing the unhardened region of the heat-sensitive layer with the aqueous developer.

On the other hand, as for the lithographic printing plate precursor, it is ordinarily conducted to incorporate a plate-inspecting agent (a coloring agent, for example, a dye or pigment) into the image-recording layer of lithographic printing plate precursor in order to easily check the image-forming property.

Among them, as the plate-inspecting agent incorporated into the image-recording layer of lithographic printing plate precursor of photopolymerization type, a pigment is often used because the pigment has an advantage of not inhibiting the photopolymerization. In order to improve dispersibility of the pigment, it is conventional to coat the pigment with a polymer or to substitute the surface of pigment with an acid group, base group or the like. However, for the lithographic printing plate precursor of simple development processing type with an aqueous weak alkaline to weak acidic solution, the pigment in the non-image area can not be completely removed by the development and a problem arises in that the color remains in the non-image area and stain occurs during printing. With respect to a conventional lithographic printing plate precursor using an alkali developer having high pH, because of two points that the surface of aluminum support is somewhat dissolved with the aqueous alkali solution at the development and that an undercoat layer is removed with the aqueous alkali solution at the development, the problems of remaining color and stain do not arise even when any pigment is used. Therefore, the problems described above are specific phenomena for the lithographic printing plate precursor using the weak alkaline to weak acidic developer.

### SUMMARY OF THE INVENTION

An object of the present invention is to provide a lithographic printing plate precursor of simple development processing type with an aqueous weak alkaline to weak acidic solution in which pigment in the non-image area can be well removed by the development and thus, the plate inspecting property can be improved due to the absence of remaining color in the non-image area and the occurrence of stain during printing can be prevented, and a method of preparing a lithographic printing plate using the lithographic printing plate precursor.

As a result of the intensive investigations to achieve the above-described object, the inventor has found that the above-described object can be achieved by a lithographic printing plate precursor capable of being developed with a developer having pH of 2 to 11 which comprises a support, au undercoat layer containing a polymer compound having at least a support-adsorbing group and a hydrophilic group and a photosensitive layer containing a pigment which does not adsorb to the polymer compound and a method of preparing a lithographic printing plate using the lithographic printing plate precursor to complete the invention.
Specifically, the present invention includes the following items.
(1) A lithographic printing plate precursor capable of being developed with a developer having pH of 2 to 11 comprising, in the following order: a support; au undercoat layer containing a polymer compound having at least (A1) a unit containing a support-adsorbing group and (A2) a unit containing a hydrophilic group; and a photosensitive layer containing a pigment which does not adsorb to the polymer compound.
(2) The lithographic printing plate precursor as described in (1) above, wherein the pigment is a pigment dispersed with a pigment dispersant having a unit containing a pigment-adsorbing group, and the hydrophilic group and the pigment-adsorbing group satisfy at least one of the following conditions 1 and 2:
   Condition 1: When the hydrophilic group is an acidic group and the pigment-adsorbing group is an acidic group, pKa of the hydrophilic group > pKa of the pigment-adsorbing group;
   Condition 2: When the hydrophilic group is a basic group and the pigment-adsorbing group is a basic group, pKa of a conjugate acid of the hydrophilic group < pKa of a conjugate acid of the pigment-adsorbing group.
(3) The lithographic printing plate precursor as described in (2) above, wherein the acidic group is selected from a carboxyl group, a sulfonic acid group, a phosphoric acid group, a phosphonic acid group and a sulfuric acid group and the basic group is selected from an amino group.
(4) The lithographic printing plate precursor as described in (2) above, wherein the pigment-adsorbing group is selected from functional groups represented by formulae (A-1) to (A-5) and (B-1): 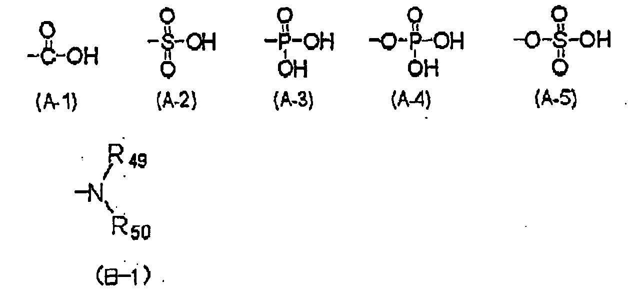 In formula (B-1), R₄₉ and R₅₀ each independently represents an alkyl group, an aryl group, an alkenyl group, an alkynyl group, -OR, -NRR', -SR, -COR, -COOR, -CONRR', -OCOR, -OCONRR', -OCOOR, -NRCOR', -NRCOOR', -NRCONR'R", -N=R, -SO₂R, -SO₃R, -SO₂NRR', a hydrogen atom, a halogen atom, a cyano group, a nitro group, a hydroxy group or a mercapto group (wherein R, R' and R" each independently represents an alkyl group, an aryl group, an alkenyl group, an alkynyl group or a hydrogen atom or may be connected with each other to form a ring) or R₄₉ and Rso may be connected with each other to form a ring.
(5) The lithographic printing plate precursor as described in (4) above, wherein the pigment-adsorbing group is selected from the functional groups represented by formulae (A-2), (A-5) and (B-1).
(6) The lithographic printing plate precursor as described in any one of (1) to (5) above, wherein the photosensitive layer further contains a radical polymerizable compound, a radical polymerization initiator, a sensitizing dye, a co-sensitizer and a binder polymer.
(7) The lithographic printing plate precursor as described in any one of (1) to (6) above, which further comprises a protective layer on the photosensitive layer.
(8) A method of preparing a lithographic printing plate comprising exposing imagewise a lithographic printing plate precursor comprising in the following order, a support, au undercoat layer containing a polymer compound having at least (A1) a unit containing a support-adsorbing group and (A2) a unit containing a hydrophilic group and a photosensitive layer containing a pigment which does not adsorb to the polymer compound with a laser and removing an unexposed area of the photosensitive layer in the presence of a developer having pH of 2 to 11.
(9) The method of preparing a lithographic printing plate as described in (8) above, wherein the pigment is a pigment dispersed with a pigment dispersant having a unit containing a pigment-adsorbing group, and the hydrophilic group and the pigment-adsorbing group satisfy at least one of the following conditions 1 and 2;
   Condition 1: When the hydrophilic group is an acidic group and the pigment-adsorbing group is an acidic group, pKa of the hydrophilic group > pKa of the pigment-adsorbing group;
   Condition 2: When the hydrophilic group is a basic group and the pigment-adsorbing group is a basic group, pKa of a conjugate acid of the hydrophilic group < pKa of a conjugate acid of the pigment-adsorbing group.
(10) The method of preparing a lithographic printing plate as described in (9) above, wherein the acidic group is selected from a carboxyl group, a sulfonic acid group, a phosphoric acid group, a phosphonic acid group and a sulfuric acid group and the basic group is selected from an amino group.
(11) The method of preparing a lithographic printing plate as described in (9) above, wherein the pigment-adsorbing group is selected from functional groups represented by formulae (A-1) to (A-5) and (B-1): 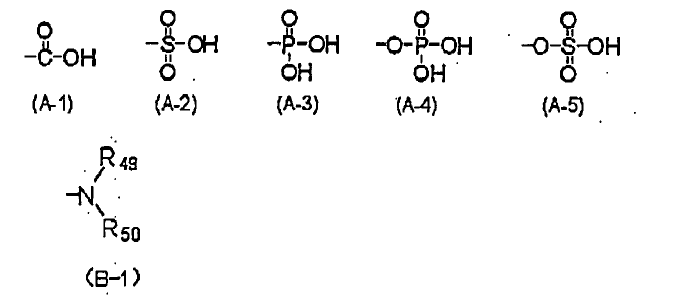 In formula (B-1), R₄₉ and R₅₀ each independently represents an alkyl group, an aryl group, an alkynyl group, an alkynyl group, -OR, -NRR', -SR, -COR, -COOR, -CONRR', -OCOR, -OCONRR', -OCOOR, -NRCOR', -NRCOOR', -NRCONR'R", -N=R, -SO₂R, -SO₃R, -SO₂NRR', a hydrogen atom, a halogen atom, a cyano group, a nitro group, a hydroxy group or a mercapto group (wherein R, R' and R" each independently represents an alkyl group, an aryl group, an alkenyl group, an alkynyl group or a hydrogen atom or may be connected with each other to form a ring) or R₄₉ and R₅₀ may be connected with each other to form a ring.
(12) The method of preparing a lithographic printing plate as described in (11) above, wherein the pigment-adsorbing group is selected from the functional groups represented by formulae (A-2), (A-5) and (B-1).
(13) The method of preparing a lithographic printing plate as described in any one of (8) to (12) above, wherein the photosensitive layer further contains a radical polymerizable compound, a radical polymerization initiator, a sensitizing dye, a co-sensitizer and a binder polymer.
(14) The method of preparing a lithographic printing plate as described in any one of (8) to (13) above, wherein the lithographic printing plate precursor further comprises a protective layer on the photosensitive layer.
(15) The method of preparing a lithographic printing plate as described in any one of (8) to (14) above, wherein after the imagewise exposure of the lithographic printing plate precursor with a laser, the exposed lithographic printing plate precursor is heated at temperature of 70°C or more and then the unexposed area of the photosensitive layer is removed in the presence of a developer having pH of 2 to 11.

According to the present invention, a lithographic printing plate precursor of simple development processing type with an aqueous weak alkaline to weak acidic solution in which pigment in the non-image area can be well removed by the development and thus, the plate inspecting property can be improved due to the absence of remaining color in the non-image area and the occurrence of stain during printing can be prevented, and a method of preparing a lithographic printing plate using the lithographic printing plate precursor can be provided.

### BRIEF DESCRIPTION OF THE DRAWINGS

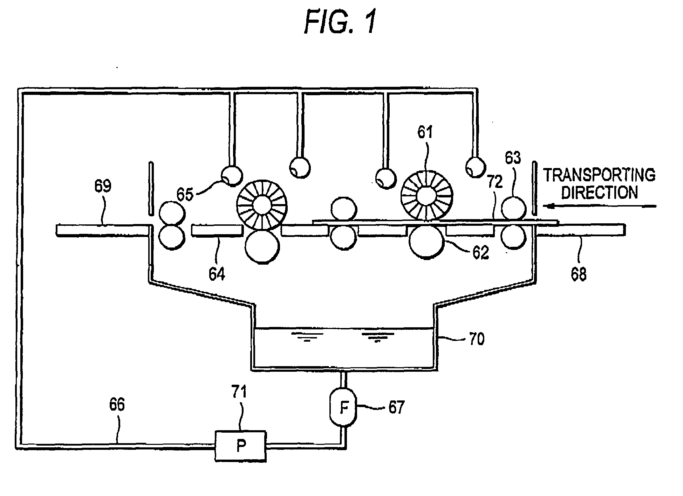

Fig. 1 is an illustration for showing a structure of an automatic development processor.

### [Description of reference numerals and signs]

- 61:: Rotating brush roller
- 62:: Backing roller
- 63:: Transport roller
- 64:: Transport guide plate
- 65:: Spray pipe
- 66:: Pipe line
- 67:: Filter
- 68:: Plate supply table
- 69:: Plate discharge table
- 70:: Developer tank
- 71:: Circulating pump
- 72:: Lithographic printing plate precursor

### DETAILED DESCRIPTION OF THE INVENTION

According to the investigations by the inventor, it has been found that in the case where a photosensitive layer containing a pigment dispersed with a pigment dispersant having a pigment-adsorbing group is applied to an undercoat layer containing a polymer compound having at least (A1) a unit containing a support-adsorbing group and (A2) a unit containing a hydrophilic group, the remaining color and stain become remarkably under certain specific conditions. Specifically, in the case wherein the pigment-adsorbing group has acidity lower than acidity of the hydrophilic group of (A2) in the undercoat layer or in the case wherein the pigment-adsorbing group has basicity lower than basicity of the hydrophilic group of (A2) in the undercoat layer, the remaining color and stain become remarkably. The reason for this is presumed that since the adsorptivity of the hydrophilic group of (A2) in the undercoat layer to pigment is stronger than that of the pigment-adsorbing group in the pigment dispersant, the pigment dispersant is released from the pigment and replaced with the hydrophilic group of (A2) in the undercoat layer to adsorb the pigment to the undercoat layer after coating of the photosensitive layer in the preparation of lithographic printing plate precursor and as a result, the pigment remains on the surface of the undercoat layer after development (since the undercoat layer contains the support-adsorbing group of (A1), it is not removed with the weak alkaline to weak acidic developer) to cause the problems of remaining color and stain. In the lithographic printing plate precursor according to the invention, the photosensitive layer containing a pigment dispersed using a pigment dispersant containing pigment-adsorbing group having the adsorptivity stronger than that of the hydrophilic group of (A2) in the undercoat layer is provided on the undercoat layer to prevent the adsorption of the pigment to the undercoat layer, thereby solving the problems described above.

The lithographic printing plate precursor according to the invention is described in more detail below. The lithographic printing plate precursor according to the invention is capable of being developed with a developer having pH of 2 to 11 and comprises, in the following order, a support, au undercoat layer containing a polymer compound having at least (A1) a unit containing a support-adsorbing group and (A2) a unit containing a hydrophilic group and a photosensitive layer containing a pigment which does not adsorb to the polymer compound.

### [Undercoat layer]

The undercoat layer of the lithographic printing plate precursor according to the invention contains as the mandatory component, a polymer compound (hereinafter, also simply referred to as a polymer compound) having at least (A1) a unit containing a support-adsorbing group and (A2) a unit containing a hydrophilic group and may contain an optional component, for example, a surfactant, a polymerization inhibitor, an initiator, a sensitizing dye or a co-sensitizer, if desired.
Each component constituting the undercoat layer will be described below.

### <Polymer compound>

The polymer compound for use in the invention is described below.

The polymer compound for use in the invention is a polymer compound having at least (A1) a unit containing a support-adsorbing group and (A2) a unit containing a hydrophilic group. (A1) Unit containing support-adsorbing group

The unit containing a support-adsorbing group for use in the invention is a unit derived from a low molecular compound (molecular weight of 1,000 or less) containing a support-adsorbing group. The low molecular compound includes a monomer having a support-adsorbing group in which the support-adsorbing group and the polymerizable double bond group are connected directly or through a connecting chain. The connecting chain may be any connecting chain and is ordinarily formed from one or more atoms selected from a carbon atom, an oxygen atom, a nitrogen atom, a sulfur atom, a phosphorus atom, a silicon atom, a hydrogen atom, a halogen atom and a boron atom.

The support-adsorbing group for use in the invention may be variously selected depending on the support used. For instance, in the case of an aluminum support which is heretofore preferably used in a lithographic printing plate precursor, a functional group, for example, a phosphoric acid group or its salt group, a phosphonic acid group or its salt group, an ammonium group, a siloxane group, a β-dicarbonyl group or a carboxylic acid group or its salt group is exemplified, although the specific support-adsorbing group may be varied depending on the surface treatment of the support. The support-adsorbing group preferably includes a phosphoric acid (or phosphate) group, a phosphonic acid (or phosphonate) group, an ammonium group, a siloxane group, a β-dicarbonyl group and a carboxylic acid (or carboxylate) group. The support-adsorbing groups may be used in combination of two or more thereof.

The amount of the support-adsorbing group introduced into the polymer compound for use in the invention is preferably from 0.01 to 10 mmol/g, more preferably from 0.05 to 5 mmol/g, and particularly preferably from 0.1 to 3 mmol/g.

### (A2) Unit containing hydrophilic group

The unit containing a hydrophilic group for use in the invention is a unit derived from a low molecular compound (molecular weight of 1,000 or less) containing a hydrophilic group. The low molecular compound includes a monomer having a hydrophilic group in which the hydrophilic group and the polymerizable double bond group are connected directly or through a connecting chain. The connecting chain may be any connecting chain and is ordinarily formed from one or more atoms selected from a carbon atom, an oxygen atom, a nitrogen atom, a sulfur atom, a phosphorus atom, a silicon atom, a hydrogen atom, a halogen atom and a boron atom.

The hydrophilic group for use in the invention may be any functional group conventionally known as a hydrophilic functional group and is preferably an acidic functional group or a basic functional group.

The acidic functional group preferably includes a sulfonic acid group, a carboxylic acid group, a phosphoric acid group, a phosphonic acid group and a sulfuric acid group, more preferably a sulfonic acid group, a phosphoric acid group, a phosphonic acid group and a sulfuric acid group, and particularly preferably a sulfonic acid group. The acidic functional groups may be used in combination of two or more thereof.

The basic functional group includes an amino group, and preferably an amino group represented by the following formula (I):

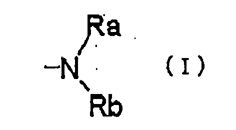

In formula (I), Rₐ and R_{b} each independently represents a hydrogen atom or an alkyl group, an alkenyl group, an alkynyl group, an aryl group or a heterocyclic group, each having 10 or less carbon atoms, or Rₐ and R_{b} may be combined with each other to form a ring.

Rₐ and R_{b} each preferably represents a hydrogen atom or an alkyl group, an alkenyl group or an alkynyl group, each having 8 or less carbon atoms, more preferably a hydrogen atom or an alkyl group, an alkenyl group or an alkynyl group, each having 6 or less carbon atoms, particularly preferably a hydrogen atom or an alkyl group, an alkenyl group or an alkynyl group, each having 4 or less carbon atoms, and most preferably a hydrogen atom or an alkyl group having 2 or less carbon atoms. The basic functional groups may be used in combination of two or more thereof.

The amount of the hydrophilic group introduced into the polymer compound for use in the invention is preferably from 0.01 to 10 mmol/g, more preferably from 0.05 to 7.5 mmol/g, and particularly preferably from 0.1 to 5 mmol/g.

### (Unit containing other functional group)

It is preferred that the polymer compound for use in the invention has a unit containing a functional group capable of interacting with the photosensitive layer in addition to (A1) the unit containing a support-adsorbing group and (A2) the unit containing a hydrophilic group.

The unit containing other functional group for use in the invention is a unit derived from a low molecular compound (molecular weight of 1,000 or less) containing other functional group. The low molecular compound includes a monomer having other functional group in which the other functional group and the polymerizable double bond group are connected directly or through a connecting chain. The connecting chain may be any connecting chain and is ordinarily formed from one or more atoms selected from a carbon atom, an oxygen atom, a nitrogen atom, a sulfur atom, a phosphorus atom, a silicon atom, a hydrogen atom, a halogen atom and a boron atom.

The functional group capable of interacting with the photosensitive layer includes (A3) an ethylenically unsaturated double bond group, (A4) a hydrogen bond-forming group and (A5) a hydrophobic group. These functional groups are described below.

### (A3) Ethylenically unsaturated double bond group

As the ethylenically unsaturated double bond group for use in the polymer compound according to the invention any group containing an ethylenically unsaturated double bond which generates a polymerization reaction by a radical may be suitably used and functional groups represented by formulae (c1) to (c3) shown below are particularly preferably used.

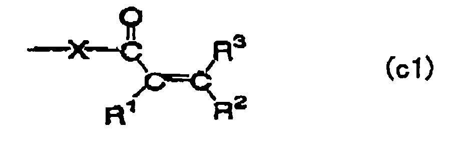

In formula (c1), R¹ to R³ each independently represents a hydrogen atom or a monovalent organic group.

R₁ preferably represents, for example, a hydrogen atom or an alkyl group which may have a substituent. Among them, a hydrogen atom, a methyl group or a -CH₂Q group is more preferable because of high radical reactivity.

Q represents a halogen atom, a cyano group, an -OR¹⁴ group, an -OCOR¹⁴ group, an -OCONR¹⁴R¹⁵ group, an -OCOOR¹⁴ group, an -OSO₂R¹⁴ group, an -OPO(OR¹⁴)(OR¹⁵) group, an -OPOR¹⁴(OR¹⁵) group, an -NR¹⁴R¹⁵ group, an -NR¹⁴COR¹⁵ group, an -NR¹⁴COOR¹⁵ group, an -NR¹⁴CONR¹⁵R¹⁶ group, an -NR¹⁴SO₂R¹⁵ group, an -N(SO₂R¹⁴)(SO₂R¹⁵) group, an -N(COR¹⁴)(COR¹⁵) group, an -SR¹⁴ group, an -SOR¹⁴ group, an -SOR¹⁴ group, an -SO₃R¹⁴ group, -SO₂NR¹⁴R¹⁵ group or a -PO(OR¹⁴)(OR¹⁵) group, and is preferably a halogen atom, a cyano group, an -OR¹⁴ group, an -OCOR¹⁴ group, an -OCONR¹⁴R¹⁵ group, an -OCOOR¹⁴ group, -NR¹⁴R¹⁵ group, an -NR¹⁴COR¹⁵ group, an -NR¹⁴COOR¹⁵ group, -NR¹⁴CONR¹⁵R¹⁶ group or -SR¹⁴.

R¹⁴ to R¹⁶ each independently represents a hydrogen atom, an alkyl group which may have a substituent, an aryl group which may have a substituent, an alkynyl group which may have a substituent or an alkenyl group which may have a substituent.

R² and R³ each independently preferably represents a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent or an arylsulfonyl group which may have a substituent. Among them, a hydrogen atom, a carboxyl group, an alkoxycarbonyl group, an alkyl group which may have a substituent or an aryl group which may have a substituent is more preferable because of high radical reactivity.

X represents an oxygen atom, a sulfur atom or -N(R¹²)-, and R¹² represents a hydrogen atom or a monovalent organic group. The monovalent organic group represented by R¹² includes, for example, an alkyl group which may have a substituent. R¹² is preferably a hydrogen atom, a methyl group, an ethyl group or an isopropyl group because of high radical reactivity.

Examples of the substituent capable of being introduced include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group and an arylsulfonyl group.

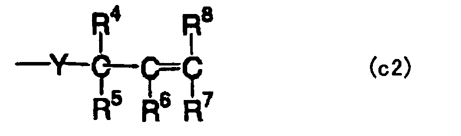

In formula (c2), R⁴ to R⁸ each independently represents a hydrogen atom or a monovalent organic group.

R⁴ to R⁸ each independently preferably represents a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent or an arylsulfonyl group which may have a substituent. Among them, a hydrogen atom, a carboxyl group, an alkoxycarbonyl group, an alkyl group which may have a substituent or an aryl group which may have a substituent is more preferable. Examples of the substituent capable of being introduced are same as those described in formula (c1) above. Y represents an oxygen atom, a sulfur atom or -N(R¹²)-, and R₁₂ has the same meaning as R¹² defined in formula (c1) above and preferable examples thereof are also same as those described in formula (c1) above.

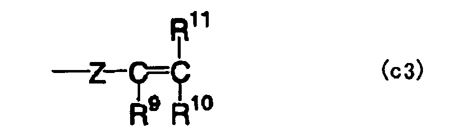

In formula (c3), R⁹ to R¹¹ each independently represents a hydrogen atom or a monovalent organic group.

The monovalent organic group represented by R⁹ includes, for example, an alkyl group which may have a substituent. R⁹ is preferably a hydrogen atom or a methyl group because of high radical reactivity.

R¹⁰ to R¹¹ each independently preferably represents a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent or an arylsulfonyl group which may have a substituent. Among them, a hydrogen atom, a carboxyl group, an alkoxycarbonyl group, an alkyl group which may have a substituent or an aryl group which may have a substituent is more preferable because of high radical reactivity. Examples of the substituent capable of being introduced are same as those described in formula (c1) above.

Z represents an oxygen atom, a sulfur atom or -N(R¹³)- or a phenylene group which may have a substituent and R¹³ includes an alkyl group which may have a substituent and is preferably a methyl group, an ethyl group or an isopropyl group because of high radical reactivity.

When the polymer compound contains the ethylenically unsaturated double bond group, only one, two or more of the same kind or two or more different kinds of the ethylenically unsaturated double bond groups may be present in the polymer compound.

The amount of the ethylenically unsaturated double bond group introduced into the polymer compound for use in the invention is preferably from 0.01 to 10 mmol/g, more preferably from 0.05 to 5 mmol/g, and particularly preferably from 0.1 to 3 mmol/g. (A4) Hydrogen bond-forming group

The hydrogen bond-forming group for use in the invention may be appropriately selected depending on the components contained in the photosensitive layer and includes a hydrogen accepting group, for example, an alkylene oxide group represented by -[(CR11R12)ₙO]ₘ-R13 (wherein R11 and R12 each independently represents a hydrogen atom, an alkyl group, an aryl group, an alkenyl group or an alkynyl group, R13 represents a hydrogen atom, an alkyl group, an aryl group, an alkenyl group, an alkynyl group, an alkylacyl group, an arylacyl group, an alkylaminoacyl group, an arylaminoacyl group, an alkylsulfone group or an arylsulfone group, and n and m each independently represents a natural number), an amino group represented by -NR11R12 (wherein R11 and R12 have the same meanings as defined above, respectively), a carbonyl group represented by -CO- or a nitrogen-containing heterocyclic group having an -N= structure, and a hydrogen donating group, for example, a carboxylic acid group represented by -COOH, a hydroxy group represented by -OH, a functional group containing a nitrogen atom having a hydrogen atom represented by -NH-, a thiol group represented by -SH, a sulfonic acid group represented by -SO₃H, a phosphoric acid group represented by -OPO(OR11)(OH) (wherein R11 has the same meaning as defined above) or a phosphonic acid group represented by -PO(OR11)(OH) (wherein R11 has the same meaning as defined above). Of the hydrogen bond-forming groups, the alkylene oxide group, amino group, carbonyl group, nitrogen-containing heterocyclic group having an -N= structure, carboxylic acid group, hydroxy group and functional group containing a nitrogen atom having a hydrogen atom represented by -NH- are preferable, and the alkylene oxide group, amino group, carbonyl group, carboxylic acid group, hydroxy group and functional group containing a nitrogen atom having a hydrogen atom represented by -NH- are more preferable.

Only one or two or more of the hydrogen bond-forming groups may be present in the polymer compound. When two different kinds of the hydrogen bond-forming groups are used, it is preferred that two hydrogen accepting groups or two hydrogen donating groups are used together.

The amount of the hydrogen bond-forming group introduced into the polymer compound for use in the invention is preferably from 0.01 to 10 mmol/g, more preferably from 0.05 to 5 mmol/g, and particularly preferably from 0.1 to 3 mmol/g. (A5) Hydrophobic group

The hydrophobic group for use in the invention includes an alkyl group, an aryl group, an alkenyl group and an alkynyl group each having 8 or more carbon atoms. Among them, an alkyl group and an aryl group each having 8 or more carbon atoms are preferable, an alkyl group and an aryl group each having 10 or more carbon atoms are more preferable, and an alkyl group and an aryl group each having 12 or more carbon atoms are particularly preferable.

Only one or two or more of the hydrophobic groups may be present in the polymer compound.

The amount of the hydrophobic group introduced into the polymer compound for use in the invention is preferably from 0.01 to 20 mmol/g, more preferably from 0.05 to 15 mmol/g, and particularly preferably from 0.1 to 10 mmol/g.

The weight average molecular weight of the polymer compound for use in the invention is preferably from 5,000 to 500,000, particularly preferably from 10,000 to 250,000, and most preferably from 20,000 to 150,000.

Specific examples of the polymer compound for use in the invention are set forth below, but the invention should not be construed as being limited thereto.

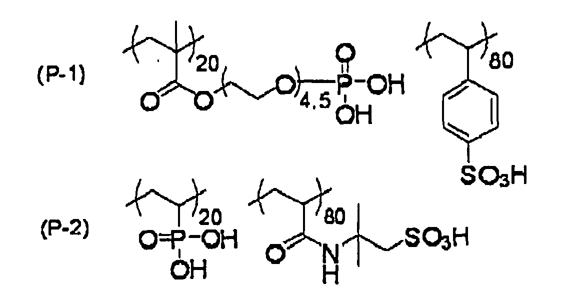

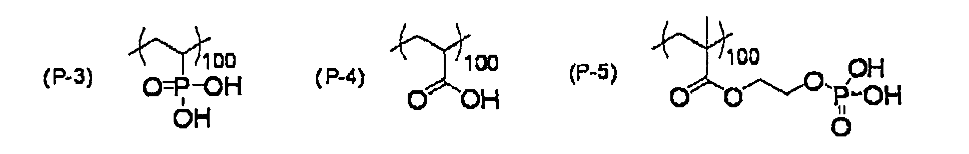

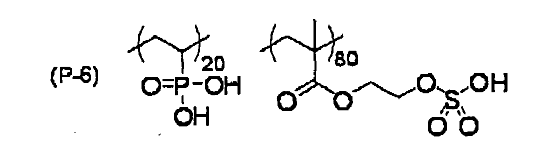

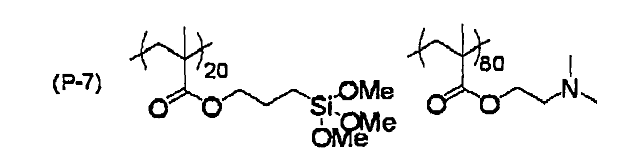

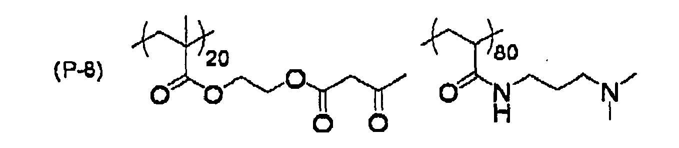

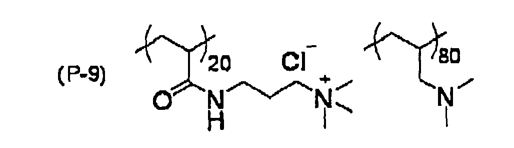

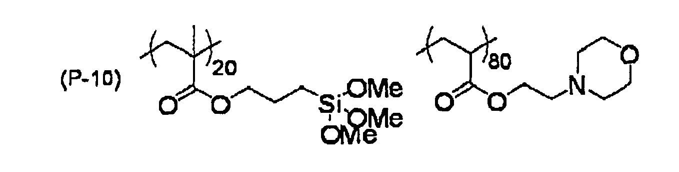

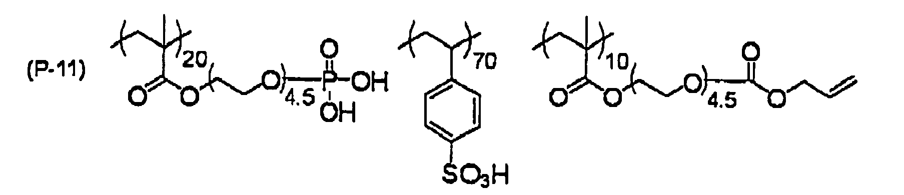

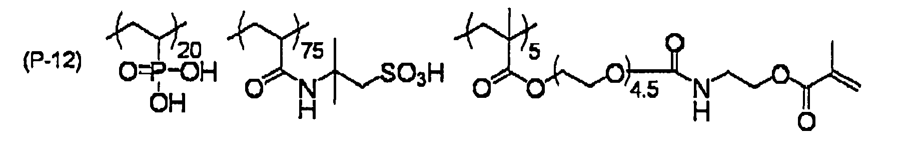

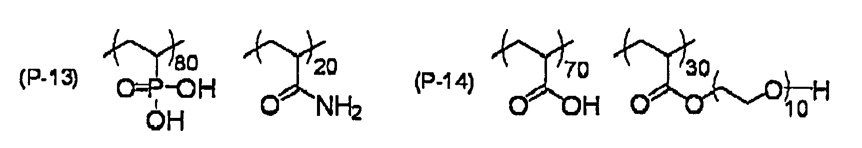

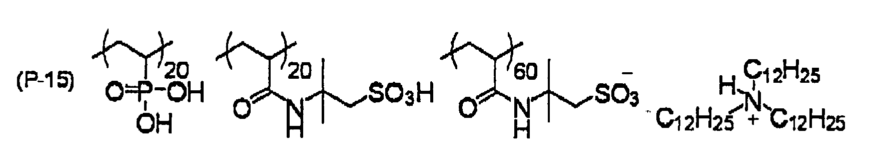

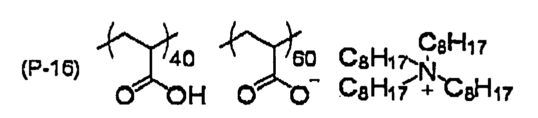

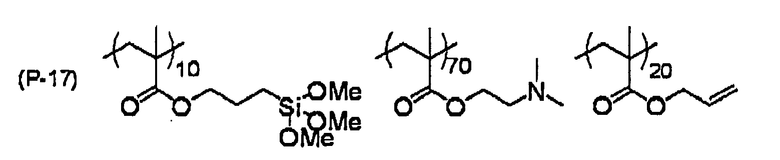

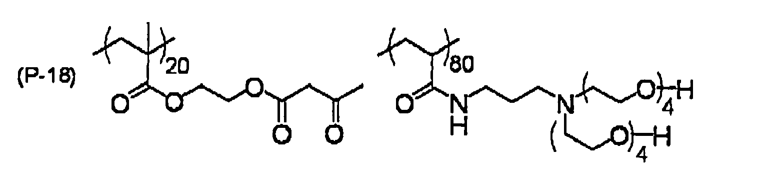

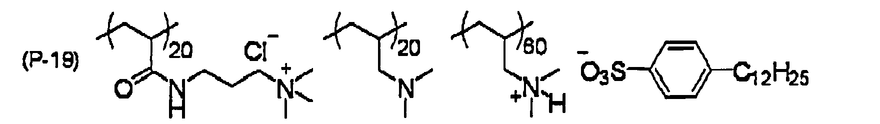

The weight average molecular weights of Polymer Compounds P-1 to P-19 are shown below, respectively. P-1: 80,000; P-2: 100,000; P-3: 50,000; P-4: 110,000; P-5: 110,000, P-6: 90,000; P-7: 80,000, P-8: 70,000; P-9: 100,000; P-10: 50,000, P-11: 100,000; P-12: 90,000; P-13: 90,000; P-14: 100,000; P-15: 80,000; P-16: 70,000; P-17: 60,000, P-18: 70,000; P-19: 80,000

The content of the polymer compound in the undercoat layer according to the invention is preferably from 50 to 100% by weight, more preferably from 60 to 100% by weight, particularly preferably from 70 to less than 100% by weight, based on the total solid content of the undercoat layer.

### <Surfactant>

The undercoat layer for use in the lithographic printing plate precursor according to the invention may contain a surfactant in order to improve the coating property. As the surfactant incorporated into the undercoat layer, the surfactant for use in the photosensitive layer described hereinafter is preferably used.

The content of the surfactant for use in the undercoat layer according to the invention is preferably less than 5% by weight, more preferably from 0.001 to 3% by weight, particularly preferably from 0.005 to less than 1% by weight, based on the total solid content of the undercoat layer.

### <Polymerization inhibitor>

The undercoat layer for use in the lithographic printing plate precursor according to the invention may contain a polymerization inhibitor in order to improve the stability of the lithographic printing plate precursor. As the polymerization inhibitor incorporated into the undercoat layer, the polymerization inhibitor for use in the photosensitive layer described hereinafter is preferably used.

The content of the polymerization inhibitor for use in the undercoat layer according to the invention is preferably less than 5% by weight, more preferably from 0.001 to 4% by weight, particularly preferably from 0.005 to less than 3% by weight, based on the total solid content of the undercoat layer.

### <Initiator>

The undercoat layer for use in the lithographic printing plate precursor according to the invention may contain an initiator in order to improve the sensitivity of the lithographic printing plate precursor. As the initiator incorporated into the undercoat layer, the radical polymerization initiator for use in the photosensitive layer described hereinafter is preferably used.

The content of the initiator for use in the undercoat layer according to the invention is preferably less than 5% by weight, more preferably from 0.001 to 4% by weight, particularly preferably from 0.005 to less than 3% by weight, based on the total solid content of the undercoat layer.

### <Sensitizing dye>

The undercoat layer for use in the lithographic printing plate precursor according to the invention may contain a sensitizing dye in order to improve the sensitivity of the lithographic printing plate precursor. As the sensitizing dye incorporated into the undercoat layer, the sensitizing dye for use in the photosensitive layer described hereinafter is preferably used.

The content of the sensitizing dye for use in the undercoat layer according to the invention is preferably less than 5% by weight, more preferably from 0.001 to 4% by weight, particularly preferably from 0.005 to less than 3% by weight, based on the total solid content of the undercoat layer.

### <Co-sensitizer>

The undercoat layer for use in the lithographic printing plate precursor according to the invention may contain a co-sensitizer in order to improve the sensitivity of the lithographic printing plate precursor. As the co-sensitizer incorporated into the undercoat layer, the co-sensitizer for use in the photosensitive layer described hereinafter is preferably used.

The content of the co-sensitizer for use in the undercoat layer according to the invention is preferably less than 5% by weight, more preferably from 0.001 to 4% by weight, particularly preferably from 0.005 to less than 3% by weight, based on the total solid content of the undercoat layer.

### <Formation of undercoat layer>

The undercoat layer according to the invention is formed by dispersing or dissolving each of the necessary components described above to prepare a coating solution and coating the solution. The solvent used include, for example, ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyrolactone, toluene and water, but the invention should not be construed as being limited thereto. The solvents may be used individually or as a mixture. The solid content concentration of the coating solution is preferably from 0.05 to 50% by weight, and more preferably from 0.1 to 25% by weight.

The undercoat layer according to the invention may also be formed by preparing plural coating solutions by dispersing or dissolving the same or different components described above into the same or different solvents and conducting repeatedly plural coating and drying.

The coating amount (solid content) of the undercoat layer on the support after the coating and drying may be varied depending on the use, but ordinarily, it is preferably from 0.001 to 0.5 g/m², more preferably from 0.003 to 0.25 g/m², and particularly preferably from 0.005 to 0.1 g/m². In the range described above, the good sensitivity, good stain resistance and good printing durability are obtained.

Various methods can be used for the coating. Examples of the method include bar coater coating, spin coating, spray coating, curtain coating, dip coating, air knife coating, blade coating and roll coating.

### [Photosensitive layer]

The photosensitive layer of the lithographic printing plate precursor according to the invention is a photosensitive layer an unexposed area of which is capable of being removed in the presence of a developer having pH of 2 to 11 and contains as the essential component, a pigment which does not adsorb to the polymer compound in the undercoat layer described above. According to a preferable embodiment, the photosensitive layer contains a radical polymerizable compound, a radical polymerization initiator, a sensitizing dye, a co-sensitizer and a binder polymer. The photosensitive layer may further contain a coloring agent and other optional components, if desired.

The control of developing speed in the unexposed area of the photosensitive layer and penetration speed of a developer into the photosensitive layer after curing can be performed in a conventional manner in addition to the method of using a binder polymer. For instance, in order to increase the developing speed in the unexposed area, addition of a hydrophilic compound is useful, and in order to restrain the penetration of developer into the exposed area, addition of a hydrophobic compound is useful.

In the lithographic printing plate precursor according to the invention, a protective layer (also referred to as an "overcoat layer") may further be provided on the photosensitive layer in order to perform the exposure in the atmosphere. The protective layer prevents oxygen or a low molecular compound, for example, a basic substance present in the atmosphere, which inhibits the image-forming reaction initiated upon the exposure in the photosensitive layer, from permeating into the photosensitive layer, whereby the protective layer makes it possible to perform the exposure in the atmosphere.

Each of the components constituting the photosensitive layer of the lithographic printing plate precursor according to the invention will be described in detail below.

### <Pigment>

As the pigment for use in the invention, any pigment which does not adsorb to the polymer compound in the undercoat layer may be suitably used and a pigment which is dispersed with a compound (hereinafter, also referred to as a "pigment dispersant") having at least (a) a functional group (pigment-adsorbing group) adsorbing to the pigment and (b) a functional group (dispersing group) imparting organic solvent dispersibility is preferable. The dye dispersant is preferably a compound comprises at least a unit containing the pigment-adsorbing group (a) and a unit containing the dispersing group (b).

The unit containing a functional group (pigment-adsorbing group or dispersing group) in the pigment dispersant for use in the invention is a unit derived from a low molecular compound (molecular weight of 1,000 or less) containing the functional group. The low molecular compound includes a monomer having the functional group in which the functional group and the polymerizable double bond group are connected directly or through a connecting chain. The connecting chain may be any connecting chain and is ordinarily formed from one or more atoms selected from a carbon atom, an oxygen atom, a nitrogen atom, a sulfur atom, a phosphorus atom, a silicon atom, a hydrogen atom, a halogen atom and a boron atom.

The dispersing group (b) for use in the invention is a group which imparts the organic solvent dispersibility to the pigment and any functional group may be suitably used as long as the group has such a function. Specific examples of the dispersing group (b) include an alkyl group, an aryl group, an alkenyl group, an alkynyl group, -OR, -NRR', -SR, -COR, -COOR, -CONRR', -OCOR, -OCONRR', -OCOOR, -NRCOR', -NRCOOR', -NRCONR'R", -N=R, -SO₂R, -SO₃R, -SO₂NRR', a hydrogen atom, a halogen atom, a cyano group, a nitro group, a hydroxy group or a mercapto group (wherein R, R' and R" each represents an alkyl group, an aryl group, an alkenyl group, an alkynyl group or a hydrogen atom or may be connected with each other to form a ring).

Specific examples of the alkyl group include a straight-chain, branched or cyclic alkyl group having 30 or less carbon atoms, for example, a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclopentyl group, a cyclohexyl group, a 1-adamantyl group or a 2-norbornyl group.

Specific examples of the alkenyl group include a straight-chain, branched or cyclic alkenyl group having 30 or less carbon atoms, for example, a vinyl group, a 1-propenyl group, a 1-butenyl group, a 1-methyl-1-propenyl group, a 1-cyclopentenyl group or a 1-cyclohexenyl group.

Specific examples of the alkynyl group include an alkynyl group having 30 or less carbon atoms, for example, an ethynyl group, a 1-propynyl group, a 1-butynyl group or 1-octynyl group.

The aryl group includes a condensed ring of one to four benzene rings and a condensed ring of a benzene ring and a 5-membered unsaturated ring. Specific examples of the aryl group include an aryl group having 30 or less carbon atoms, for example, a phenyl group, a naphthyl group, an anthryl group, a phenanthryl group, an indenyl group, an acenaphthenyl group, a fluorenyl group or a pyrenyl group. Also, a heteroaryl group containing one or more hetero atoms selected from the group consisting of a nitrogen atom, an oxygen atom and a sulfur atom is exemplified. Specific examples of the heteroaryl group include a heteroaryl group derived from a heteroaryl ring, for example, pyrrole, furan, thiophene, pyrazole, imidazole, triazole, oxazole, isooxazole, oxadiazole, thiazole, thiadiazole, indole, carbazole, benzofuran, dibenzofuran, thianaphthene, dibenzothiophene, indazole, benzimidazole, anthranil, benzisooxazole, benzoxazole, benzothiazole, purine, pyridine, pyridazine, pyrimidine, pyradine, triazine, quinoline, acridine, isoquinoline, phthalazine, quinazoline, quinoxazine, naphthylidine, phenanthroline or pteridine.

The alkyl group, aryl group, alkenyl group and alkynyl group may be substituted with one or more appropriate substituents. Examples of the substituent include a monovalent non-metallic atomic group exclusive of a hydrogen atom, for example, a halogen atom (e.g., -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylmnino group, an acyloxy group, a carbamoyloxy group, an N-alkylcarbamoyloxy group, an N-arylcarbamoyloxy group, an N,N-dialkylcarbamoyloxy group, an N,N-dimylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, N'-arylureido group, an N',N'-diarylureido group, an N'-alkyl-N'-arylureido group, an N-alkylureido group, N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido goup, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group and a conjugate base group thereof, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and a conjugate base group thereof, an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, an N-acylsulfamoyl group and a conjugate base group thereof, an N-alkylsulfonylsulfamoyl group (-SO₂NHSO₂(alkyl)) and a conjugate base group thereof, an N-arylsulfonylsulfamoyl group (-SO₂NHSO₂(aryl)) and a conjugate base group thereof, an N-alkylsulfonylcarbamoyl group (-CONHSO₂(alkyl)) and a conjugate base group thereof, an N-arylsulfonylcarbamoyl group (-CONHSO₂(alrl)) and a conjugate base group thereof, an alkoxysilyl group (-Si(O-akl)₃), an aryloxysilyl group (-Si(O-aryl)₃), a hydroxysilyl group (-Si(OH)₃) and a conjugate base group thereof, a phosphono group (-PO₃H₂) and a conjugate base group thereof, a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and a conjugate base group thereof, a monoarylphosphono group (-PO₃H(aryl)) and a conjugate base group thereof, a phosphonoxy group (-OPO₃H₂) and a conjugate base group thereof, a dialkylphosphonoxy group (-OPO₃(alkyl)₂), a diarylphosphonoxy group (-OPO₃(aryl)₂), an alkylarylphosphonoxy group (-OPO₃(alkyl)(aryl)), a monoalkylphosphonoxy group (-OPO₃H(alkyl)) and a conjugate base group thereof, a monoarylphosphonoxy group (-OPO₃H(aryl)) and a conjugate base group thereof, a cyano group, a nitro group, an aryl group, an alkyl group, an alkenyl group or an alkynyl group.

As the dispersing group of the pigment dispersant for the dye used in the invention, a functional group containing a hydrocarbon (alkyl, aryl, alkynyl or alkynyl) group having 6 or more carbon atoms and a polyalkylene oxide group are preferable, and a functional group containing a hydrocarbon group having 9 or more carbon atoms and a polyalkylene oxide group are more preferable. The dispersing groups may be used individually or in combination of two or more thereof. The amount of the dispersing group present in the pigment dispersant is preferably 0.05 mmol or more, more preferably 0.1 mmol or more, per g of the pigment dispersant.

The functional group adsorbing to the pigment (a) for use in the invention can be variously selected depending on the kind of pigment. In the case where the surface of pigment is substituted with an acidic functional group, the functional group adsorbing to the pigment (a) is preferably a basic functional group, for example, an amino group or an anilino group, and in the case where the surface of pigment is substituted with a basic functional group, the functional group adsorbing to the pigment (a) is preferably an acidic functional group, for example, a carboxyl group, a phosphoric acid group, a phosphonic acid group, a sulfonic acid group or a sulfuric acid group. Of the functional groups, a functional group having an adsorbing amount to pigment of 0.01 mmol/g or more is more preferable. The term "adsorbing amount to pigment" as used herein means a value obtained by the following method.

Specifically, a low molecular compound (having a molecular weight of 1,000 or less) having the functional group is dissolved in an appropriate solvent to prepare Solution 1. To Solution 1 is added 1 g of a pigment to be used and the mixture is stirred at room temperature for 4 hours and filtrated with a filter to prepare Solution 2. The amounts of the low molecular compound having the functional group included in Solution 1 and Solution 2 are determined by HPLC, and from the decreased amounts, an amount of the low molecular compound adsorbed to 1 g of the pigment is obtained.

Of the pigment-adsorbing groups, a pigment-adsorbing group which satisfies any one of Conditions 1 and 2 shown below is particularly preferable.
Condition 1: When the hydrophilic group of the polymer compound is an acidic group and the pigment-adsorbing group is an acidic group, pKa of the hydrophilic group > pKa of the pigment-adsorbing group.
Condition 2: When the hydrophilic group of the polymer compound is a basic group and the pigment-adsorbing group is a basic group, pKa of a conjugate acid of the hydrophilic group < pKa of a conjugate acid of the pigment-adsorbing group.

As the pKa of the pigment-adsorbing group or hydrophilic group, it is preferred to use a value obtained by calculation of the unit containing the group using "ACD/pKa DB V8.0" produced by Advanced Chemistry Development, Inc. The software includes a program for calculating an acid dissociation constant (pKa) of a certain organic structure in an aqueous solution (25°C, ion strength of 0). The calculation is performed using the Hammett equation, substituent constants and database of known values in literatures (including chemical structures of 16,000 and measured values of 31,000 or more) to output a value of ± 0.2 pKa unit at confidence limit of ± 95%. In case of a polybasic acid, the calculation is performed under consideration of a statistical factor.

As the pigment-adsorbing goup, any functional group described above may be suitably used. As the acidic group, functional groups represented by formulae (A-1) to (A-5) shown below are preferable. Among them, the functional groups represented by formulae (A-2) and (A-5) are particularly preferable.

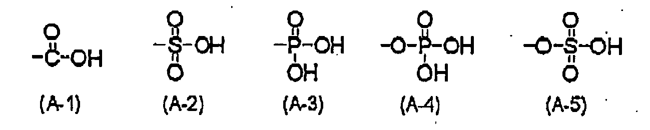

As the basic group, a functional group represented by formula (B-1) shown below is preferable.

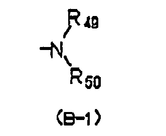

In formula (B-1), R₄₉ and R₅₀ each independently represents an alkyl group, an aryl group, an alkenyl group, an alkynyl group, -OR, -NRR', -SR, -COR, -COOR, -CONRR', -OCOR, -OCONRR', -OCOOR, -NRCOR', -NRCOOR', -NRCONR'R", -N=R, -SO₂R, -SO₃R, -SO₂NRR', a hydrogen atom, a halogen atom, a cyano group, a nitro group, a hydroxy group or a mercapto group (wherein R, R', and R" each independently represents an alkyl group, an aryl group, an alkenyl group, an alkynyl group or a hydrogen atom or may be connected with each other to form a ring) or R₄₉ and R₅₀ may be connected with each other to form a ring.

The pigment-adsorbing groups may be used individually or in combination of two or more thereof. The amount of the pigment-adsorbing group present in the pigment dispersant is preferably 0.05 mmol or more, more preferably 0.1 mmol or more, per g of the pigment dispersant

Specific examples of the pigment dispersant for use in the invention are set forth below, but the invention should not be construed as being limited thereto.

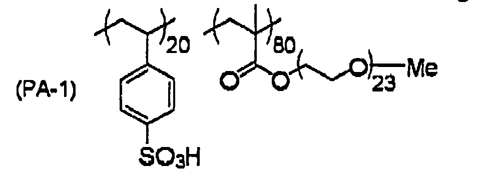

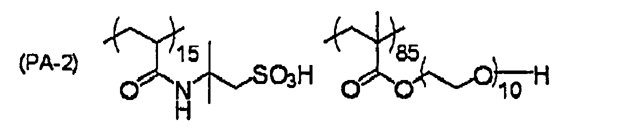

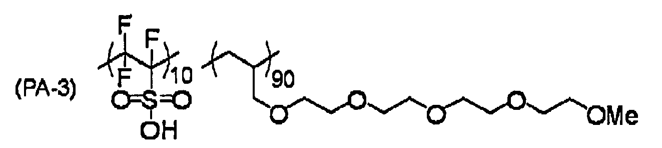

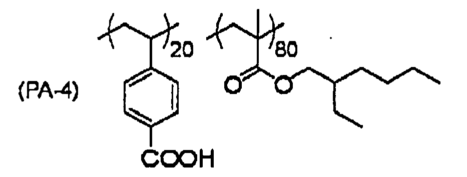

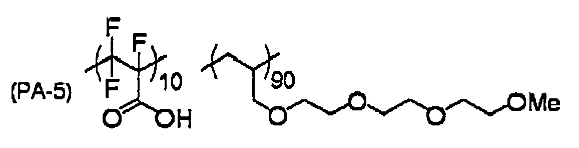

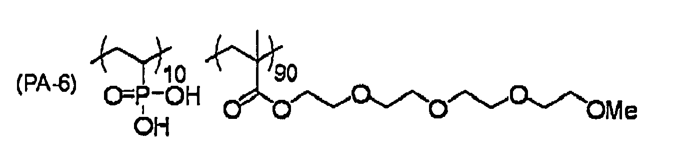

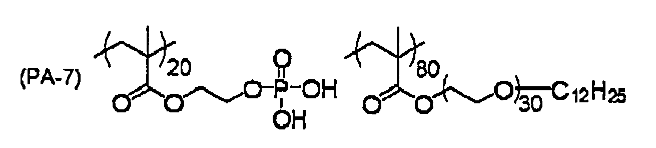

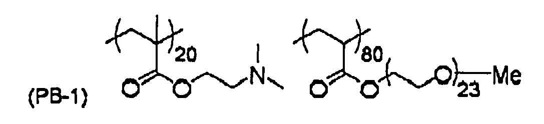

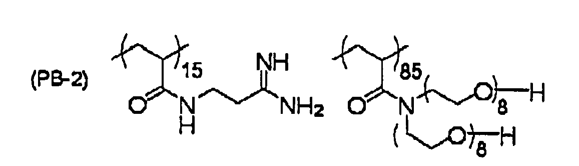

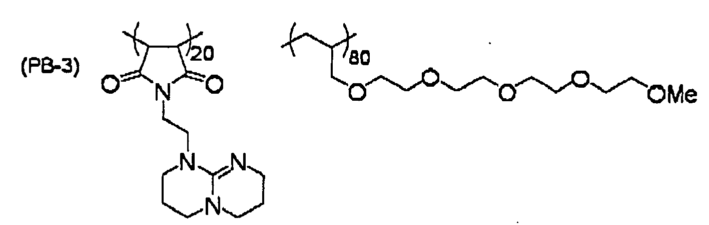

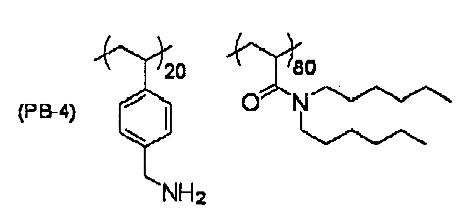

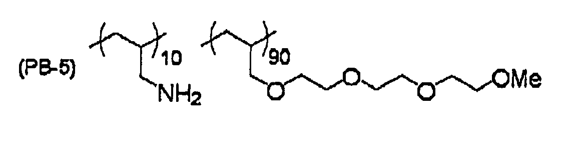

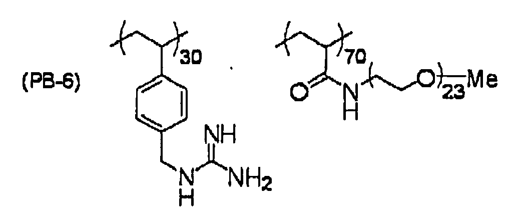

According to the invention, a combination of an acidic-basic property of the hydrophilic group used in the polymer compound for the undercoat layer and an acidic-basic property of the pigment-adsorbing group used in the pigment dispersant for the pigment in the photosensitive layer is important.

When the pigment-adsorbing group for use in the invention is an acidic group, any acidic group is suitably used as long as the acidic group has pKa lower than pKa of the acidic group as the hydrophilic group used in the polymer compound for the undercoat layer. The difference of the pKa of both groups is preferably 0.01 or more, more preferably 0.05 or more, and particularly preferably 0.1 or more.

When the pigment-adsorbing group for use in the invention is a basic group, any basic group is suitably used as long as the basic group has pKa of its conjugate acid higher than pKa of a conjugate acid of the basic group as the hydrophilic group used in the polymer compound for the undercoat layer. The difference of the pKa of both groups is preferably 0.01 or more, more preferably 0.05 or more, and particularly preferably 0.1 or more.

Specific examples of the combination of the hydrophilic group used in the polymer compound for the undercoat layer and the pigment-adsorbing group used in the pigment dispersant are set forth below, but the invention should not be construed as being limited thereto.

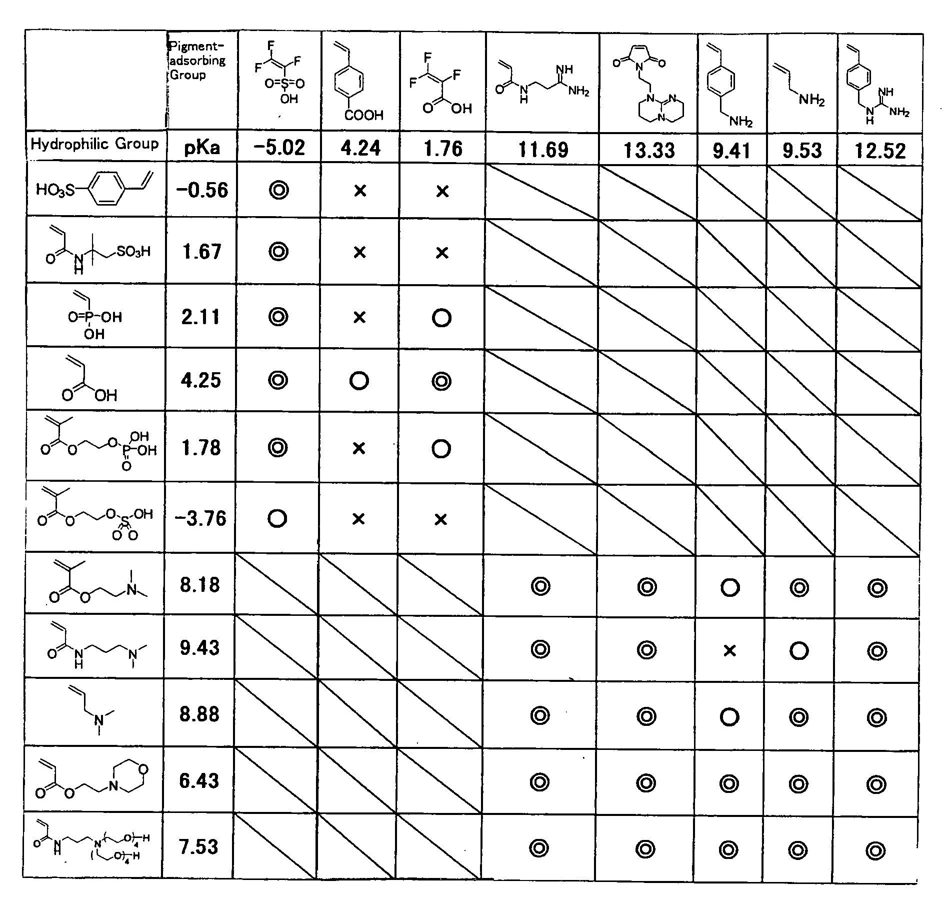

In the above Table, ⊚ means very good, ○ means good, and X means inappropriate.

The weight average molecular weight of the pigment dispersant for use in the invention is preferably from 1,000 to 1,000,000, more preferably from 2,000 to 500,000, and still more preferably from 5,000 to 200,000.

The amount of the pigment dispersant added is preferably from 10 to 200% by weight, more preferably from 30 to 100% by weight, based on the weight of the pigment.

As the pigment for use in the invention (hereinafter, also referred to as pigment of the invention), conventionally known pigments including those commercially available can be preferably used. For instance, those described, for example, in Ganryo Binran (Kaitei-Sinpan) (Handbook of Pigments (Newly revised edition)) compiled by Pigment Technology Society of Japan, Seibundo Shinkosha Inc. or Colour Index. Examples of the pigment include black pigments, yellow pigments, red pigments, brown pigments, purple pigments, blue pigments, green pigments, fluorescent pigments and metal powder pigments. Specific examples of the pigment include inorganic pigments (for example, titanium dioxide, carbon black, graphite, zinc oxide, Prussian blue, cadmium sulfide, iron oxide or lead, zinc, barium or calcium salt of chromic acid) and organic pigments (for example, azo pigments, thioindigo pigments, anthraquinone pigments, anthanthrone pigments, triphendioxazine pigments, vat dye pigments, phthalocyanine pigments and derivatives thereof or quinacridone pigments). Among the pigments, a pigment which does not substantially have absorption in an absorption wavelength range of a sensitizing dye corresponding to laser used for the image exposure is preferably used. Specifically, a pigment having 0.05 or less of reflection absorption measured using an integrating sphere at the emission wavelength of laser is preferable.

Also, in the case of using an argon laser, SHG-YAG laser or violet laser, which now becomes the mainstream in the field of lithographic printing plate precursor of photopolymerization type, a violet pigment or a blue pigment is preferably employed in view of the absorption of pigment in the photosensitive wavelength range and visibility of image after development Examples of such a dye include Cobalt Blue, Cerulean Blue, Alkali Blue Lake, Phonatone Blue 6G, Victoria Blue Lake, non-metal Phthalocyanine Blue, Phthalocyanine Blue, Fast Sky Blue, Indanthrene Blue, Indigo, Dioxane Violet, Isobioranthrone Violet, Indanthrone Blue and Indanthrone BC. Among them, Phthalocyanine Blue and Dioxane Violet are more preferable.

The pigment of the invention may be used after undergoing surface treatment or may be used without undergoing surface treatment. For the surface treatment, treatments, for example, with a resin, wax, surfactant or coupling agent as described in JP-A-3-69949 are illustrated.
An average particle size of the pigment of the invention in the photosensitive layer is preferably from 0.05 to 1.5 µm, more preferably from 0.1 to 1.0 µm. In the range described above, the improvement in printing durability is achieved and the occurrence of background stain on the support is avoided. However, the average particle size of the pigment of less than 0.05 µm is not preferable, because not only the pigment does not contribute to the improvement in printing durability but also it causes clogging on the surface of support subjected to hydrophilic treatment, likely resulting in the occurrence of background stain. The average particle size of the pigment of more than 1.5 µm is also not preferable, because it may be larger than the dry thickness of the photosensitive layer in some cases and the advantages of the invention can not be effectively achieved.

As a method of measuring the average particle size of the pigment of the invention, measurement by a transmission electron microscope can be exemplified. According to the invention, a primary average particle size of the pigment means an average particle size of the pigment in a sample obtained by dropping 0.1 mg of a pigment dispersion prepared by dispersing the pigment in a single solvent is dropped on a 200 mesh with a carbon support film subjected to hydrophilization treatment, coating by a spin coater and drying. Also, a particle size of the pigment in the photosensitive layer means an average particle size of the pigment aggregate determined by coating a photosensitive solution having a solid content of 10% so as to form a layer of 3 g/m² on a PET film and drying at 95°C to preparing a sample, coating an ambient temperature curable epoxy resin on the surface of sample and drying to cure, preparing an ultrathin section (section thickness: 150 nm) by a microtome, putting the ultrathin section on a 200 mesh with a carbon support film subjected to hydrophilization treatment to measure. The measurement was performed using a transmission electron microscope (JEM-2000FX produced by JEOL Ltd.) under the measurement condition of acceleration voltage of 200 kV.

As for the pigment of the invention, it is preferred that a ratio of the primary average particle size of the pigment to the average particle size of the pigment in the photosensitive layer is from 1:1 to 1:15. The ratio described above means that it is preferable for the average particle size of the pigment in the photosensitive layer to unboundedly close to the primary average particle size of the pigment and indicates that the pigment is apt to be dispersed finely, uniformly and stably in the photosensitive layer. When the ratio exceeds 1:15, the pigment becomes enlarged and is not preferable.

As a method for control the average particle size of the pigment of the invention in the photosensitive layer to the range of 0.05 to 1.5 µm, for example, a method to dispersing the pigment in a single solvent and using the solvent as the main solvent for a solution forming the photosensitive layer is exemplified. The solvent for use at the dispersion of the pigment is essentially an organic solvent It is preferred that the solvent is singly used in view of dispersion stability as described above. Examples of the organic solvent preferably used include known solvents, for example, an alcohol solvent, for example, methanol, ethanol, propanol, isopropanol or 1-mehtoxy-2-propanol, a ketone solvent, for example, acetone, methyl ethyl ketone or cyclohexanone, an ester solvent, for example, ethyl acetate, butyl acetate or γ-butyrolactone, an ether solvent, for example, tetrahydrofuran, 1,3-dioxorane or diisopropyl ether, a hydrocarbon solvent, for example, toluene, hexane or xylene, an amide solvent, for example, dimethylformamide, dimethylacetamide or N-methylpyrrolidone, a halogenated solvent, for example, chloroform or carbon tetrachloride, and dimethylsulfoxide. An organic ketone solvent having a solubility parameter value (SP value) of 9 to 10.5 is preferable and, for example, cyclohexanone (SP value: 9.9), methyl ethyl ketone (MEK) (SP value: 9.3), cyclopentanone (SP value; 10.4) and methylcyclohexanone (SP value; 9.3) are illustrated. Among them, methyl ethyl ketone and cyclohexanone are most preferable.

The use of the above-described organic solvent as the solvent at the dispersion of the pigment is greatly influenced dispersion stability when the pigment dispersion is added to the composition for photosensitive layer. The use of the organic solvent as the main solvent for the solution for forming the photosensitive layer is also greatly influenced the dispersion stability.

The pigment of the invention dispersed in the organic solvent in the manner described above can be controlled the average particle size thereof to the range of 0.05 to 1.5 µm in the photosensitive layer and a dispersion of the pigment particle dispersed extremely finely, uniformly and stably can be prepared.

In the dispersion, it is ordinary to add the pigment and pigment dispersant to the above-described solvent so as to have concentration of 10 to 30% by weight and to disperse, for example, by a paint shaker. However, other known dispersing methods can be suitably employed.

The content of the pigment dispersed with the pigment dispersant in the photosensitive layer is not particularly restricted and it is preferably from 0.01 to 20% by weight, more preferably from 0.05 to 15% by weight, and still more preferably from 0.1 to 10% by weight.

### <Radical polymerizable compound>

The radical polymerizable compound (hereinafter, also referred to as a polymerizable compound) for use in the photosensitive layer according to the invention is an addition-polymerizable compound having at least one ethylenically unsaturated double bond, and it is selected from compounds having at least one, preferably two or more, terminal ethylenically unsaturated double bonds. Such compounds are widely known in the art and they can be used in the invention without any particular limitation. The polymerizable compound has a chemical form, for example, a monomer, a prepolymer, specifically, a dimer, a trimer or an oligomer, or a copolymer thereof, or a mixture thereof. Examples of the monomer include unsaturated carboxylic acids (for example, acrylic acid, methacrylic acid, itaconic acid, crotonic acid, isocrotonic acid or maleic acid) and esters or amides thereof. Preferably, esters of an unsaturated carboxylic acid with an aliphatic polyhydric alcohol compound and amides of an unsaturated carboxylic acid with an aliphatic polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used.

Specific examples of the monomer, which is an ester of an aliphatic polyhydric alcohol compound with an unsaturated carboxylic acid, include, as an acrylic acid ester, for example, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, isocyanuric acid ethylene oxide (EO) modified triacrylate and polyester acrylate oligomer.

As a methacrylic acid ester, for example, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane and bis[p-(methacryloxyethoxy)phenyl]dimethylmethane are exemplified.

As an itaconic acid ester, for example, ethylene glycol diitaconate, propylene glycol diitaconate, 1,3-butanediol diitaconate, 1,4-butanediol diitaconate, tetramethylene glycol diitaconate, pentaerythritol diitaconate and sorbitol tetraitaconate are exemplified. As a crotonic acid ester, for example, ethylene glycol dicrotonate, tetramethylene glycol dicrotonate, pentaerythritol dicrotonate and sorbitol tetracrotonate are exemplified. As an isocrotonic acid ester, for example, ethylene glycol diisocrotonate, pentaerythritol diisocrotonate and sorbitol tetraisocrotonate are exemplified. As a maleic acid ester, for example, ethylene glycol dimaleate, triethylene glycol dimaleate, pentaerythritol dimaleate and sorbitol tetramaleate are exemplified.

Other examples of the ester, which can be preferably used, include aliphatic alcohol esters described in JP-B-51-47334 (the term "JP-B" as used herein means an "examined Japanese patent publication and JP-A-57-196231, esters having an aromatic skeleton described in JP-A-59-5240, JP-A-59-5241 and JP-A-2-226149, and esters containing an amino group described in JP-A-1-165613.

The above-described ester monomers can also be used as a mixture.

Specific examples of the monomer, which is an amide of an aliphatic polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide. Other preferable examples of the amide monomer include amides having a cyclohexylene structure described in JP-B-54-21726.

Urethane type addition-polymerizable compounds produced using an addition reaction between an isocyanate and a hydroxy group are also preferably used, and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per molecule, described in JP-B-48-41708.

CH₂=C(R₄)COOCH₂CH(R₅)OH (A)

wherein R₄ and R₅ each independently represents H or CH₃.

Also, urethane acrylates described in JP-A-51-37193, JP-B-2-32293 and JP-B-2-16765, and urethane compounds having an ethylene oxide skeleton described in JP-B-58-49860, JP-B-56-17654, JP-B-62-39417 and JP-B-62-39418 are preferably used. Further, a photopolymerizable composition having remarkably excellent photo-speed can be obtained by using an addition polymerizable compound having an amino structure or a sulfide structure in its molecule, described in JP-A-63-277653, JP-A-63-260909 and JP-A-1-105238.

Other examples include polyfunctional acrylates and methacrylates, for example, polyester acrylates and epoxy acrylates obtained by reacting an epoxy resin with (meth)acrylic acid, described in JP-A-48-64183, JP-B-49-43191 and JP-B-52-30490. Specific unsaturated compounds described in JP-B-46-43946, JP-B-1-40337 and JP-B-1-40336, and vinylphosphonic acid type compounds described in JP-A-2-25493 can also be exemplified. In some cases, structure containing a perfluoroalkyl group described in JP-A-61-22048 can be preferably used. Moreover, photocurable monomers or oligomers described in Nippon Secchaku Kyokaishi (Journal of Japan Adhesion Society), Vol. 20, No. 7, pages 300 to 308 (1984) can also be used.

Details of the method of using the polymerizable compound, for example, selection of the structure, individual or combination use or an amount added, can be appropriately determined in accordance with the characteristic design of the final lithographic printing plate precursor. For instance, the compound is selected from the following standpoints.

In view of the sensitivity, a structure having a large content of unsaturated group per molecule is preferred and in many cases, a difunctional or more functional compound is preferred. Also, in order to increase the strength of the image area, that is, cured layer, a trifunctional or more functional compound is preferred. A combination use of compounds different in the functional number or in the kind of polymerizable group (for example, an acrylic acid ester, a methacrylic acid ester, a styrene compound or a vinyl ether compound) is an effective method for controlling both the sensitivity and the strength.

The selection and use method of the polymerizable compound are also important factors for the compatibility and dispersibility with other components (for example, a binder polymer, a polymerization initiator or a coloring agent) in the photosensitive layer. For instance, the compatibility may be improved in some cases by using the compound of low purity or using two or more kinds of the compounds in combination. A specific structure may be selected for the purpose of improving an adhesion property to a support, a protective layer or the like described hereinafter. In the method of using the polymerizable compound, the structure, blend and amount added can be appropriately selected by taking account of the degree of polymerization inhibition due to oxygen, resolution, fogging property, change in refractive index, surface tackiness and the like. Further, depending on the case, a layer construction, for example, an undercoat layer or an overcoat layer, and a coating method, may also be considered.

The polymerizable compound is used preferably in a range of 5 to 75% by weight, more preferably in a range of 25 to 70% by weight, particularly preferably in a range of 30 to 60% by weight, based on the total solid content of the photosensitive layer.

### <Radical polymerization initiator>

The radical polymerization initiator (hereinafter, also referred to as a polymerization initiator or an initiator compound) for use in the photosensitive layer according to the invention is a compound undergoing chemical change upon a function, for example, electron transfer, energy transfer or heat generation resulting from a sensitizing dye in the electron excited state to generate at least one species selected from a radical, an acid or a base. The radical, acid or base thus-generated is simply referred to as an active species, hereinafter. When the initiator compound is not present or when it is used alone, sensitivity sufficient for practical use can not be obtained. According to one embodiment of using the sensitizing dye together with the initiator compound, it is possible to utilize a single compound including both compounds prepared by an appropriate chemical method (for example, a linkage of the sensitizing dye and the initiator compound by a chemical bond).

It is believed that many of the initiator compounds ordinarily generate the active species through an initial chemical process as typified by following processes (1) to (3). Specifically, there are a process (1): reductive decomposition of the initiator compound based on electron transfer from the sensitizing dye in the electron excited state to the initiator compound, a process (2): oxidative decomposition of the initiator compound based on electron transfer from the initiator compound to the sensitizing dye in the electron excited state, and a process (3): decomposition of the initiator compound in the electron excited state based on energy transfer from the sensitizing dye in the electron excited state to the initiator compound. Although it is not clear in many cases that an individual initiator compound decomposes according to which process belongs to (1) to (3), in the invention the sensitizing dye has a great feature in that it exhibits a very large sensitizing effect even in combination with any initiator compounds decomposed according to the processes (1) to (3).

As the initiator compound according to the invention, initiator compounds known to those skilled in the art can be used without limitation. Specifically, the initiator compound includes, for example, a trihalomethyl compound, a carbonyl compound, an organic peroxide, an azo compound, an azide compound, a metallocene compound, a hexaarylbiimidazole compound, an organic boron compound, a disulfone compound, an oxime ester compound, an onium salt compound and a iron arene complex. Among them, at least one compound selected from the hexaarylbiimidazole compound, onium salt compound, trihalomethyl compound and metallocene compound is preferable, and the hexaarylbiimidazole compound is particularly preferable.

The polymerization initiators may be appropriately used in combination of two or more thereof.

The hexaarylbiimidazole compound includes, for example, lophine dimers described in
JP-B-45-37377 and JP-B-44-86516, specifically,
2,2'-bis(o-chlorophenyl)-4,4',5,5'-tetraphenylbiimidazole,
2,2'-bis(o-bromophenyl)-4,4',5,5'-tetraphenylbiimidazole,
2,2'-bis(o,p-dichlorophenyl)-4,4',5,5'-tetraphenylbiimidazole,
2,2'-bis(o-chlorophenyl)-4,4',5,5'-tetra(m-methoxyphenyl)biimidazole,
2,2'-bis(o,o'-dichlorophenyl)-4,4',5,5'-tetraphenylbiimidazole,
2,2'-bis(o-nitrophenyl)-4,4',5,5'-tetraphenylbUmidazole,
2,2'-bis(o-methylphenyl)-4,4',5,5'-tetraphenylbiimidazole and
2,2'-bis(o-trifluommethylphenyl)-4,4',5,5'-tetraphenylbiimidazole.

The hexaarylbiimidazole compound is particularly preferably used together with a sensitizing dye having an absorption maximum in a wavelength range of 3 50 to 450 nm.

The onium salt (which functions not as an acid generator but as an ionic polymerization initiator in the invention) preferably used in the invention includes onium salts represented by the following formulae (RI-I) to (RI-III):

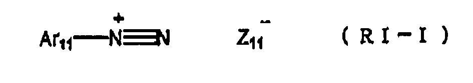

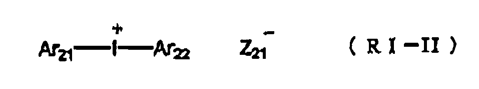

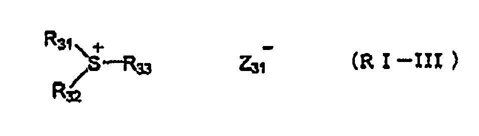

In formula (RI-I), Ar₁₁ represents an aryl group having 20 or less carbon atoms, which may have 1 to 6 substituents. Preferable examples of the substituent include an alkyl group having from 1 to 12 carbon atoms, an alkenyl group having from 2 to 12 carbon atoms, an alkynyl group having from 2 to 12 carbon atoms, an aryl group having from 6 to 12 carbon atoms, an alkoxy group having from 1 to 12 carbon atoms, an aryloxy group having from 6 to 12 carbon atoms, a halogen atom, an alkylamino group having from 1 to 12 carbon atoms, a dialkylamino group having from 2 to 12 carbon atoms, an alkylamido group or arylamido having from 2 to 12 carbon atoms, a carbonyl group, a carboxyl group, a cyano group, a sulfonyl group, an thioalkyl group having from 1 to 12 carbon atoms and an thioaryl group having from to 12 carbon atoms, Z₁₁⁻ represents a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion and a sulfate ion. Among them, a perchlorate ion, a hexafluorophosphate ion, a tetrafluoroborate ion, a sulfonate ion and a sulfinate ion are preferred in view of stability.

In the formula (RI-II), Ar₂₁ and Ar₂₂ each independently represents an aryl group having 20 or less carbon atoms, which may have 1 to 6 substituents. Preferable examples of the substituent include an alkyl group having from 1 to 12 carbon atoms, an alkenyl group having from 2 to 12 carbon atoms, an alkynyl group having from 2 to 12 carbon atoms, an aryl group having from 6 to 12 carbon atoms, an alkoxy group having from 1 to 12 carbon atoms, an aryloxy group having from 6 to 12 carbon atoms, a halogen atom, an alkylamino group having from 1 to 12 carbon atoms, a dialkylamino group having from 2 to 12 carbon atoms, an alkylamido group or arylamido group having from 2 to 12 carbon atoms, a carbonyl group, a carboxyl group, a cyano group, a sulfonyl group, an thioalkyl group having from 1 to 12 carbon atoms and an thioaryl group having from 6 to 12 carbon atoms. Z₂₁⁻ represents a monovalent anion. Specific example of the monovalent anion include a halogen ion, a perchlorate ion, a hexafluorophosphate ion, a tetrafluoroborate ion, a sulfonate ion, a sulfonate ion, a thiosulfonate ion, a sulfate ion and a carboxylate ion. Among them, a perchlorate ion, a hexafluorophosphate ion, a tetrafluoroborate ion, a sulfonate ion, a sulfinate ion and a carboxylate ion are preferred in view of stability and reactivity.

In the formula (RI-III), R₃₁, R₃₂ and R₃₃ each independently represents an aryl group having 20 or less carbon atoms, which may have 1 to 6 substituents, an alkyl group, an alkenyl group or an alkenyl group. Among them, the aryl group is preferred in view of reactivity and stability. Preferable examples of the substituent include an alkyl group having from 1 to 12 carbon atoms, an alkenyl group having from 2 to 12 carbon atoms, an alkynyl group having from 2 to 12 carbon atoms, an aryl group having from 6 to 12 carbon atoms, an alkoxy group having from 1 to 12 carbon atoms, an aryloxy group having from 6 to 12 carbon atoms, a halogen atom, an alkylamino group having from 1 to 12 carbon atoms, a dialkylamino group having from 2 to 12 carbon atoms, an alkylamido group or arylamido group having from 2 to 12 carbon atoms, a carbonyl group, a carboxyl group, a cyano group, a sulfonyl group, an thioalkyl group having from 1 to 12 carbon atoms and an thioaryl group having from 6 to 12 carbon atoms. Z₃₁⁻ represents a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion, a sulfate ion and a carboxylate ion. Among them, a perchlorate ion, a hexafluorophosphate ion, a tetrafluoroborate ion, a sulfonate ion, a sulfinate ion and a carboxylate ion are preferred in view of stability and reactivity. Carboxylate ions described in JP-A-2001-343742 are more preferable, and carboxylate ions described in JP-A-2002-148790 are particularly preferable.

The onium salt is particularly preferably used together with an infrared absorbing agent having an absorption maximum in a wavelength range of 750 to 1,400 nm.

As other polymerization initiators, polymerization initiators described in JP-A-2007-171406, JP-A-2007-206216, JP-A-2007-206217, JP-A-2007-225701, JP-A-2007-225702, JP-A-2007-316582 and JP-A-2007-328243 are preferably used.

The polymerization initiators are preferably used individually or in combination of two or more thereof according to the invention.

The amount of the polymerization initiator used in the photosensitive layer according to the invention is preferably from 0.01 to 20% by weight, more preferably from 0.1 to 15% by weight, still more preferably from 1.0 to 10% by weight, based on the total solid content of the photosensitive layer.

### <Sensitizing dye>

By added a sensitizing dye, for example, a sensitizing dye having an absorption maximum in a wavelength range of 350 to 450 nm, a sensitizing dye having an absorption maximum in a wavelength range of 500 to 600 and an infrared absorbing agent having an absorption maximum in a wavelength range of 750 to 1,400 nm to the photosensitive layer, high-sensitive lithographic printing plate precursors responding to a violet laser of 405 nm, green laser of 532 nm and IR laser of 803 nm ordinarily used in the industry can be provided, respectively.

First, the sensitizing dye having an absorption maximum in a wavelength range of 350 to 450 nm is described below. Such sensitizing dyes include, for example, merocyanine dyes, benzopyranes, coumarins, aromatic ketones and anthracenes.
Of the sensitizing dyes having an absorption maximum in a wavelength range of 350 to 450 nm, dyes represented by formula (IX) shown below are more preferable in view of high sensitivity.

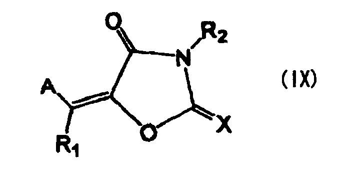

In formula (IX), A represents an aromatic cyclic group which may have a substituent or a heterocyclic group which may have a substituent, X represents an oxygen atom, a sulfur atom or =N(R₃), and R₁, R₂ and R₃ each independently represents a monovalent nonmetallic atomic group, or A and R₁ or R₂ and R₃ may be combined with each other to form an aliphatic or aromatic ring.

The formula (IX) will be described in more detail below. R₁, R₂ and R₃ each independently represents a monovalent nonmetallic atomic group, preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxy group or a halogen atom.

Next, A in formula (IX) represents an aromatic cyclic group which may have a substituent or heterocyclic group which may have a substituent. Specific examples of the aromatic cyclic group which may have a substituent and a heterocyclic group which may have a substituent include those described for the substituted or unsubstituted aryl group and substituted or unsubstituted aromatic heterocyclic residue in any one of R₁, R₂ and R₃ in formula (IX).

As specific examples of the sensitizing dye, compounds described in Paragraph Nos. [0047] to [0053] of JP-A-2007-58170 are exemplified.

Further, sensitizing dyes represented by formulae (V) to (VII) can also be used.

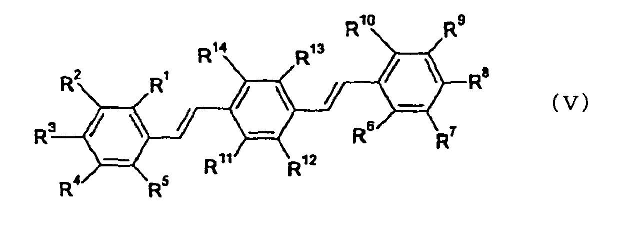

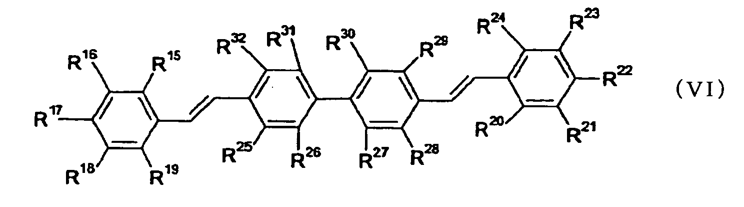

In formula (V), R¹ to R¹⁴ each independently represents a hydrogen atom, an alkyl group, an alkoxy group, a cyano group or a halogen atom, provided that at least one of R¹ to R¹⁰ represents an alkoxy group having 2 or more carbon atoms.

In formula (VI), R¹⁵ to R³² each independently represents a hydrogen atom, an alkyl group, an alkoxy group, a cyano group or a halogen atom, provided that at leas one of R¹⁵ to R²⁴ represents an alkoxy group having 2 or more carbon atoms.

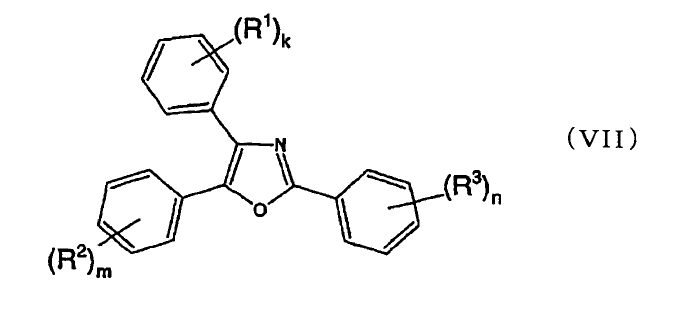

In formula (VII), R¹, R² and R³ each independently represents a halogen atom, an alkyl group, an aryl group, an aralkyl group, an NR⁴R⁵ group or an -OR⁶ group, R⁴, R⁵ and R⁶ each independently represents a hydrogen atom, an alkyl group, an aryl group or an aralkyl group, and k, m and n each represents an integer of 0 to 5.

Moreover, sensitizing dyes described in JP-A-2007-171406, JP-A-2007-206216, JP-A-2007-206217, JP-A-2007-225701, JP-A-2007-225702, JP-A-2007-316582 and JP-A-2007-328243 are also preferably used.

The amount of the sensitizing dye having an absorption maximum in a wavelength range of 350 to 450 nm added is preferably from 0.05 to 30 parts by weight, more preferably from 0.1 to 20 parts by weight, most preferably from 0.2 to 10 parts by weight, per 100 parts by weight of the total solid content of the photosensitive layer.

Now, the sensitizing dye having an absorption maximum in a wavelength range of 750 to 1,400 preferably used in the invention is described in detail below.

The sensitizing dye includes an infrared absorbing agent and it is believed that the sensitizing dye used forms an electron excited state with high sensitivity upon irradiation (exposure) of infrared laser, and electron transfer, energy transfer or heat generation (light-to-heat conversion function) relating to the electron excited state acts on a polymerization initiator coexistent in the photosensitive layer to cause chemical change in the polymerization initiator, thereby generating a radical. In any event, it is particularly preferable for plate making including direct drawing with the infrared laser beam having a wavelength of 750 to 1,400 nm to add the sensitizing dye having an absorption maximum in a wavelength range of 750 to 1,400 and the high image-forming property can be generated in comparison with a conventional lithographic printing plate precursor.

The infrared absorbing agent is preferably a dye or pigment having an absorption maximum in a wavelength range of 750 to 1,400 nm.

As the dye, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Of the dyes, cyanine dyes, squarylium dyes, pyrylium dyes, nickel thiolate complexes and indolenine cyanine dyes are particularly preferred. Further, cyanine dyes and indolenine cyanine dyes are more preferred. As particularly preferable examples of the dye, cyanine dyes represented by formula (a) shown below are exemplified.

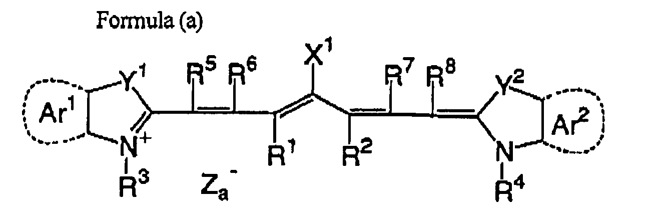

In formula (a), X¹ represents a hydrogen atom, a halogen atom, -NPh₂, X²-L¹ or a group shown below. X² represents an oxygen atom, a nitrogen atom or a sulfur atom, L¹ represents a hydrocarbon group having from 1 to 12 carbon atoms, an aromatic cyclic group containing a hetero atom or a hydrocarbon group having from 1 to 12 carbon atoms and containing a hetero atom. The hetero atom indicates herein a nitrogen atom, a sulfur atom, an oxygen atom, a halogen atom or a selenium atom. Xa⁻ has the same meaning as Za⁻ defined hereinafter. R^{a} represents a hydrogen atom or a substituent selected from an alkyl group, an aryl group, a substituted or unsubstituted amino group and a halogen atom.

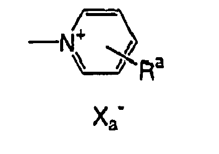

R¹ and R² each independently represents a hydrocarbon group having from 1 to 12 carbon atoms. In view of the preservation stability of a coating solution for photosensitive layer, it is preferred that R¹ and R² each represents a hydrocarbon group having two or more carbon atoms. It is also preferred that R¹ and R² are combined with each other to form a 5-membered or 6-membered ring.

Ar¹ and Ar², which may be the same or different, each represents an aromatic hydrocarbon group which may have a substituent. Preferable examples of the aromatic hydrocarbon group include a benzene ring group and a naphthalene ring group. Preferable examples of the substituent include a hydrocarbon group having 12 or less carbon atoms, a halogen atom and an alkoxy group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms, which may have a substituent Preferable examples of the substituent include an alkoxy group having 12 or less carbon atoms, a carboxyl group and a sulfo group. R⁵, R⁶, R⁷ and R⁸, which may be the same or different, each represents a hydrogen atom or a hydrocarbon group having 12 or less carbon atoms. In view of the availability of raw materials, a hydrogen atom is preferred. Za⁻ represents a counter anion. However, Za⁻ is not necessary when the cyanine dye represented by formula (a) has an anionic substituent in the structure thereof and neutralization of charge is not needed. Preferable examples of the counter ion for Za⁻ include a halogen ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion in view of the preservation stability of a coating solution for image-forming layer. As the counter ion, that not containing a halogen ion is particularly preferable.

Specific examples of the cyanine dye represented by formula (a), which can be preferably used in the invention, include those described in Paragraph Nos. [0017] to [0019] of JP-A-2001-133969.

Further, other particularly preferable examples include specific indolenine cyanine dyes described in JP-A-2002-278057.

Examples of the pigment for use in the invention include commercially available pigments and pigments described in Colour Index (C.I.), Saishin Ganryo Binran (Handbook of the Newest Pigments) compiled by Pigment Technology Society of Japan (1977), Saishin Ganryo Oyou Gijutsu (Newest Application on Technologies for Pigments), CMC Publishing Co., Ltd. (1986) and Insatsu Ink Gijutsu (Printing Ink Technology), CMC Publishing Co., Ltd. (1984).

Examples of the pigment include black pigments, yellow pigments, orange pigments, brown pigments, red pigments, purple pigments, blue pigments, green pigments, fluorescent pigments, metal powder pigments and polymer-bonded dyes. Specific examples of usable pigment include insoluble azo pigments, azo lake pigments, condensed azo pigments, chelated azo pigments, phthalocyanine pigments, anthraquinone pigments, perylene and perynone pigments, thioindigo pigments, quinacridone pigments, dioxazine pigments, isoindolinone pigments, quinophthalone pigments, dying lake pigments, azine pigments, nitroso pigments, nitro pigments, natural pigments, fluorescent pigments, inorganic pigments and carbon black. Of the pigments, carbon black is preferred

The pigment may be used without undergoing surface treatment or may be used after the surface treatment For the surface treatment, a method of coating a resin or wax on the surface, a method of attaching a surfactant and a method of bonding a reactive substance (for example, a silane coupling agent, an epoxy compound or polyisocyanate) to the pigment surface. The surface treatment methods are described in Kinzoku Sekken no Seishitsu to Oyo (Properties and Applications of Metal Soap), Saiwai Shobo, Insatsu Ink Gijutsu (Printing Ink Technology), CMC Publishing Co., Ltd (1984) and Saishin Ganryo Oyo Gijutsu (Newest Application on Technologies for Pigments), CMC Publishing Co., Ltd. (1986).

The pigment has a particle size of preferably from 0.01 to 10 µm, more preferably from 0.05 to 1 µm, and particularly preferably from 0.1 to 1 µm. In the range described above, excellent dispersion stability of the pigment in the photosensitive layer is achieved and a uniform photosensitive layer can be obtained.

For dispersing the pigment, known dispersion techniques for use in the production of ink or toner may be used. Examples of the dispersing machine include an ultrasonic dispersing machine, a sand mill, an attritor, a pearl mill, a super-mill, a ball mill, an impeller, a disperser, a KD mill, a colloid mill, a dynatron, a three roll mill and a pressure kneader. The dispersing machines are described in detail in Saishin Ganryo Oyo Gijutsu (Newest Application on Technologies for Pigments), CMC Publishing Co., Ltd. (1986).

The infrared absorbing agent may be added together with other components to the same layer or a different layer separately provided.

The infrared absorbing agent is added ordinarily in an amount of 0.01 to 50% by weight, preferably in an amount of 0.1 to 10% by weight, particularly preferably in an amount of 0.5 to 10% by weight in case of the dye and in an amount of 0.1 to 10% by weight in case of the pigment, based on the total solid content constituting the photosensitive layer, from the standpoint of uniformity in the photosensitive layer and durability of the photosensitive layer.

### <Co-sensitizer>

To the photosensitive layer according to the invention, may be added a known compound referred to, for example, as a chain transfer agent or co-sensitizer which has a function of further increasing sensitivity or of preventing polymerization inhibition due to oxygen.

Examples of such a compound include amines, for example, compounds described in M. R. Sander et al, Journal of Polymer Society, Vol. 10, Page 3173 (1972), JP-B-44-20189, JP-A-51-82102, JP-A-52-134692, JP-A-59-138205, JP-A-60-84305, JP-A-62-18537, JP-A-64-33104 and Research Disclosure, No. 33825. Specific examples thereof include triethanolamine, N-phenylglycine, N-phenylasparaginic acid, and an N,N-dialkylaniline derivative, for example, ethyl p-dimethylaminobenzoate, p-formyldimethylaniline and p-methylthiodimethylaniline.

Another example of the compound which acts as a chain transfer agent includes a compound having SH, PH, SiH or GeH in its molecule. The compound donates hydrogen to a low active radical species to generate a radical or is oxidized and deprotonized to generate a radical.

In particular, a thiol compound (for example, a 2-mercaptobenzimidazole, a 2-mercaptobenzthiazole, a 2-mercaptobenzoxazole, a 3-mercaptotriazole or a 5-mercaptotetrazole) is preferably used as the chain transfer agent in the photosensitive layer according to the invention.

Among them, a thiol compound represented by formula (I) shown below is particularly preferably used. By using the thiol compound represented by formula (I) as the chain transfer agent, a problem of the odor and decrease in sensitivity due to evaporation of the compound from the photosensitive layer or diffusion thereof into other layers are avoided and a lithographic printing plate precursor which is excellent in preservation stability and exhibits high sensitivity and good printing durability is obtained.

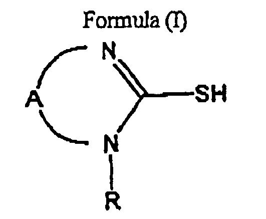

In formula (I), R represents a hydrogen atom, an alkyl group which may have a substituent or an aryl group which may have a substituent, A represents an atomic group necessary for forming a 5-membered or 6-membered hetero ring containing a carbon atom together with the N=C-N linkage, and A may have a substituent

Compounds represented by any one of formulae (IA) and (IB) shown below are more preferably used.

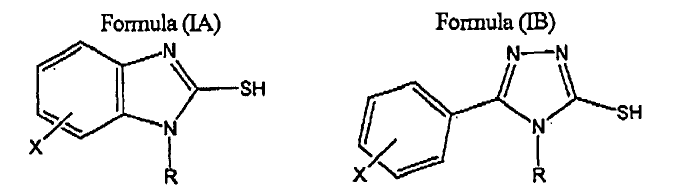

In formulae (IA) and (IB), R represents a hydrogen atom, an alkyl group which may have a substituent or an aryl group which may have a substituent, and X represents a hydrogen atom, a halogen atom, an alkoxy group which may have a substituent, an alkyl group which may have a substituent or an aryl group which may have a substituent.

Specific examples of the compound represented by formula (I) are set forth below, but the invention should not be construed as being limited thereto.

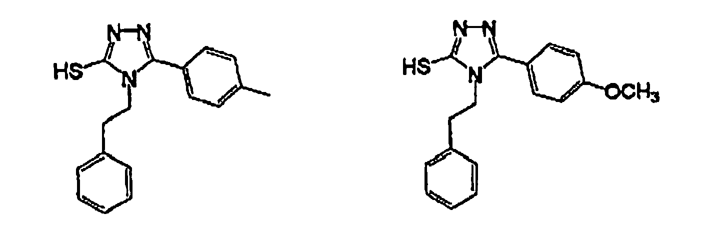

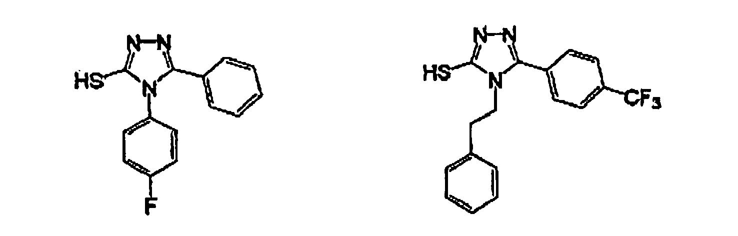

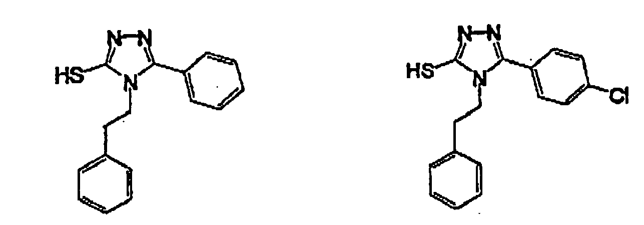

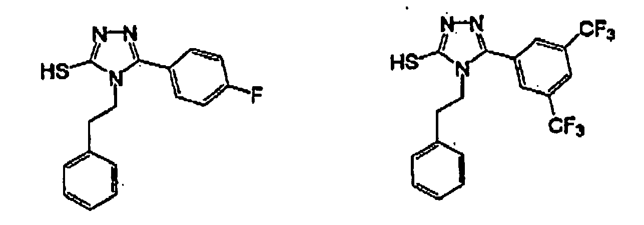

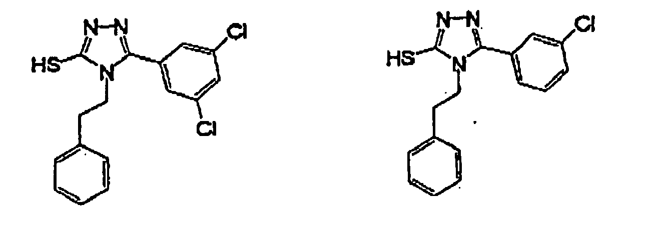

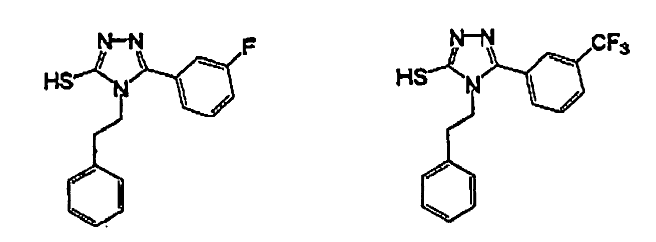

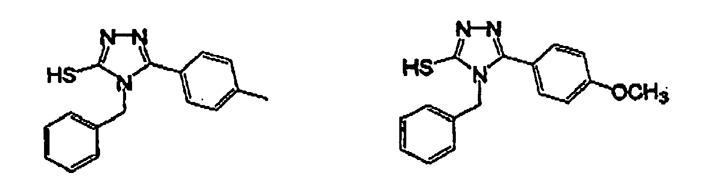

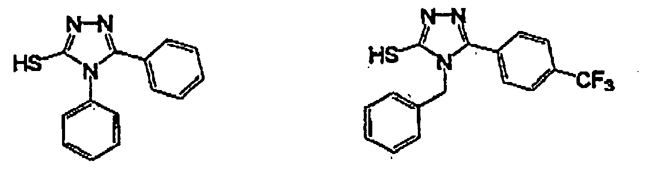

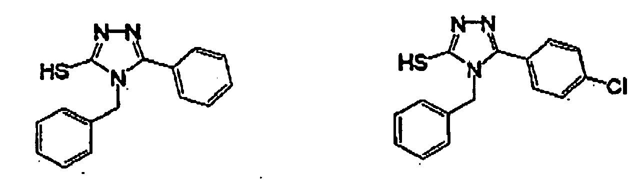

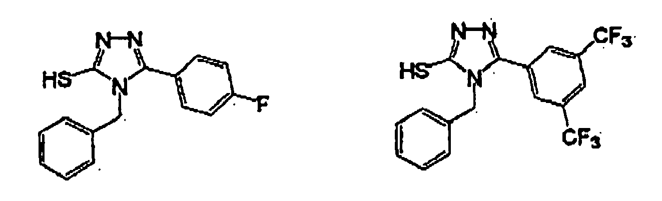

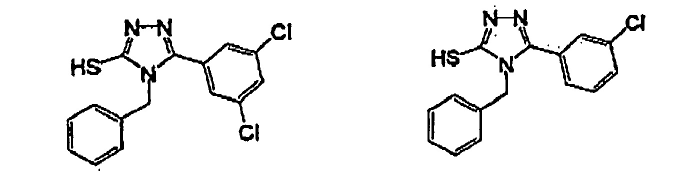

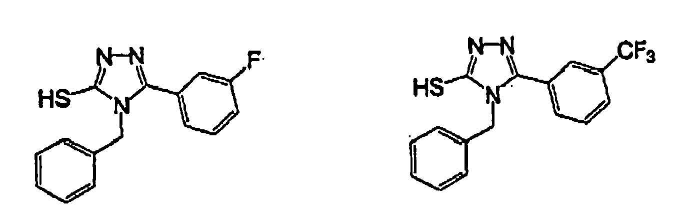

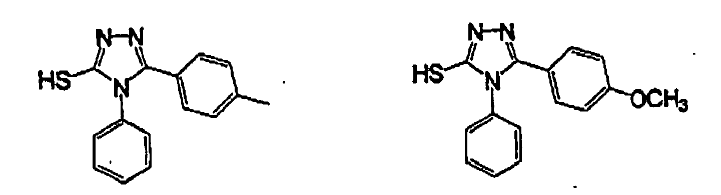

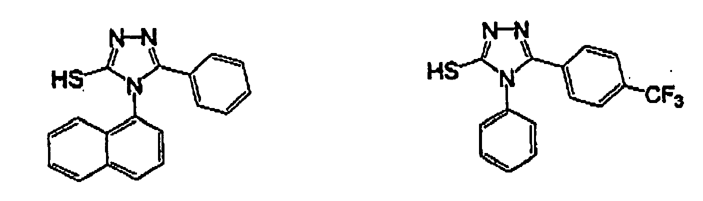

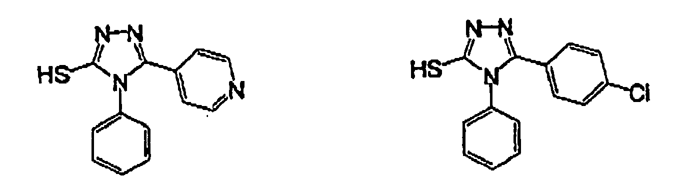

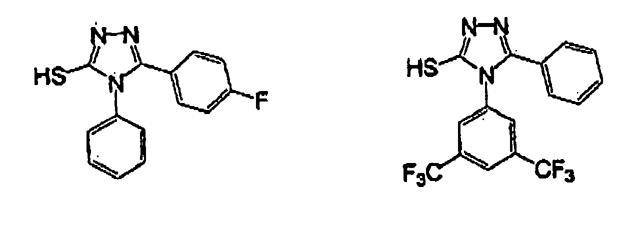

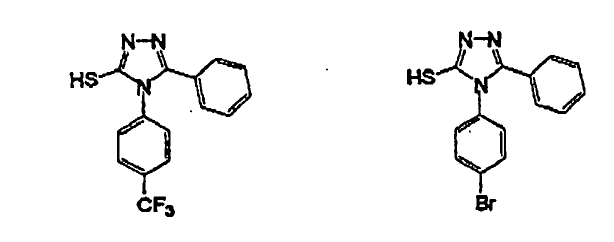

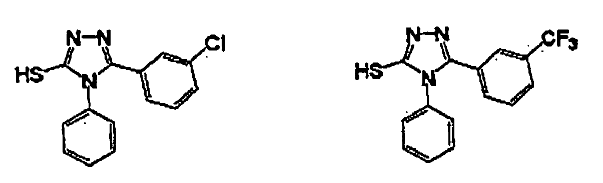

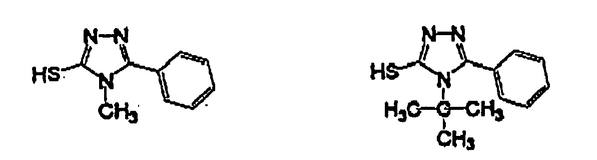

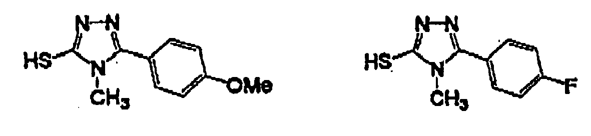

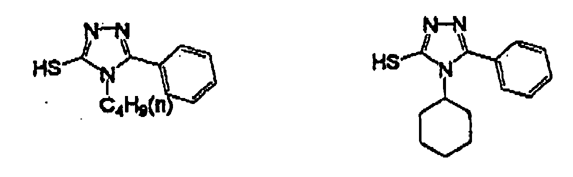

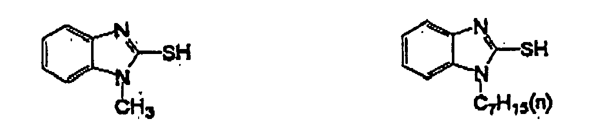

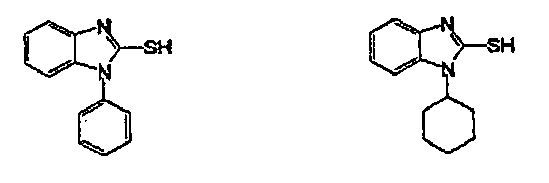

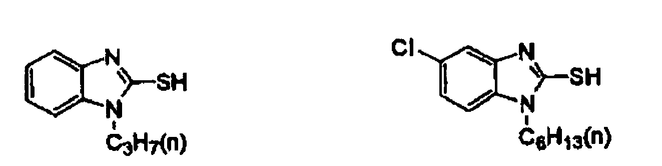

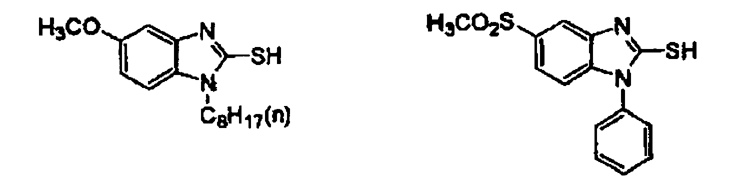

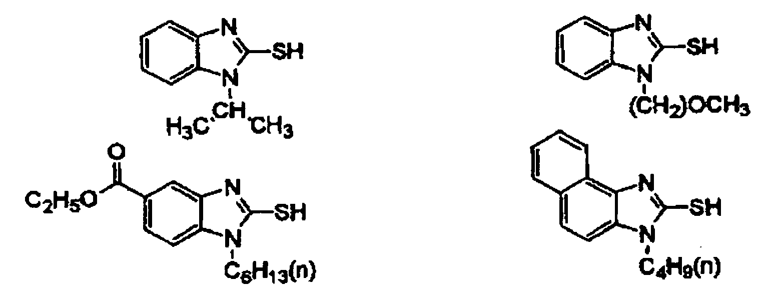

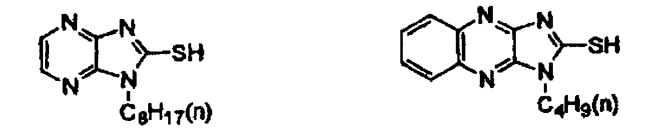

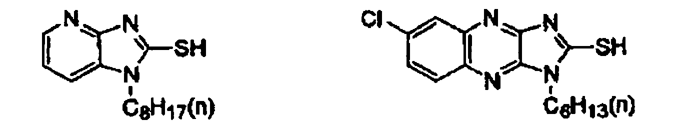

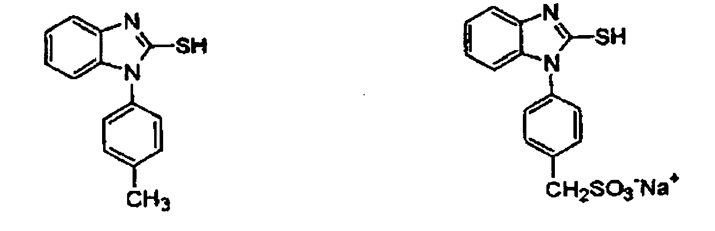

The amount of the chain transfer agent, for example, the thiol compound used is preferably from 0.01 to 20% by weight, more preferably from 0.1 to 15% by weight, still more preferably from 1.0 to 10% by weight, based on the total solid content of the photosensitive layer.

### <Binder polymer>

The binder polymer for use in the photosensitive layer according to the invention is a polymer which acts as a film-forming agent of the photosensitive layer and preferably includes a linear organic polymer. As the linear organic polymer, a known polymer can be used.

Examples of the binder polymer preferably includes polymers selected from an acrylic resin, a polyvinyl acetal resin, a polyurethane resin, a polyamide resin, an epoxy resin, a methacrylic resin, a styrene resin and a polyester resin. Among them, an acrylic resin and a polyurethane resin are preferable. The term "acrylic resin" as used herein means an acrylic polymer containing an acrylic acid derivative as a (co)polymer component. The term "polyurethane resin" as used herein means a polymer formed by a condensation reaction of a compound having two isocyanate groups and a compound having two hydroxy groups.
The binder polymer can be imparted with a crosslinking property in order to increase the film strength of the image area.
In order to impart the crosslinking property to the binder polymer, a crosslinkable functional group, for example, an ethylenically unsaturated bond is introduced into a main chain or side chain of the polymer. The crosslinkable functional group may be introduced by copolymerization or a polymer reaction.
The term "crosslinkable group" as used herein means a group capable of crosslinking the binder polymer in the process of a radical polymerization reaction which is caused in the photosensitive layer, when the lithographic printing plate precursor is exposed to light. The crosslinkable group is not particularly restricted as long as it has such a function and includes, for example, an ethylenically unsaturated bonding group, an amino group or an epoxy group as a functional group capable of conducting an addition polymerization reaction. Also, a functional group capable of forming a radical upon irradiation with light may be used and such a crosslinkable group includes, for example, a thiol group, a halogen atom and an onium salt structure. Among them, the ethylenically unsaturated bonding group is preferable, and functional groups represented by formulae (1) to (3) shown below are particularly preferable.

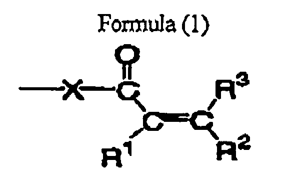

In formula (I), R¹ to R³ each independently represents a hydrogen atom or a monovalent organic group. R¹ preferably includes, for example, a hydrogen atom or an alkyl group which may have a substituent. Among them, a hydrogen atom or a methyl group is preferable because of high radical reactivity. R² and R³ each independently preferably includes, for example, a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferable because of high radical reactivity.
X represents an oxygen atom, a sulfur atom or -N(R¹²)-, and R¹² represents a hydrogen atom or a monovalent organic group. The monovalent organic group represented by R¹² includes, for example, an alkyl group which may have a substituent Among them, a hydrogen atom, a methyl group, an ethyl group or an isopropyl group is preferable for R¹² because of high radical reactivity.
Examples of the substituent introduced include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group and an arylsulfonyl group.

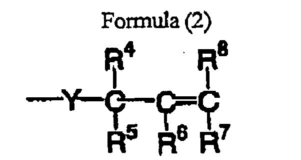

In formula (2), R⁴ to R⁸ each independently represents a hydrogen atom or a monovalent organic group. R⁴ to R⁸ each independently preferably includes, for example, a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent Among them, a hydrogen atom, a carboxyl group, an alkoxycarbonyl group, an alkyl group which may have a substituent or an aryl group which may have a substituent is preferable.
Examples of the substituent introduced include those described in Formula (1). Y represents an oxygen atom, a sulfur atom or -N(R¹²)-, and R¹² has the same meaning as R¹² defined in Formula (1). Preferable examples for R¹² are also same as those described in Formula
(1). 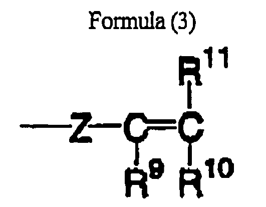 In formula (3), R⁹ to R¹¹ each independently represents a hydrogen atom or a monovalent organic group. R⁹ preferably represents a hydrogen atom or an alkyl group which may have a substituent. Among them, a hydrogen atom or a methyl group is preferable because of high radical reactivity. R¹⁰ and R¹¹ each independently represents, for example, a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferable because of high radical reactivity.
   Examples of the substituent introduced include those described in Formula (1). Z represents an oxygen atom, a sulfur atom, -N(R¹²)- or a phenylene group which may have a substituent R¹² has the same meaning as R¹² defined in Formula (1). Preferable examples for R¹² are also same as those described in Formula (1).
   Among the polymers, a (meth)acrylic acid copolymer and a polyurethane each having a crosslinkable group in the side chain thereof are more preferable.
   In the binder polymer having a crosslinking property, for example, a free radical (a polymerization initiating radical or a propagating radical in the process of polymerization of the polymerizable compound) is added to the crosslinkable functional group to cause an addition-polymerization between polymers directly or through a polymerization chain of the polymerizable compound, as a result, crosslinking is formed between polymer molecules to effect curing. Alternatively, an atom (for example, a hydrogen atom on the carbon atom adjacent to the functional crosslinkable group) in the polymer is withdrawn by a free radical to produce a polymer radical and the polymer radicals combine with each other to form crosslinking between polymer molecules to effect curing.
   The content of the crosslinkable group (content of radical-polymerizable unsaturated double bond determined by iodine titration) in the binder polymer is preferably from 0.1 to 10.0 mmol, more preferably from 1.0 to 7.0 mmol, and most preferably from 2.0 to 5.5 mmol, per g of the binder polymer.
   In order to for the non-image area of the photosensitive layer to be well removed in the plate making process of lithographic printing plate precursor, the binder polymer to be used is appropriately selected corresponding to an embodiment of the development processing. The details will be described below.

### (D-1) Alkali-soluble binder polymer

In the embodiment where the development processing is conducted using an alkali developer, since the binder polymer must be soluble in the alkali developer, an organic polymer compound soluble in an aqueous alkali solution is preferably used.
In order to be soluble in the aqueous alkali solution, the binder polymer preferably contains an alkali-soluble group. The alkali-soluble group is preferably an acid group and includes, for example, a carboxyl group, a sulfonic acid group, a phosphoric acid group or a hydroxy group. Among them, a binder polymer containing a carboxyl group is particularly preferable from the standpoint of compatibility between film-forming property, printing durability and developing property.
The alkali-soluble binder polymer may have the crosslinking property as described above in order to increase film strength of the image area. In order to impart the crosslinking property to the binder polymer, a crosslinkable functional group, for example, an ethylenically unsaturated bond is introduced into a main chain or side chain of the polymer. The crosslinkable functional group may be introduced by copolymerization or a polymer reaction.
The alkali-soluble binder polymer preferably has a weight average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.
The alkali-soluble binder polymer may be any of a random polymer, a block polymer, a graft polymer and the like, and is preferably a random polymer.
The alkali-soluble binder polymers may be used individually or in combination of two or more thereof.
The content of the alkali-soluble binder polymer is ordinarily from 5 to 90% by weight, preferably from 10 to 70% by weight, more preferably from 10 to 60% by weight, based on the total solid content of the photosensitive layer. In the range described above, good strength of the image area and good image-forming property are obtained.

### (D-2) Binder polymer containing hydrophilic group

As the binder polymer for the photosensitive layer according to the invention, a binder polymer containing a hydrophilic group may be used in order to improve developing property in a developer. In particular, in case of using a developer of acidity to weak alkalinity, such a binder polymer is preferably used.
The hydrophilic group is selected from monovalent and divalent or more valent hydrophilic groups, and preferably includes, for example, a hydroxy group, a sulfonic acid group, a carboxylic acid group, a phosphoric acid group, an alkylene oxy group (for example, an ethylene oxy group or a propylene oxy group), a primary amino group, a secondary amino group, a tertiary amino group, a salt formed by neutralization of an amino group with an acid, a quaternary ammonium group, a sulfonium group, an iodonium group, a phosphonium group, an amido group, an ether group, a salt formed by neutralization of an acid, for example, carboxylic acid, sulfonic acid or phosphoric acid. Especially, a primary amino group, a secondary amino group, a tertiary amino group, a salt formed by neutralization of an amino group with an acid, a quaternary ammonium group, an amido group, a hydroxy group, a repeating unit of -CH₂CH₂O- and a repeating unit of -CH₂CH₂NH- are preferable, and a tertiary amino group, a salt formed by neutralization of an acid group with an amino group-containing compound, a salt formed by neutralization of an amino group with an acid and a quaternary ammonium group are most preferable.
The binder polymer containing a hydrophilic group is preferably a copolymer. The ratio of the copolymerization component having a hydrophilic group as described above is preferably from 1 to 70% by mole based on the total copolymerization component of the copolymer from the standpoint of the developing property. In consideration of the compatibility between the developing property and printing durability, the ratio is more preferably from 1 to 50% by mole, and particularly preferably from 1 to 30% by mole.
As the skeleton of the binder polymer containing a hydrophilic group, a polymer selected from an acrylic resin, a polyvinyl acetal resin, a polyvinyl alcohol resin, a polyurethane resin, a polyamide resin, an epoxy resin, a methacrylic resin, a styrene resin and a polyester resin is preferable. Among them, a vinyl copolymer, for example, an acrylic resin, a methacrylic resin or a styrene resin and a polyurethane resin are particularly preferable.
The binder polymer containing a hydrophilic group for use in the invention preferably has a crosslinkable group. The content of the crosslinkable group (content of radical-polymerizable unsaturated double bond determined by iodine titration) in the binder polymer containing a hydrophilic group is preferably from 0.01 to 10.0 mmol, more preferably from 0.05 to 5.0 mmol, most preferably from 0.1 to 2.0 mmol, per g of the binder polymer containing a hydrophilic group.
From the standpoint of further improvement in the printing durability, it is preferred that the crosslinkable group is present near the hydrophilic group and both the hydrophilic group and the crosslinkable group may be present in the same polymerization unit.
The binder polymer containing a hydrophilic group for use in the invention preferably has a unit of alkyl (meth)acrylate or aralkyl (meth)acrylate besides the unit having a hydrophilic group, the unit having a crosslinkable group or the unit having a hydrophilic group and a crosslinkable group. The alkyl group in the alkyl (meth)acrylate is preferably an alkyl group having from I to 5 carbon atoms and more preferably a methyl group. The aralkyl (meth)acrylate includes, for example, benzyl (meth)acrylate.
The binder polymer containing a hydrophilic group preferably has a weight average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.
The binder polymer containing a hydrophilic group may be any of a random polymer, a block polymer, a graft polymer and the like.
The binder polymers containing a hydrophilic group may be used individually or in combination of two or more thereof. The content of the binder polymer containing a hydrophilic group is preferably from 5 to 75% by weight, more preferably from 10 to 70% by weight, still more preferably from 10 to 60% by weight, based on the total solid content of the photosensitive layer from the standpoint of good strength of the image area and good image-forming property.
The total content of the polymerizable compound and the binder polymer is preferably 80% by weight or less based on the total solid content of the photosensitive layer. When it exceeds 80% by weight, decrease in the sensitivity and deterioration in the developing property may be caused sometimes. The total content is more preferably from 35 to 75% by weight

Specific examples of the binder polymer containing a hydrophilic group for use in the invention are set forth below, but the invention should not be construed as being limited thereto.
In the tables below, the molecular weight of each binder polymer is a weight average molecular weight (Mw) measured by gel permeation chromatography (GPC) and determined using polystyrene as a standard substance.

| Polymer No. | Structure of Binder Polymer (% by mole) | Molecular Weight |
|---|---|---|
| P-1 | 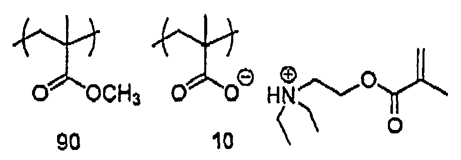 | 80000 |
| P-2 | 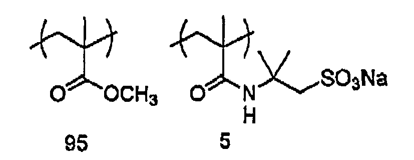 | 72000 |

| Polymer No. | Diisocyanate Compound Used (% by mole) | Diol Compound Used(% by mole) | Molecular Weight |
|---|---|---|---|
| P-3 | 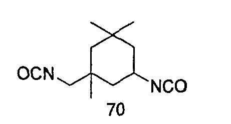 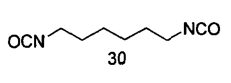 | 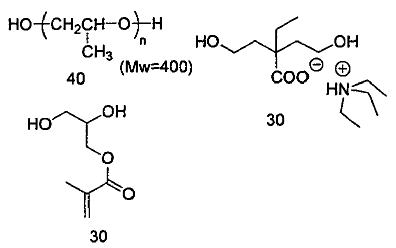 | 60000 |

| Polymer No. | Structure of Binder Polymer (% by mole) | Molecular Weight |
|---|---|---|
| P-4 | 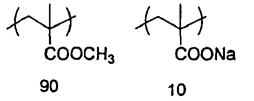 | 50000 |
| P-5 | 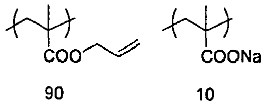 | 60000 |
| P-6 | 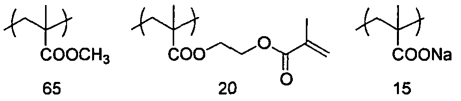 | 65000 |
| P-7 | 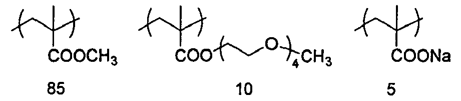 | 60000 |
| P-8 | 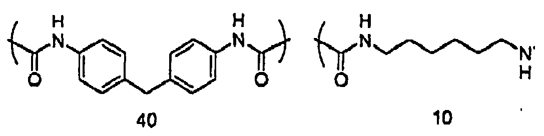 | 63000 |
| | 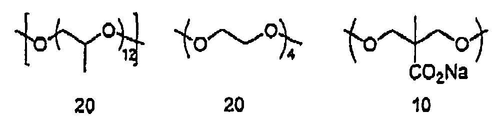 | |
| P-9 | 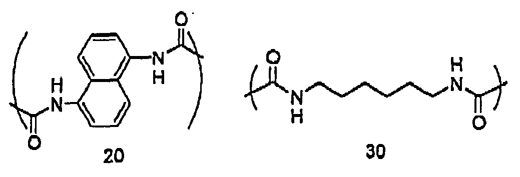 | 60000 |
| | 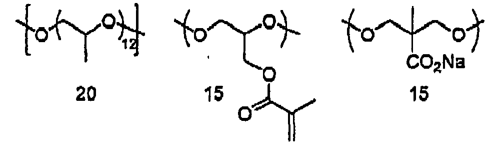 | |

| Polymer No. | Structure of Binder | Composition Ratio | Molecular Weight |
|---|---|---|---|
| P-10 | 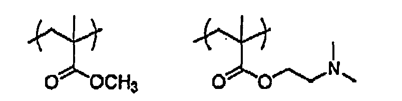 | 90/10 | 70000 |
| P-11 | 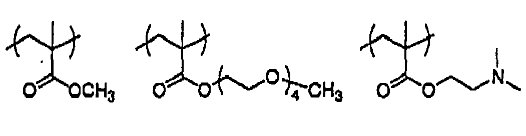 | 90/5/5 | 80000 |
| P-12 | 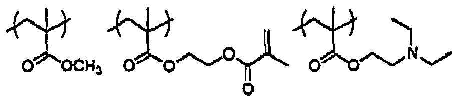 | 60/35/5 | 80000 |

| Polymer No. | Diisocyanate Compound Used (% by mole) | Diol Compound Used (% by mole) | Molecular Weight |
|---|---|---|---|
| P-13 | 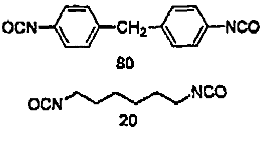 | 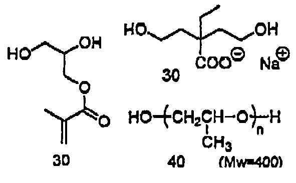 | 57000 |

| Polymer No. | Structure of Binder | Composition Ratio | Molecular Weight |
|---|---|---|---|
| P-14 | 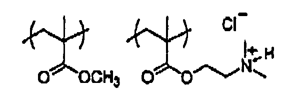 | 90/10 | 70000 |
| P-15 | 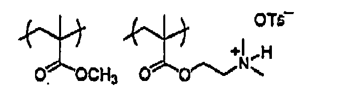 | 90/10 | 58000 |
| P-16 | 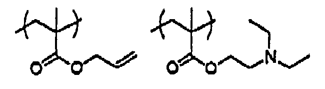 | 90/10 | 90000 |
| P-17 | 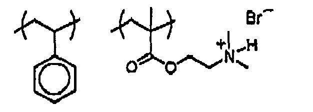 | 70/30 | 62000 |
| P -18 | 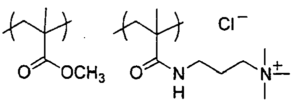 | 70/30 | 58000 |
| P -19 | 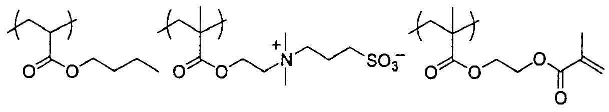 | 50/25/25 | 49000 |

| Polymer No. | Structure of Diisocyanate/ Dicarboxylic acid | | Structure of Diol/Diamine | Molecular Weight |
|---|---|---|---|---|
| P-20 | 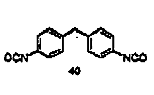 | 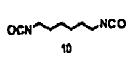 | 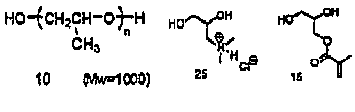 | 59000 |
| P-21 | 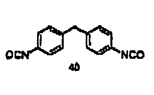 | 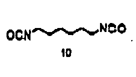 | 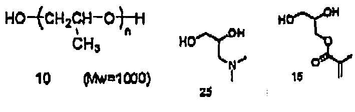 | 59000 |
| P-22 | 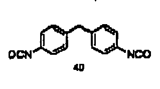 | 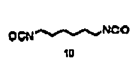 | 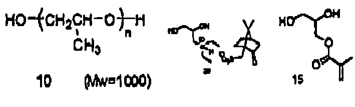 | 62000 |
| P-23 | 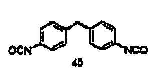 | 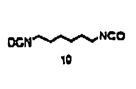 | 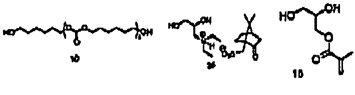 | 53000 |

| Polymer No. | Structure of Binder | Molecular Weight |
|---|---|---|
| P-24 | 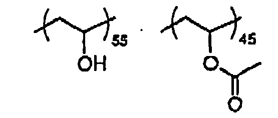 | 80000 |
| P-25 | 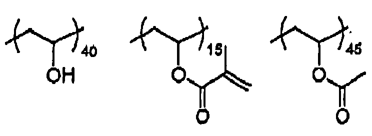 | 100000 |

### <Microcapsule>

In the invention, in order to incorporate the above-described constituting components of the photosensitive layer and other constituting components described hereinafter into the photosensitive layer, a part of the constituting components is encapsulated into microcapsules and added to the photosensitive layer as described, for example, in JP-A-2001-277740 and JP-A-2001-277742. In such a case, each constituting component may be present inside or outside the microcapsule in an appropriate ratio.
As a method of microencapsulating the constituting components of the photosensitive layer, known methods can be used. Methods for the production of microcapsules include, for example, a method of utilizing coacervation described in U.S. Patents 2,800,457 and 2,800,458, a method of using interfacial polymerization described in U.S. Patent 3,287,154, JP-B-38-19574 and JP-B-42-446, a method of using deposition of polymer described in U.S. Patents 3,418,250 and 3,660,304, a method of using an isocyanate polyol wall material described in U.S. Patent 3,796,669, a method of using an isocyanate wall material described in U.S. Patent 3,914,511, a method of using a urea-formaldehyde-type or urea-formaldehyde-resorcinol-type wall-forming material described in U.S. Patens 4,001,140, 4,087,376 and 4,089,802, a method of using a wall material, for example, a melamine-formaldehyde resin or hydroxycellulose described in U.S. Patent 4,025,445, an in-situ method by polymerization of monomer described in JP-B-36-9163 and JP-B-51-9079, a spray drying method described in British Patent 930,422 and U.S. Patent 3,111,407, and an electrolytic dispersion cooling method described in British Patents 952,807 and 967,074, but the invention should not be construed as being limited thereto.
A preferable microcapsule wall used in the invention has three-dimensional crosslinking and has a solvent-swellable property. From this point of view, a preferable wall material of the microcapsule includes polyurea, polyurethane, polyester, polycarbonate, polyamide and a mixture thereof, and particularly polyurea and polyurethane are preferred. Further, a compound having a crosslinkable functional group, for example, an ethylenically unsaturated bond, capable of being introduced into the binder polymer described above may be introduced into the microcapsule wall.
The average particle size of the microcapsule is preferably from 0.01 to 3.0 µm, more preferably from 0.05 to 2.0 µm, particularly preferably from 0.10 to 1.0 µm. In the range described above, preferable resolution and good preservation stability can be achieved.

### <Other components of photosensitive layer>

Into the photosensitive layer according to the invention, various additives can be further incorporated, if desired. Examples of the additive include a surfactant for progressing the developing property and improving the state of surface coated, a hydrophilic polymer for improving the developing property and dispersion stability of microcapsule, a coloring agent or print-out agent for visually distinguishing the image area from the non-image area, a polymerization inhibitor for preventing undesirable thermal polymerization of the radical polymerizable compound during the production and preservation of the photosensitive layer, a higher fatty acid derivative for avoiding polymerization inhibition due to oxygen, a fine inorganic particle for increasing strength of the cured layer in the image area, a hydrophilic low molecular weight compound for improving the developing property, a co-sensitizer or chain transfer agent for increasing sensitivity, and a plasticizer. As the additives, known compounds are used. For example, compounds described in JP-A-2007-171406, JP-A-2007-206216, JP-A-2007-206217, JP-A-2007-225701, JP-A-2007-225702, JP-A-2007-316582 and JP-A-2007-328243 are used.

### <Formation of photosensitive layer>

The photosensitive layer according to the invention is formed by dispersing or dissolving each of the necessary constituting components described above in a solvent to prepare a coating solution and coating the solution. The solvent used include, for example, ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyrolactone, toluene and water, but the invention should not be construed as being limited thereto. The solvents may be used individually or as a mixture. The solid content concentration of the coating solution is preferably from 1 to 50% by weight

The photosensitive layer according to the invention may also be formed by preparing plural coating solutions by dispersing or dissolving the same or different components described above into the same or different solvents and conducting repeatedly plural coating and drying.
The coating amount (solid content) of the photosensitive layer on the support after the coating and drying may be varied depending on the use, but ordinarily, it is preferably from 0.3 to 3.0 g/m². In the range described above, the preferable sensitivity and good film property of the photosensitive layer can be obtained.
Various methods can be used for the coating. Examples of the method include bar coater coating, spin coating, spray coating, curtain coating, dip coating, air knife coating, blade coating and roll coating.

### [Protective layer]

In the lithographic printing plate precursor according to the invention, a protective layer (oxygen-blocking layer) is preferably provided on the photosensitive layer in order to prevent diffusion and penetration of oxygen which inhibits the polymerization reaction at the time of exposure. The protective layer for use in the invention preferably has oxygen permeability (A) at 25°C under one atmosphere of 1.0 ≤ (A) ≤ 20 (ml/m²·day). When the oxygen permeability (A) is extremely lower than 1.0 (ml/m²·day), problems may occur in that an undesirable polymerization reaction arises during the production or preservation before image exposure and in that undesirable fog or spread of image line occurs at the image exposure. On the contrary, when the oxygen permeability (A) greatly exceeds 20 (ml/m²·day), decrease in sensitivity may be incurred. The oxygen permeability (A) is more preferably in a range of 1.5 ≤ (A) ≤ 12 (ml/m²·day), and still more preferably in a range of 2.0 ≤ (A) ≤ 10.0 (ml/m²·day). Besides the above described oxygen permeability, as for the characteristics required of the protective layer, it is desired that the protective layer does not substantially hinder the transmission of light for the exposure, is excellent in the adhesion property to the photosensitive layer, and can be easily removed during a development step after the exposure. Contrivances on the protective layer have been heretofore made and described in detail in U.S. Patent 3,458,311 and JP-B-55-49729.
As a binder polymer for the protective layer, a water-soluble polymer compound relatively excellent in crystallizability is preferably used. Specifically, a water-soluble polymer, for example, polyvinyl alcohol, vinyl alcohol/vinyl phthalate copolymer, vinyl acetate/vinyl alcohol/vinyl phthalate copolymer, vinyl acetate/crotonic acid copolymer, polyvinyl pyrrolidone, acidic cellulose, gelatin, gum arabic, polyacrylic acid or polyacrylamide is enumerated. The water-soluble polymer compounds may be used individually or as a mixture. Of the compounds, when polyvinyl alcohol is used as a main component, the best results can be obtained in the fundamental characteristics, for example, oxygen-blocking property and removability by development.
Polyvinyl alcohol for use in the protective layer may be partially substituted with ester, ether or acetal as long as it contains unsubstituted vinyl alcohol units for achieving the necessary oxygen-blocking property and water solubility. Also, a part of polyvinyl alcohol may have other copolymer component As specific examples of the polyvinyl alcohol, those having a hydrolysis degree of 71 to 100% and a polymerization repeating unit number of 300 to 2,400 are exemplified. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 (produced by Kuraray Co., Ltd.). They can be used individually or as a mixture, According to a preferred embodiment, the content of polyvinyl alcohol in the protective layer is from 20 to 95% by weight, and more preferably from 30 to 90% by weight

Also, known modified polyvinyl alcohol can be preferably used. For instance, polyvinyl alcohols of various polymerization degrees having at random a various kind of hydrophilic modified cites, for example, an anion-modified cite modified with an anion, e.g., a carboxyl group or a sulfo group, a cation-modified cite modified with a cation, e.g., an amino group or an ammonium group, a silanol-modified cite or a thiol-modified cite, and polyvinyl alcohols of various polymerization degrees having at the terminal of the polymer a various kind of modified cites, for example, the above-described anion-modified cite, cation modified cite, silanol-modified cite or thiol-modified cite, an alkoxy-modified cite, a sulfide-modified cite, an ester modified cite of vinyl alcohol with a various kind of organic acids, an ester modified cite of the above-described anion-modified cite with an alcohol or an epoxy-modified cite are exemplified.

As a component used as a mixture with polyvinyl alcohol, polyvinyl pyrrolidone or a modified product thereof is preferable from the viewpoint of the oxygen-blocking property and removability by development The content thereof is ordinarily from 3.5 to 80% by weight, preferably from 10 to 60% by weight, more preferably from 15 to 30% by weight, in the protective layer.
The components of the protective layer (selection of PVA and use of additives) and the coating amount are determined taking into consideration fogging property, adhesion property and scratch resistance besides the oxygen-blocking property and removability by development In general, the higher the hydrolyzing rate of the PVA used (the higher the unsubstituted vinyl alcohol unit content in the protective layer) and the larger the layer thickness, the higher is the oxygen-blocking property, thus it is advantageous in the point of sensitivity. The molecular weight of the binder, for example, polyvinyl alcohol (PVA) is ordinarily from 2,000 to 10,000,000, preferably from 20,000 to 3,000,000.
As other additive of the protective layer, glycerin, dipropylene glycol or the like can be added in an amount corresponding to several % by weight of the binder to provide flexibility. Further, an anionic surfactant, for example, sodium alkylsulfate or sodium alkylsulfonate, an amphoteric surfactant, for example, alkylaminocarboxylate and alkylaminodicarboxylate, or a nonionic surfactant, for example, polyoxyethylene alkyl phenyl ether can be added in an amount corresponding to several % by weight of the binder.
The adhesion property of the protective layer to the photosensitive layer and scratch resistance are also extremely important in view of handling of the printing plate precursor. Specifically, when a hydrophilic layer comprising a water-soluble polymer is laminated on the oleophilic photosensitive layer, layer peeling due to an insufficient adhesion property is liable to occur, and the peeled portion causes such a defect as failure in curing of the photosensitive layer due to polymerization inhibition by oxygen. Various proposals have been made for improving the adhesion property between the photosensitive layer and the protective layer. For example, it is described in U.S. Patent Application Nos. 292,501 and 44,563 that a sufficient adhesion property can be obtained by mixing from 20 to 60% by weight of an acryl-based emulsion or a water-insoluble vinyl pyrrolidone/vinyl acetate copolymer with a hydrophilic polymer mainly comprising polyvinyl alcohol and laminating the resulting mixture on the photosensitive layer. Any of these known techniques can be applied to the protective layer according to the invention. Coating methods of the protective layer are described in detail, for example, in U.S. Patent 3,458,311 and JP-B-55-49729.
Further, it is also preferred to incorporate an inorganic stratiform compound into the protective layer of the lithographic printing plate precursor according to the invention for the purpose of improving the oxygen-blocking property and property for protecting the surface of photosensitive layer.
The inorganic stratiform compound used here is a particle having a thin tabular shape and includes, for instance, mica, for example, natural mica represented by the following formula:
A (B, C)₂₋₅ D₄ O₁₀ (OH, F, O)₂, (wherein A represents any one of K, Na and Ca, B and C each represents any one of Fe (II), Fe(III), Mn, Al, Mg and V, and D represents Si or Al) or synthetic mica, talc represented by the following formula: 3MgO·4SiO·H₂O, teniolite, montmorillonite, saponite, hectoliter and zirconium phosphate.
   Of the inorganic stratiform compounds, fluorine based swellable synthetic mica, which is a synthetic inorganic stratiform compound, is particularly useful in the invention.
   The aspect ratio of the inorganic stratiform compound according to the invention is preferably 20 or more, more preferably 100 or more, and particularly preferably 200 or more. The aspect ratio is a ratio of major axis to thickness of particle and can be determined, for example, from a projection drawing of particle by a microphotography. The larger the aspect ratio, the greater the effect obtained.
   As for the particle size of the inorganic stratiform compound used in the invention, an average major axis is ordinarily from 0.3 to 20 µm, preferably from 0.5 to 10 µm, and particularly preferably from 1 to 5 µm. An average thickness of the particle is ordinarily 0.1 µm or less, preferably 0.05 µm or less, and particularly preferably 0.01 µm or less. For example, in the swellable synthetic mica that is the representative compound of the inorganic stratiform compounds, thickness is approximately from 1 to 50 nm and plain size is approximately from 1 to 20 µm.
   When such an inorganic stratiform compound particle having a large aspect ratio is incorporated into the protective layer, strength of coated layer increases and penetration of oxygen or moisture can be effectively inhibited and thus, the protective layer can be prevented from deterioration due to deformation, and even when the lithographic printing plate precursor is preserved for a long period of time under a high humidity condition, it is prevented from decrease in the image-forming property thereof due to the change of humidity and exhibits excellent preservation stability.
   The content of the inorganic stratiform compound in the protective layer is preferably from 5/1 to 1/100 in terms of weight ratio to the amount of binder used in the protective layer. When a plurality of inorganic stratiform compounds is used in combination, it is also preferred that the total amount of the inorganic stratiform compounds fulfills the above-described weight ratio.
   As a dispersing method for the inorganic stratiform compound used in the protective layer, methods described in JP-A-2007-171406, JP-A-2007-206216, JP-A-2007-206217, JP-A-2007-225701, JP-A-2007-225702, JP-A-2007-316582 and JP-A-2007-328243 are used.
   The coating amount of the protective layer is preferably in a range of 0.05 to 10 g/m² in terms of the coating amount after drying. When the protective layer contains the inorganic stratiform compound, it is more preferably in a range of 0.1 to 2 g/m², and when the protective layer does not contain the inorganic stratiform compound, it is more preferably in a range of 0.5 to 5 g/m².

### [Support]

As the support for the lithographic printing plate precursor according to the invention, any material may be used as long as it has a hydrophilic surface. A dimensionally stable plate-like material is preferable and includes, for example, paper, paper laminated with plastic (for example, polyethylene, polypropylene or polystyrene), a plate of metal (for example, aluminum, zinc or copper), or its alloy (for example, alloy of aluminum with silicon, copper, manganese, magnesium, chromium, zinc, lead, bismuth or nickel), a film of plastic (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinyl acetal) and paper or a plastic film laminated with or vapor-deposited thereon the metal or alloy as described above. Of the supports, an aluminum plate is particularly preferred since it is extremely dimensionally stable and is inexpensive. Also, a composite sheet comprising a polyethylene terephthalate film having bonded thereon an aluminum sheet described in JP-B-48-18327 is preferred. Ordinarily, the thickness of the support is approximately from 0.05 to 1 mm.
In case of using a support having a metal surface, particularly, an aluminum surface, the support is preferably subjected to a surface treatment, for example, a graining treatment, an immersion treatment in an aqueous solution, for example, of sodium silicate, potassium fluorozirconate or a phosphate, or anodizing treatment described below.

### <Graining treatment>

The graining treatment method includes a method of conducting mechanical graining, chemical etching and electrolytic graining as described in JP-A-56-28893. Also, an electrochemical graining method wherein surface graining is electrochemically conducted in an electrolytic solution of hydrochloric acid or nitric acid or a mechanical graining method, for example, a wire brush graining method wherein a surface of aluminum plate is scratched with a metal wire, a ball graining method wherein a surface of aluminum plate is grained with abrasive balls and an abrasive or a brush graining method wherein a surface of aluminum plate is grained with a nylon brush and an abrasive can be employed. The graining methods may be used individually or in combination thereof.
Among them, a method of forming surface roughness effectively used in the invention is an electrochemical graining method wherein surface graining is chemically conducted in an electrolytic solution of hydrochloric acid or nitric acid and suitable current density is in a range from 100 to 400 Coulomb/dm². More specifically, it is preferred to perform electrolysis in an electrolytic solution containing from 0.1 to 50% by weight of hydrochloric acid or nitric acid under the conditions of temperature from 20 to 100°C, time from one second to 30 minutes and current density from 100 to 400 Coulomb/dm².
The aluminum support subjected to the graining treatment is then chemically etched with an acid or an alkali. The method of using an acid as an etching agent takes time for destroying fine structures and thus, industrial application of the technique to the invention is disadvantageous. Such a problem can be resolved by using an alkali as the etching agent.
Examples of the alkali agent preferably used in the invention include sodium hydroxide, sodium carbonate, sodium aluminate, sodium metasilicate, sodium phosphate, potassium hydroxide and lithium hydroxide. Preferable ranges of the concentration and temperature are form 1 to 50% and 20 to 100°C, respectively. The conditions for providing a dissolution amount of aluminum in a range from 5 to 20 g/m³ are preferable.
After the etching procedure, the aluminum support is subjected to washing with an acid for removing stain (smut) remaining on the surface thereof Examples of the acid for use in the acid-washing step include nitric acid, sulfuric acid, phosphoric acid, chromic acid, hydrofluoric acid and hydrofluoroboric acid. As the method for removing smut after the electrochemical graining treatment, a method of bringing the aluminum support into contact with an aqueous 15 to 65% by weight sulfuric acid solution having a temperature of 50 to 90°C as described in JP-A-53-12739 and a method of performing alkali etching as described in JP-B-48-28123 are preferred.
Surface roughness (Ra) of the aluminum support according to the invention is preferably from 0.3 to 0.7 µm.

### <Anodizing treatment>

The aluminum support treated described above may further be subjected to anodizing treatment. The anodizing treatment can be conducted in a manner conventionally used in the field of art.

Specifically, it is performed by applying direct current or alternating current to the aluminum support in an aqueous solution or non-aqueous solution containing sulfuric acid, phosphoric acid, chromic acid, oxalic acid, sulfamic acid, benzenesulfonic acid, or a combination of two or more thereof to form an anodic oxide film on the surface of aluminum support.
The conditions of anodizing treatment cannot be determined generally, since they vary widely depending on the electrolytic solution to be used. However, it is ordinarily suitable that a concentration of the electrolytic solution is in a range from 1 to 80%, a temperature of the electrolytic solution is in a range from 5 to 70°C, a current density is in a range from 0.5 to 60 Ampere/dm², a voltage is in a range from 1 to 100 V, and a period of electrolysis is in a range from 10 to 100 seconds.
Of the anodizing treatments, a method of anodizing in a sulfuric acid solution with a high current density described in British Patent 1,412,768 and a method of anodizing using phosphoric acid as an electrolytic bath described in U.S. Patent 3,511,661 are preferably used.
According to the invention, the amount of anodic oxide film is preferably from 1 to 10 g/m². When the amount is less than 1 g/m², the printing plate is apt to be scratched. When the amount exceeds 10 g/m², a large quantity of electric power is necessary and thus it is economically disadvantageous. The amount of anodic oxide film is more preferably from 1.5 to 7 g/m², and still more preferably from 2 to 5 g/m².
The aluminum support may further be subjected to a sealing treatment of the anodic oxide film after the graining treatment and anodizing treatment according to the invention. The sealing treatment is performed by immersing the aluminum support in hot water or a hot aqueous solution containing an inorganic salt or an organic salt, or transporting the aluminum support in a water vapor bath. Moreover, the aluminum support for use in the invention may be subjected to a surface treatment other than silicate treatment with an alkali metal silicate, for example, immersion treatment in an aqueous solution, for example, of potassium fluorozirconate or a phosphate.

### [Backcoat layer]

After applying the surface treatment to the support or forming the undercoat layer on the support, a backcoat layer can be provided on the back surface of the support, if desired.
The backcoat layer preferably includes, for example, a coating layer comprising an organic polymer compound described in JP-A-5-45885 and a coating layer comprising a metal oxide obtained by hydrolysis and polycondensation of an organic metal compound or an inorganic metal compound described in JP-A-6-35174. Among them, use of an alkoxy compound of silicon, for example, Si(OCH₃)₄, Si(OC₂H₅)₄, Si(OC₃H₇)₄ or Si(OC₄H₉)₄ is preferred since the starting material is inexpensive and easily available.

### [Method of preparing lithographic printing plate]

Now, the method of preparing a lithographic printing plate using the lithographic printing plate precursor according to the invention is described in greater detail below. The method of preparing a lithographic printing plate according to the invention essentially comprises a step (exposure step) of exposing imagewise the lithographic printing plate precursor with laser and a step (development step) of removing the unexposed area of the photosensitive layer in the presence of a developer having pH of 2 to 11. A step of exposing to light and/or heating the entire surface of lithographic printing plate precursor may be provided between the exposure step and the development step and/or after the development step, if desired. Also, a drying step (including natural drying) may be provided after the development step.

### <Exposure>

The image exposure of the lithographic printing plate precursor is performed, for example, by a method of scanning of laser beam based on digital data. An example of preferable wavelength of the light source for use in the image exposure is from 350 to 450 nm.
Specifically, a gas laser, for example, Ar ion laser (364 nm, 351 nm,10 mW to 1 W), Kr ion laser (356 nm, 351 nm, 10 mW to 1 W) and He-Cd laser (441 nm, 325 nm, 1 mW to 100 mW); a solid laser, for example, a combination of Nd:YAG (YVO₄) with SHG crystals×twice (355 nm, 5 mW to 1 W) and a combination of Cr:LiSAF with SHG crystal (430 nm, 10 mW); a semiconductor laser system, for example, a KNbO₃ ring resonator (430 nm, 30 mW), a combination of a waveguide-type wavelength conversion element with an AlGaAs or InGaAs semiconductor (380 nm to 450 nm, 5 mW to 100 mW), a combination of a waveguide-type wavelength conversion element with an AlGaInP or AlGaAs semiconductor (300 nm to 350 nm, 5 mW to 100 mW), and AlGaInN (350 nm to 450 nm, 5 mW to 30 mW); and a pulse laser, for example, N₂ laser (337 nm, pulse 0.1 to 10 mJ) or XeF (351 nm, pulse 10 to 250 mJ) are exemplified. Among the light sources, the AlGaInN semiconductor laser (commercially available InGaN semiconductor laser, 400 to 410 nm, 5 to 30 mW) is particularly preferable in view of the wavelength characteristics and cost.
Another preferable example of the wavelength of light source for use in the image exposure is from 750 to 1,400 nm. Specifically, a solid laser and a semiconductor laser are preferably used. The output of the laser is preferably 100 mW or more. In order to shorten the exposure time, it is preferred to use a multibeam laser device. The exposure time per pixel is preferably within 20 microseconds. The irradiation energy on the lithographic printing plate precursor is preferably from 10 to 300 mJ/cm². When the energy for exposure is too low, curing of the photosensitive layer proceeds insufficiently. When the energy for exposure is too high, the photosensitive layer undergoes laser ablation, resulting in damage to the image in some cases.
In the image exposure according to the invention, light beams of the light source can be overlapped to perform exposure. The term "overlap" as used herein means that a pitch width of vertical scanning is smaller than a beam diameter. For example, when the beam diameter is represented by a half-value width of beam intensity (FWHM), the overlap can be quantitatively expressed by FWHM/pitch width of vertical scanning (overlap coefficient). According to the invention, the overlap coefficient is preferably 0.1 or more.
As for the exposure apparatus for the lithographic printing plate precursor of scanning exposure system, the exposure mechanism may be any of an internal drum system, an external drum system and a flat bed system. As the light source, among the light sources described above, those capable of conducting continuous oscillation can be preferably utilized.

### <Development>

An image can be formed by exposing imagewise the lithographic printing plate precursor according to the invention and removing the photosensitive layer in the unexposed area with a developer. According to the invention, the developer having pH of 2 to 11 is used, which is mild in comparison with a strong alkali developer conventionally used. The pH of developer is preferably from 3 to 10.5, and more preferably from 4 to 10.5.
The developer for use in the invention preferably includes a surfactant. The surfactant used includes any of anionic, nonionic, cationic and amphoteric surfactants.
The anionic surfactant is not particularly limited and conventionally known anionic surfactants can be used. Examples of the anionic surfactant include fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkylphenoxy polyoxyethylene propylsulfonic acid salts, polyoxyethylene alkylsulfophenyl ether salts, N-methyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer, naphthalene sulfonate formalin condensates, aromatic sulfonic acid salts and aromatic substituted polyoxyethylene sulfonic acid salts. Of the compounds, dialkylsulfosuccinic acid salts, alkyl sulfate ester salts and alkylnaphthalenesulfonic acid salts are particularly preferably used.
The cationic surfactant is not particularly limited and conventionally known cationic surfactants can be used. Examples of the cationic surfactant include alkylamine salts, quaternary ammonium salts, polyoxyethylene alkyl amine salts and polyethylene polyamine derivatives.
The nonionic surfactant is not particularly limited and conventionally known nonionic surfactants can be used. Examples of the nonionic surfactant include polyethylene glycol type higher alcohol ethylene oxide addacts, alkylphenol ethylene oxide addacts, polyethylene glycol adducts of aromatic compound, fatty acid ethylene oxide addacts, polyhydric alcohol fatty acid ester ethylene oxide addacts, higher alkylamine ethylene oxide addacts, fatty acid amide ethylene oxide addacts, ethylene oxide addacts of fat, polypropylene glycol ethylene oxide addacts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers ofpolyhydric alcohols and fatty acid amides of alkanolamines.
In the invention, polyethylene glycol type higher alcohol ethylene oxide addacts, polyethylene glycol adducts of aromatic compound, ethylene oxide addacts of sorbitol and/or sorbitan fatty acid esters, polypropylene glycol ethylene oxide addacts, dimethylsiloxane-ethylene oxide block copolymers, dimethylsiloxane-(propylene oxide-ethylene oxide) block copolymers and fatty acid esters of polyhydric alcohols are more preferable.
Further, from the standpoint of stable solubility in water or opacity, with respect to the nonionic surfactant, the HLB (hydrophile-lipophile balance) value thereof is preferably 6 or more, and more preferably 8 or more. Furthermore, an oxyethylene adduct of acetylene glycol type or acetylene alcohol type or a surfactant, for example, a fluorine-based surfactant or a silicon-based surfactant can also be used.
The amphoteric surfactant is a compound having an anionic site and a cationic site in its molecule as well known in the field of surfactant and includes, for example, amphoteric surfactants of amino acid type, betaine type and amine oxide type. As the amphoteric surfactant used in the developer for use in the invention, a compound represented by formula <1> shown below or a compound represented by formula <2> shown below is preferable.

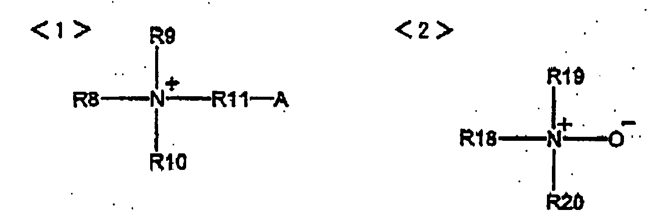

In formula <1>, R8 represents an alkyl group, R9 and R10 each represents a hydrogen atom or an alkyl group, R11 represents an alkylene group, and A represents a carboxylate ion or a sulfonate ion.
In formula <2>, R18, R19 and R20 each represents a hydrogen atom or an alkyl group, provided that all or R18, R19 and R20 are not hydrogen atoms at the same time.
In formula <1>, the alkyl group represented by R8, R9 or R10 or the alkylene group represented by R11 may be a straight chain or branched structure, may contain a connecting group in the chain thereof and may have a substituent. As the connecting group, a connecting group containing a hetero atom, for example, an ester bond, an amido bond or an ether bond is preferable. As the substituent, a hydroxy group, an ethylene oxide group, a phenyl group, an amido group or a halogen atom is preferable.
In the compound represented by formula <1>, as the total number of carbon atoms increases, the hydrophobic portion becomes large and dissolution of the compound in an aqueous developer becomes difficult. In such a case, the dissolution is improved by adding a dissolution auxiliary agent, for example, an organic solvent, e.g., an alcohol. However, when the total number of carbon atoms excessively increases, the surfactant can not be dissolved in the proper amount in some cases. Therefore, the total number of carbon atoms included in R8 to R11 in formula <1> is preferably from 8 to 25, and more preferably from 11 to 21.
In formula <2>, the alkyl group represented by R18, R19 or R20 may be a straight chain or branched structure, may contain a connecting group in the chain thereof and may have a substituent. As the connecting group, a connecting group containing a hetero atom, for example, an ester bond, an amido bond or an ether bond is preferable. As the substituent, a hydroxy group, an ethylene oxide group, a phenyl group, an amido group or a halogen atom is preferable.

In the compound represented by formula <2>, as the total number of carbon atoms increases, the hydrophobic portion becomes large and dissolution of the compound in an aqueous developer becomes difficult. In such a case, the dissolution is improved by adding a dissolution auxiliary agent, for example, an organic solvent, e.g., an alcohol. However, when the total number of carbon atoms excessively increases, the surfactant can not be dissolved in the proper amount in some cases. Therefore, the total number of carbon atoms included in R18 to R20 in formula <2> is preferably from 8 to 22, and more preferably from 10 to 20.

The total number of carbon atoms in the amphoteric surfactant may be influenced depending on property of the materials used in the photosensitive layer, especially, a binder polymer. When the binder polymer having high hydrophilicity is used, it tends to be preferable that the total number of carbon atoms is relatively small. On the other hand, when the binder having low hydrophilicity is used, it tends to be preferable that the total number of carbon atoms is relatively large.

Preferable specific examples of the amphoteric surfactant for use in the developer are set forth below, but the invention should not be construed as being limited thereto.

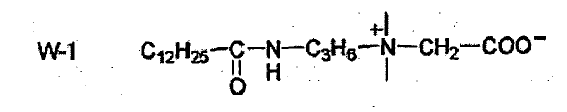

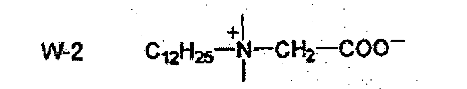

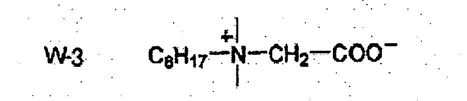

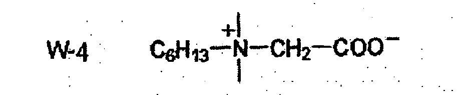

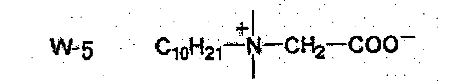

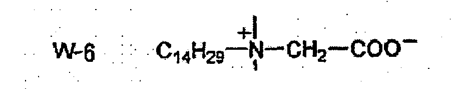

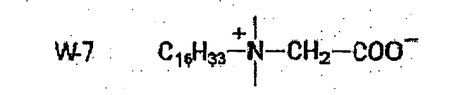

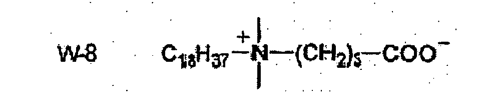

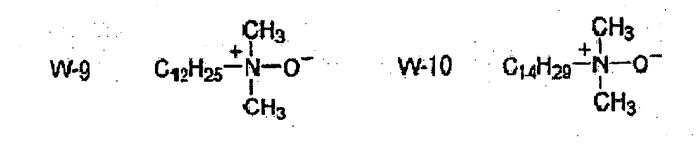

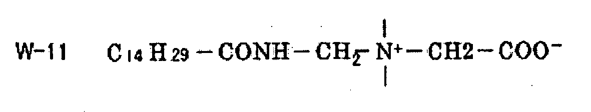

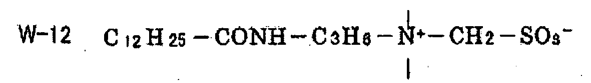

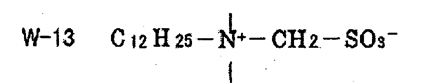

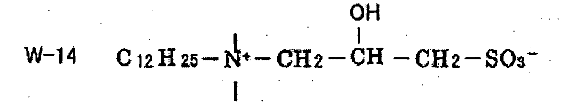

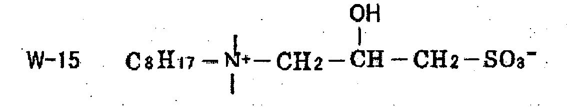

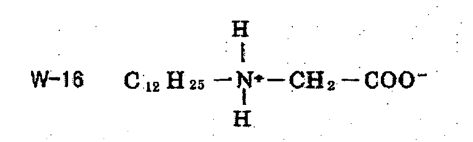

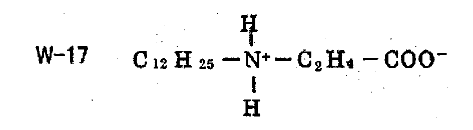

The surfactants may be used individually or in combination of two or more thereof The content of the surfactant in the developer is preferably from 0.01 to 10% by weight, and more preferably from 0.01 to 5% by weight.

The developer for use in the invention may contain a pH buffer agent.

As the pH buffer agent according to the invention, any buffer agent exhibiting a buffer function at pH of 2 to 11 can be used without particular restriction. In the invention, an alkaline buffer agent is preferably used. For example, (a) a carbonate ion and a hydrogen carbonate ion, (b) a borate ion, (c) a water-soluble amine compound and an ion of the water-soluble amine compound, and combinations thereof are illustrated. Using the buffer agent, the developer exhibits the pH buffer function and is prevented from fluctuation of the pH even when it is used for a long period of time. As a result, the deterioration of developing property resulting from the fluctuation of pH, the occurrence of development scum and the like are restrained. The combination of a carbonate ion and a hydrogen carbonate ion is particularly preferable.
(a) In order for a carbonate ion and a hydrogen carbonate ion to be present in a developer, a carbonate and a hydrogen carbonate may be added to the developer or a carbonate ion and a hydrogen carbonate ion may be generated by adding a carbonate or a hydrogen carbonate to a developer and then adjusting the pH. The carbonate or hydrogen carbonate used is not particularly restricted and it is preferably an alkali metal salt thereof. Examples of the alkali metal include lithium, sodium and potassium and sodium is particularly preferable. The alkali metals may be used individually or in combination of two or more thereof.
(b) In order for a borate ion to be present in a developer, a boric acid or a borate is added to a developer and then pH of the developer is adjusted using an alkali or an alkali and an acid to generate an appropriate amount of the borate ion.
   The boric acid or a borate used is not particularly restricted. The boric acid includes, for example, ortho boric acid, metha boric acid and tetra boric acid, and preferably ortho boric acid and tetra boric acid. The borate includes an alkali metal salt thereof and an alkaline earth metal salt thereof, specifically, an orthoborate, a diborate, a methaborate, a tetraborate, a pentaborate and an octaborate, preferably an orthoborate and a tetraborate, and particularly preferably an alkali metal salt of tetraborate. The alkali metal salt of tetraborate includes, for example, sodium tetraborate, potassium tetraborate and lithium tetraborate, and particularly preferably sodium tetraborate. The borates may be used individually or in combination of two or more thereof
   As the boric acid and borate for use in the invention, ortho boric acid, tetra boric acid and sodium tetraborate are particularly preferable. The boric acid and borate may be used in combination in the developer.
(c) An ion of a water-soluble amine compound may be generated in an aqueous solution of the water-soluble amine compound. To the aqueous solution of water-soluble amine compound may be added an alkali or an acid. Alternatively, the ion of a water-soluble amine compound may be contained in an aqueous solution by adding a compound which is a salt of amine compound per se. The water-soluble amine compound is not particularly restricted and preferably a water-soluble amine compound having a group capable of facilitating water-solubility. The group capable of facilitating water-solubility includes, for example, a carboxylic acid group, a sulfonic acid group, a sulfinic acid group, a phosphonic acid group and a hydroxy group. The water-soluble amine compound may have two or more groups capable of facilitating water-solubility.
   In case where the water-solubility of the water-soluble amine compound is facilitated with a carboxylic acid group, a sulfonic acid group, a sulfinic acid group or a phosphonic acid group, the water-soluble amine compound corresponds to an amino acid. The amino acid is held in equilibrium in an aqueous solution and for example, when the acid group is a carboxylic acid group, the equilibrium state is indicated as below. In the invention, the amino acid means State B shown below and an amino acid ion means State C shown below. A counter ion in State C is preferably a sodium ion or a potassium ion.

### Equilibrium of amino acid (case wherein acid group is carboxylic acid group)

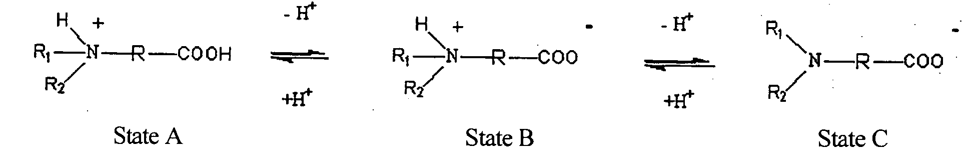

wherein, for example, R₁ and R₂ each independently represents a hydrogen atom, an alkyl group or an aryl group, and R represents a connecting group.

Specific examples of the water-soluble amine compound having a carboxylic acid group, a sulfonic acid group or a sulfinic acid group include an amino acid, for example, glycine, iminodiacatic acid, lysine, threonine, serine, asparaginic acid, parahydroxyphenyl glycine, dihydroxyethyl glycine, alanine, anthranilic acid or tryptophan, sulfamic acid, cyclohexylsulfamic acid, an aliphatic amine sulfonic acid, for example, taurine, and an aliphatic amine sulfinic acid, for example, aminoethanesulfinic acid. Among them, glycine and iminodiacetic acid are preferable.

Specific examples of the water-soluble amine compound having a phosphonic acid group (including a phosphinic acid group) include 2-aminoethylphosphonic acid, 1-aminoethane-1,1-diphosphonic acid, 1-amino-1-phenylmethane-1,1-diphosphonic acid, 1-dimethylaminoethane-1,1-diphosphonic acid and ethylenediaminopentamethylenephosphonic acid. Particularly, 2-aminoethylphosphonic acid is preferable.

The water-soluble amine compound having a hydroxy group as the group capable of facilitating water-solubility means an alkylamine (State B shown below) having a hydroxy group in its alkyl group and its ion means an ammonium ion (State A shown below) of the amino group. 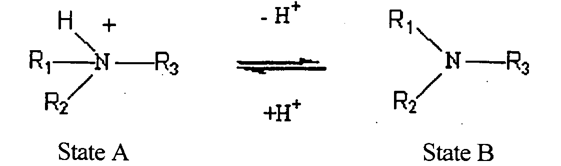 wherein, for example, R₁ R₂ and R₃ each independently represents a hydrogen atom, an alkyl group or an aryl group, provided that at least one of R₁, R₂ and R₃ represents an alkyl group having a hydroxy group.
Examples of the water-soluble amine compound having a hydroxy group include monoethanol amine, diethanol amine, trimethanol amine, triethanol amine, tripropanol amine and triisopropanol amine. Among them, triethanol amine and diethanol amine are preferable. A counter ion of the ammonium group is preferably a chloride ion.
The alkali for use in the adjustment of pH includes, for example, sodium hydroxide, potassium hydroxide, lithium hydroxide, sodium carbonate, potassium carbonate, ammonium carbonate, sodium hydrogen carbonate, potassium hydrogen carbonate, ammonium hydrogen carbonate, an organic alkali agent and combinations thereof. The acid for use in the adjustment of pH includes, for example, an inorganic acid, for example, hydrochloric acid, sulfuric acid or a nitric acid.
In case of using the pH buffer agent, pH of the developer is preferably in a range of 8.5 to 10.8. When the pH is 8.5 or higher, the developing property in the non-image area is well maintained. On the other hand, when the pH is 10.8 or lower, the developer is hardly affected by carbon dioxide in the atmosphere and degradation of the processing ability due to the influence of carbon dioxide can be prevented. The pH of the developer is more preferably in a range of 8.8 to 10.2, and particularly preferably in a range of 9.0 to 10.0.
For the purpose of finely adjusting the alkali concentration or aiding dissolution of the photosensitive layer in the non-image area, an alkali agent, for example, an organic alkali agent may be supplementarily used together. Examples of the organic alkali agent include monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine and tetramethylammonium hydroxide. The supplementary alkali agents may be used individually or in combination of two or more thereof.
When the combination of (a) a carbonate ion and a hydrogen carbonate ion is adopted as the pH buffer agent, the total amount of the carbonate ion and hydrogen carbonate ion is preferably from 0.05 to 5 mole/l, more preferably from 0.1 to 2 mole/l, particularly preferably from 0.2 to 1 mole/l, in the developer. When the total amount is 0.05 mole/l or more, developing property and processing ability are not degraded. When the total amount is 5 mole/l or less, precipitates and crystals hardly generate and since gelation at neutralization of waste liquid of the developer hardly occur, treatment of the waste liquid can be carried out without trouble.
When (b) a borate ion is adopted as the pH buffer agent, the total amount of the borate ion is preferably from 0.05 to 5 mole/l, more preferably from 0.1 to 2 mole/l, particularly preferably from 0.2 to 1 mole/l, in the developer. When the total amount of borate ion is 0.05 mole/l or more, developing property and processing ability are not degraded On the other hand, when the total amount of borate ion is 5 mole/l or less, precipitates and crystals hardly generate and since gelation at neutralization of the waste liquid hardly occur, treatment of the waste liquid can be carried out without trouble.
When the combination of (c) a water-soluble amine compound and an ion of the water-soluble amine compound is adopted as the pH buffer agent, the total amount of the water-soluble amine compound and ion of water-soluble amine compound is preferably from 0.01 to 1 mole/l, more preferably from 0.03 to 0.7 mole/l, particularly preferably from 0.05 to 0.5 mole/l, in the developer. When the total amount of ion of water-soluble amine compound is in the range described above, developing property and processing ability are not degraded and treatment of the waste liquid can be easily carried out.
The developer for use in the invention may contain a wetting agent, an antiseptic agent, a chelating agent, a defoaming agent, an organic solvent, an inorganic acid, an inorganic salt, a water-soluble resin or the like in addition the components described above.
As the wetting agent, for example, ethylene glycol, propylene glycol, triethylene glycol, butylene glycol, hexylene glycol, diethylene glycol, dipropylene glycol, glycerin, trimethylol propane or diglycerin is preferably used. The wetting agents may be used individually or in combination of two or more thereof. The wetting agent is ordinarily used in an amount of 0.1 to 5% by weight based on the total weight of the developer.
As the antiseptic agent, for example, phenol or a derivative thereof, formalin, an imidazole derivative, sodium dehydroacetate, a 4-isothiazolin-3-one derivative, benzisotiazolin-3-one, 2-methyl-4-isothiazolin-3-one, a benzotriazole derivative, an amidine guanidine derivative, a quaternary ammonium salt, a pyridine derivative, a quinoline derivative, a guanidine derivative, diazine, a triazole derivative, oxazole, an oxazine derivative or a nitrobromoalcohol-based compound, e.g., 2-bromo-2-nitropropane-1,3-diol, 1,1-dibromo-1-nitro-2-ethanol or 1,1-dibromo-1-nitro-2-propanol is preferably used. It is preferred to use two or more kinds of the antiseptic agents so as to exert the effect to various molds and bacteria. The amount of the antiseptic agent added is an amount stably exerts the effect to bacterium, molds, yeast or the like. Although the amount of the antiseptic agent may be varied depending on the kind of the bacterium, molds, yeast or the like, it is preferably in a range of 0.01 to 4% by weight based on the developer.
As the chelating agent, for example, ethylenediaminetetraacetic acid, potassium salt thereof, sodium salt thereof; diethylenetriaminepentaacetic acid, potassium salt thereof, sodium salt thereof; triethylenetetraminehexaacetic acid, potassium salt thereof, sodium salt thereof; hydroxyethylethylenediaminetriacetic acid, potassium salt thereof, sodium salt thereof; nitrilotriacetic acid, sodium salt thereof; organic phosphonic acids, for example, 1-hydroxyethane-1,1-diphosphonic acid, potassium salt thereof, sodium salt thereof, aminotri(methylenephosphonic acid), potassium salt thereof, sodium salt thereof; and phosphonoalkanetricarboxylic acids are illustrated. A salt of an organic amine is also effectively used in place of the sodium salt or potassium salt in the chelating agent. The chelating agent is so selected that it is stably present in the developer and does not impair the printing property. The amount of the chelating agent added is preferably from 0.001 to 1.0% by weight based on the developer.
As the defoaming agent, for example, a conventional silicone-based self-emulsifying type or emulsifying type defoaming agent, or a nonionic compound having HLB of 5 or less is used. The silicone defoaming agent is preferably used. Any of emulsifying dispersing type and solubilizing type can be used. The amount of the defoaming agent added is preferably from 0.001 to 1.0% by weight based on the developer.
As the organic solvent, for example, an aliphatic hydrocarbon (e.g., hexane, heptane, Isopar E, Isopar H, Isopar G (produced by Esso Chemical Co., Ltd.), gasoline or kerosene), an aromatic hydrocarbon (e.g., toluene or xylene), a halogenated hydrocarbon (methylene dichloride, ethylene dichloride, trichlene or monochlorobenzene) or a polar solvent is exemplified.
Examples of the polar solvent include an alcohol (e.g., methanol, ethanol, propanol, isopropanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methyl phenyl carbinol, n-amyl alcohol or methylamyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine or N-phenyldiethanolamine).
Further, when the organic solvent is insoluble in water, it may be employed by being solubilized in water using a surfactant or the like. In the case where the developer contains the organic solvent, the concentration of the organic solvent is desirably less than 40% by weight in view of safety and inflammability.
As the inorganic acid or inorganic salt, for example, phosphoric acid, methaphosphoric acid, ammonium primary phosphate, ammonium secondary phosphate, sodium primary phosphate, sodium secondary phosphate, potassium primary phosphate, potassium secondary phosphate, sodium tripolyphosphate, potassium pyrophosphate, sodium hexamethaphosphate, magnesium nitrate, sodium nitrate, potassium nitrate, ammonium nitrate, sodium sulfate, potassium sulfate, ammonium sulfate, sodium sulfite, ammonium sulfite, sodium hydrogen sulfate or nickel sulfate is illustrated. The amount of the inorganic acid or inorganic salt added is preferably from 0.01 to 0.5% by weight based on the total weight of the developer.
As the water-soluble resin, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer or a styrene/maleic anhydride copolymer is exemplified. An acid value of the water-soluble resin is preferably from 0 to 3.0 meq/g.
As the soybean polysaccharide, those conventionally known can be used. For example, as a commercial product, Soyafive (produced by Fuji Oil Co., Ltd) is available and various grade products can be used. The soybean polysaccharide preferably used has viscosity in a range of 10 to 100 mPa/sec in a 10% by weight aqueous solution thereof.
As the modified starch, that represented by formula (M) shown below is exemplified. As a starch used for the production of the modified starch, any starch, for example, of com, potato, tapioca, rice or wheat can be used. The modification of starch can be performed, for example, by a method wherein starch is decomposed, for example, with an acid or an enzyme to an extent that the number of glucose residue per molecule is from 5 to 30 and then oxypropylene is added thereto in an alkali.

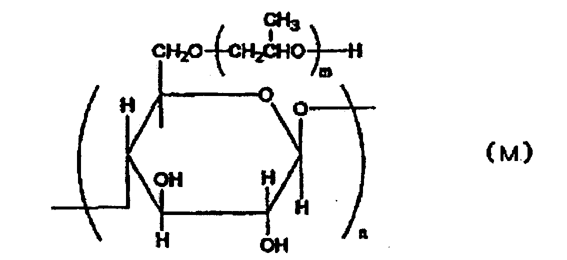

In formula (M), the etherification degree (substitution degree) is in a range of 0.05 to 1.2 per glucose unit, n represents an integer of 3 to 30, and m represents an integer of 1 to 3.

Other examples of the modified starch and the derivative thereof include roast starch, for example, British gum, an enzymatically modified dextrin, for example, enzyme dextrin or Shardinger dextrin, oxidized starch, for example, solubilized starch, alphalized starch, for example, modified alphalized starch or unmodified alphalized starch, esterified starch, for example, starch phosphate, starch of fatty acid, starch sulfate, starch nitrate, starch xanthate or starch carbamate, etherified starch, for example, carboxyalkyl starch, hydroxyalkyl starch, sulfoalkyl starch, cyanoethyl starch, allyl starch, benzyl starch, carbamylethyl starch or dialkylamino starch, cross-linked starch, for example, methylol cross-linked starch, hydroxyalkyl cross-linked starch, phosphoric acid cross-linked starch or dicarboxylic acid cross-linked starch, and starch graft polymer, for example, starch-polyacrylamide copolymer, starch-polyacrylic acid copolymer, starch-polyvinyl acetate copolymer, starch-polyacrylonitrile copolymer, cationic starch-polyacrylate copolymer, cationic starch-vinyl polymer copolymer, starch-polystyrene-maleic acid copolymer, starch-polyethylene oxide copolymer or starch-polypropylene copolymer.

Of the water-soluble resins, for example, soybean polysaccharide, modified starch, gum arabic, dextrin, carboxymethyl cellulose or polyvinyl alcohol is preferable.

The water-soluble resins may be used in combination of two or more. The content of the water-soluble resin is preferably from 0.1 to 20% by weight, more preferably from 0.5 to 10% by weight, based on the developer.

The temperature of developer is ordinarily 60°C or lower, and preferably from about 15 to about 40°C. In the case of conducting the development processing using an automatic developing machine, the developer becomes fatigued in accordance with the processing amount, and hence the processing ability may be restored using a replenisher or a fresh developer.
The development step can be preferably performed by an automatic processor equipped with a rubbing member. As the automatic processor, there are illustrated an automatic processor in which a lithographic printing plate precursor after imagewise exposure is subjected to a rubbing treatment while it is transporting described in JP-A-2-220061 and JP-A-60-59351, and an automatic processor in which a lithographic printing plate precursor after imagewise exposure placed on a cylinder is subjected to a rubbing treatment while rotating the cylinder described in U.S. Patents 5,148,746 and 5,568,768 and British Patent 2,297,719. Among them, an automatic processor using a rotating brush roller as the rubbing member is particularly preferred.
The rotating brush roller which can be preferably used in the invention can be appropriately selected by taking account, for example, of scratch resistance of the image area and nerve strength of the support of the lithographic printing plate precursor. As for the rotating brush roller, a known rotating brush roller produced by implanting a brush material in a plastic or metal roller can be used. For example, a rotating brush roller described in JP-A-58-159533 and JP-A-3-100554, or a brush roller described in JP-UM-B-62-167253 (the term "JP-UM-B" as used herein means an "examined Japanese utility model publication"), in which a metal or plastic groove-type member having implanted therein in rows a brush material is closely radially wound around a plastic or metal roller acting as a core, can be used.
As the brush material, a plastic fiber (for example, a polyester-based synthetic fiber, e.g., polyethylene terephthalate or polybutylene terephthalate, a polyamide-based synthetic fiber, e.g., nylon 6.6 or nylon 6.10, a polyacrylic synthetic fiber, e.g., polyacrylonitrile or polyalkyl (meth)acrylate and a polyolefin-based synthetic fiber, e.g., polypropylene or polystyrene can be used. For instance, a brush material having a fiber bristle diameter of 20 to 400 µm and a bristle length of 5 to 30 mm can be preferably used.
The outer diameter of the rotating brush roller is preferably from 30 to 200 mm, and the peripheral velocity at the tip of the brush rubbing the plate surface is preferably from 0.1 to 5 m/sec. It is preferred to use a plurality of the rotating brush rollers.
The rotating direction of the rotating brush roller may be the same direction or the opposite direction with respect to the transporting direction of the lithographic printing plate precursor, but when two or more rotating brush rollers are used, it is preferred that at least one rotating brush roller rotates in the same direction and at least one rotating brush roller rotates in the opposite direction with respect to the transporting direction. By such arrangement, the photosensitive layer in the non-image area can be more steadily removed. Further, a technique of rocking the rotating brush roller in the rotation axis direction of the brush roller is also effective.
After the development step, although the developer may be dried by natural drying, it is preferred to provide a drying step using, for example, hot air.
In the method of preparing a lithographic printing plate according to the invention, the entire surface of the lithographic printing plate precursor may be heated between the exposure and the development, if desired. By the heating, the image-forming reaction in the photosensitive layer is accelerated and advantages, for example, improvement in the sensitivity and printing durability and stabilization of the sensitivity may be achieved.
The conditions of the heating can be appropriately determined in a range for providing such effects. Examples of the heating means include a conventional convection oven, an IR irradiation apparatus, an IR laser, a microwave apparatus or a Wisconsin oven. For instance, the heat treatment can be conducted by maintaining the lithographic printing plate precursor at a plate surface temperature ranging from 70 to 150°C for a period of one second to 5 minutes, preferably at 80 to 140°C for 5 seconds to one minute, more preferably at 90 to 130°C for 10 to 30 seconds. In the above-described range, the effects described above are efficiently achieved and an adverse affect, for example, change in shape of the lithographic printing plate precursor due to the heat can be preferably avoided.
It is preferable that heat treatment means used in the heat treatment step is connected with a plate setter used in the exposure step and a development apparatus used in the development processing step and the lithographic printing plate precursor is subjected to automatically continuous processing. Specifically, a plate making line wherein the plate setter and the development apparatus are connected with each other by transport means, for example, a conveyer is illustrated. Also, the heat treatment means may be placed between the plate setter and the development apparatus or the heat treatment means and the development apparatus may constitute a unit apparatus.
In case where the lithographic printing plate precursor used is apt to be influenced by surrounding light under a working environment, it is preferable that the plate making line is blinded by a filter, a cover or the like.
The entire surface of lithographic printing plate after development may be exposed to active ray, for example, ultraviolet light to accelerate curing of the image area. As a light source for the entire surface exposure, for example, a carbon arc lamp, a mercury lamp, a gallium lamp, a metal halide lamp, a xenon lamp, a tungsten lamp or various laser beams is exemplified. In order to obtain sufficient printing durability, the amount of the entire surface exposure is preferably 10 mJ/cm² or more, and more preferably 100 mJ/cm² or more.
Heating may be performed at the same time with the entire surface exposure. By performing the heating, further improvement in the printing durability is recognized. Examples of the heating means include a conventional convection oven, an IR irradiation apparatus, an IR laser, a microwave apparatus or a Wisconsin oven. The plate surface temperature at the heating is preferably from 30 to 150°C, more preferably from 35 to 130°C, and still more preferably from 40 to 120°C. Specifically, a method described in JP-A-2000-89478 can be used.
Further, for the purpose of increasing printing durability, the lithographic printing plate after development can be heated under very strong conditions. The heat temperature is ordinarily in a range of 200 to 500°C. When the temperature is too low, a sufficient effect of strengthening the image may not be obtained, whereas when it is excessively high, problems of deterioration of the support and thermal decomposition of the image area may occur sometimes.
The lithographic printing plate thus-obtained is mounted on an off-set printing machine to use for printing a large number of sheets.

### EXAMPLES

The present invention will be described in more detail with reference to the following examples, but the invention should not be construed as being limited thereto.

### Examples 1 to_24 and Comparative Examples 1 to 9

### [Preparation of Organic pigment dispersion]

### <Organic Pigment Dispersions (1) to (5)>

An organic pigment composition having the composition shown below was stirred to prepare a coarse dispersion. The resulting coarse dispersion was dispersed in a sand mill filled with glass beads of 0.8 mm Φ at a circumferential velocity of 15 m/sec for 30 minutes to prepare Organic Pigment Dispersions (1) to (5), respectively.

| | |
|---|---|
| Propylene glycol monomethyl ether acetate | 17.5 parts by weight |
| Cyclohexanone | 17.5 parts by weight |
| Methoxypropanol | 40.0 parts by weight |
| Pigment dispersant shown in Table A | 10.0 parts by weight |
| Cyan pigment (No. 700-10-FGCY Blue, produced by Toyo Ink Mfg. Co., Ltd.) | 15.0 parts by weight |

### <Organic Pigment Dispersions (6) to (11)>

An organic pigment composition having the composition shown below was stirred to prepare a coarse dispersion. The resulting coarse dispersion was dispersed in a sand mill filled with glass beads of 0.8 mm Φ at a circumferential velocity of 15 m/sec for 30 minutes to prepare Organic Pigment Dispersions (6) to (11), respectively.

| | |
|---|---|
| Propylene glycol monomethyl ether acetate | 17.5 parts by weight |
| Cyclohexanone | 17.5 parts by weight |
| Methoxypropanol | 40.0 parts by weight |
| Pigment dispersant shown in Table B | 10,0 parts by weight |
| Cyan pigment (Irgalite Blue GLVO, produced by Ciba) | 15.0 parts by weight |

### [Preparation of Aluminum Support 1]

An aluminum plate (material: JIS A1050) having a thickness of 0.3 mm was subjected to a degrease treatment with an aqueous 10% by weight sodium aluminate solution at 50°C for 30 seconds in order to remove rolling oil on the surface thereof. Thereafter, the aluminum plate surface was grained using three nylon brushes implanted with bundled bristles having a diameter of 0.3 mm and an aqueous suspension (specific gravity: 1.1 g/cm³) of pumice having a median diameter of 25 µm, and then thoroughly washed with water. The plate was etched by dipping it in an aqueous 25% by weight sodium hydroxide solution at 45°C for 9 seconds and after washing with water, dipped in an aqueous 20% by weight nitric acid solution at 60°C for 20 seconds, followed by washing with water. The etching amount of the grained surface was about 3 g/m². Subsequently, the aluminum plate was subjected to a continuous electrochemical surface roughening treatment using alternate current voltage of 60 Hz. The electrolytic solution used was an aqueous 1% by weight nitric acid solution (containing 0.5% by weight of aluminum ion) at a liquid temperature of 50°C. The electrochemical surface roughening treatment was performed using a rectangular wave alternate current having a trapezoidal waveform such that the time TP necessary for the current value to reach the peak from zero was 0.8 msec and the duty ratio was 1:1, and disposing a carbon electrode as the counter electrode. The auxiliary anode used was a ferrite. The current density was 30 A/dm² in terms of the peak value of current, and 5% of the current flowing from the power source was divided to the auxiliary anode. The quantity of electricity at the nitric acid electrolysis was 175 C/dm² when the aluminum plate was serving as the anode. Then, the aluminum plate was washed with water by spraying.
Then, the aluminum plate was subjected to an electrochemical surface roughening treatment in the same manner as in the nitric acid electrolysis above using, as the electrolytic solution, an aqueous 0.5% by weight hydrochloric acid solution (containing 0.5% by weight of aluminum ion) at a liquid temperature of 50°C under the conditions that the quantity of electricity was 50 C/dm² when the aluminum plate was serving as the anode, and then washed with water by spraying. The plate was then treated in an aqueous 15% by weight sulfuric acid solution (containing 0.5% by weight of aluminum ion) as the electrolytic solution at a current density of 15 A/dm² to provide a direct current anodic oxide film of 2.5 g/m², thereafter washed with water and dried.
The center line average roughness (Ra) of Aluminum Support 1 thus-obtained was measured using a stylus having a diameter of 2 µm and found to be 0.51 µm.
Further, Undercoat Solution (1) shown below was coated using a bar and dried in an oven at 80°C for 10 seconds to prepare a support provided with an undercoat layer having a dry coating amount of 10 mg/m².

**<Undercoat Solution (1)>**

| | |
|---|---|
| Polymer compound shown in Table A | 0.017 g |
| Methanol | 9.00 g |
| Water | 1.00 g |

### [Preparation of Lithographic Printing Plate Precursors (1) to (33)]

On the support provided with the undercoat layer prepared above, Coating Solution (1) for Photosensitive Layer having the composition shown below was coated using a bar and dried in an oven at 70°C for 60 seconds to form a photosensitive layer having a dry coating amount of 1.1 g/m². On the photosensitive layer, Coating Solution (1) for Protective Layer having the composition shown below was coated using a bar to have a dry coating amount of 0.75 g/m² and dried at 125°C for 70 seconds to prepare Lithographic Printing Plate Precursors (1) to (33), respectively.

**<Coating Solution (1) for Photosensitive Layer>**

| | |
|---|---|
| Binder Polymer (1) shown below (weight average molecular | 0.54 g |
| weight: 80,000, acid value: 0 meq/g) | |
| Polymerizable compound | 0.40 g |
| Isocyanuric acid EO-modified triacrylate (Aronix M-315, produced by Toagosei Co., Ltd.) | |
| Polymerizable compound | 0.08 g |
| Ethoxylated trimethylolpropane triacrylate (SR9035, EO | |
| addition molar number: 15, molecular weight: 1,000, | |
| produced by Nippon Kayaku Co., Ltd.) | |
| Sensitizing Dye (1) shown below | 0.06 g |
| Polymerization Initiator (1) shown below | 0.18 g |
| Co-sensitizer (1) shown below | 0.07 g |
| Organic pigment dispersion shown in Table A | 0.40 g |
| Thermal polymerization inhibitor | 0.01 g |
| N-nitrosophenylhydroxylamine aluminum salt | |
| Fluorine-Based Surfactant (1) shown below (weight average | 0.001 g |
| molecular weight: 11,000) | |
| Polyoxyethylene-polyoxypropylene condensate | 0.04 g |
| (Pluronic L44, produced by ADEKA Corp.) | |
| 1-Methoxy-2-propanol | 3.5 g |
| Methyl ethyl ketone | 8.0 g |

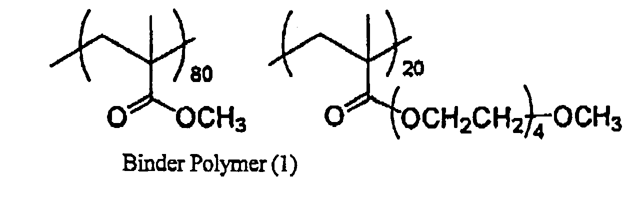

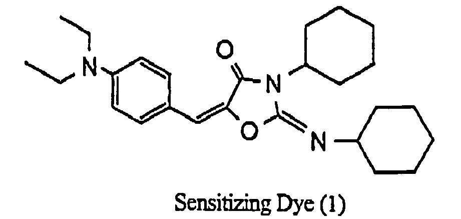

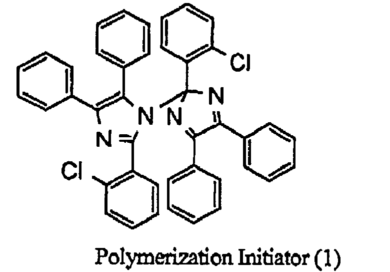

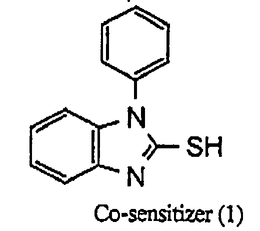

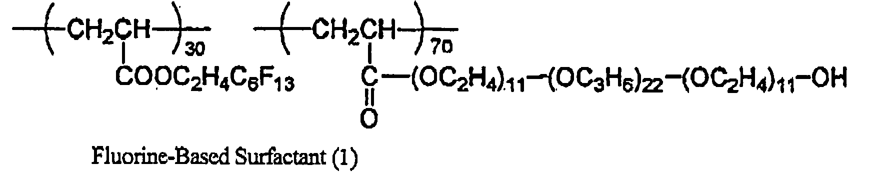

**<Coating Solution (1) for Protective Layer>**

| | |
|---|---|
| Polyvinyl alcohol (saponification degree: 98% by mole; polymerization degree: 500) | 40 g |
| Polyvinyl pyrrolidone (weight average molecular weight: 50,000) | 5 g |
| Vinyl pyrrolidone/vinyl acetate (1/1) copolymer (weight average molecular weight: 70,000) | 0.5 g |
| Surfactant (Emalex 710, produced by Nihon-Emulsion Co., Ltd.) | 0.5 g |
| Water | 950 g |

(1) Exposure, Development and Printing Each of Lithographic Printing Plate Precursors (1) to (33) was subjected to imagewise exposure of 50% halftone dot image using a semiconductor laser of 405 nm having an output of 100 mW under conditions of plate surface exposure amount of 300 µJ/cm² and 100 lpi.
Then, development processing was performed in an automatic development processor having a structure as shown in Fig. 1 using Developer (1) having the composition shown below to prepare a lithographic printing plate. The automatic development processor was an automatic processor having two rotating brush rollers. As for the rotating brush rollers used, the first brush roller was a brush roller having an outer diameter of 90 mm and being implanted with fiber of polybutylene terephthalate (bristle diameter: 200 µm, bristle length: 17 mm), and the brush roller was rotated at 200 rpm in the same direction as the transporting direction (peripheral velocity at the tip of brush: 0.94 m/sec). The second brush roller was a brush roller having an outer diameter of 60 mm and being implanted with fiber of polybutylene terephthalate (bristle diameter: 200µm, bristle length: 17 mm), and the brush roller was rotated at 200 rpm in the opposite direction to the transporting direction (peripheral velocity at the tip of brush: 0.63 m/sec). The transportation of the lithographic printing plate precursor was performed at a transporting speed of 100 cm/min.
The developer was supplied on the surface of the lithographic printing plate precursor by showering from a spray pipe using a circulation pump. The tank volume for the developer was 10 liters.
On the other hand, each of Lithographic Printing Plate Precursors (1) to (33) was allowed to stand in an oven of 60°C for 3 days to conduct enforced preservation and then subjected to the image exposure and development processing in the same manner as described above to prepare a lithographic printing plate. Developer (1)

| | |
|---|---|
| Water | 100.00 g |
| Benzyl alcohol | 1.00 g |
| Polyoxyethylene naphthyl ether (average number of oxyethylene: n = 13) | 1.00 g |
| Sodium salt of dioctylsulfosuccinic acid ester | 0.50 g |
| Gum arabic (molecular weight: 200,000) | 1.00 g |
| Ethylene glycol | 0.50 g |
| Ammonium primary phosphate | 0.05 g |
| Citric acid | 0.05 g |
| Tetrasodium ethylenediaminetetraacetate | 0.05 g |

(pH of the developer was adjusted to 7.0 using phosphoric acid and sodium hydroxide)
The lithographic printing plate obtained was mounted on a printing machine, SOR-M, produced by Heidelberg, and printing was performed at a printing speed of 6,000 sheets per hour using dampening water (EU-3 (etching solution, produced by Fuji Film Co., Ltd.))/water/isopropyl alcohol = 1/89/10 (by volume ratio)) and TRANS-G(N) black ink (produced by Dainippon Ink & Chemicals, Inc.).
(2) Evaluation

Using the lithographic printing plate precursor without the enforced preservation and the lithographic printing plate prepared therefrom, the coloring property, color remaining property, stain resistance and printing durability were evaluated in the manner shown below. Also, using the lithographic printing plate precursor subjected to the enforced preservation and the lithographic printing plate prepared therefrom, the color remaining property and stain resistance were evaluated in the manner shown below. The results obtained are shown in Table A below. In Tables A to D shown below, the term "pka 1" indicates pKa of the pigment-adsorbing group of the pigment dispersant used in the photosensitive layer and "pka 2" indicates pKa of the hydrophilic group of the polymer compound used in the undercoat layer.

### <Coloring Property>

Cyan density of the photosensitive layer of the lithographic printing plate precursor before image exposure was measured by a Macbeth densitometer and the coloring property was evaluated according to the numerical value of density. As the numerical value is large, the coloring property is high.

### <Color Remaining Property>

Cyan density of the non-image area of the lithographic printing plate obtained was measured by a Macbeth densitometer and the color remaining property was evaluated according to the numerical value of density. As the numerical value is small, the color remaining property is good.

### <Stain Resistance>

After performing the printing of 500 sheets under the printing condition described above, ink stain occurred in the non-image area was visually determined on a scale of 1 to 10. Specifically, a case where the non-image area was not stained at all was rated 10 and a case where the non-image area was almost stained with ink attachment was rated 1.

### <Printing Durability>

The printing was performed under the printing condition described above and a number of printed materials obtained until the ink density (reflection density) decreased by 0.1 from that at the initiation of printing was determined to evaluate the printing durability.

**TABLE A**

| | Lithographic Printing Plate Precursor | Organic Pigment Dispersion | | | | Undercoat Layer | | pKa 2 -Pka 1 | Coloring Property | Color Remaining Property | | Stain Resistance | | Printing Durability |
|---|---|---|---|---|---|---|---|---|---|---|---|---|---|---|
| | | No. | Pigment Dispersant | pKa 1 | Average Particle Size (µm) | Polymer Compound | pKa 2 | | | Without Enforced Preservation | With Enforced Preservation | Without Enforced Preservation | With Enforced Preservation | |
| Example 1 | (1) | (1) | PA-1 | -0.56 | 0.125 | P-2 | 1.67 | 2.23 | 1.75 | 0.65 | 0.65 | 10 | 10 | 50,000 |
| Example 2 | (2) | (1) | PA-1 | -0.56 | 0.125 | P-3 | 2.11 | 2.67 | 1.75 | 0.65 | 0.65 | 10 | 10 | 70,000 |
| Example 3 | (3) | (1) | PA-1 | -0.56 | 0.125 | P-4 | 4.25 | 4.81 | 1.75 | 0.64 | 0.64 | 9 | 9 | 60,000 |
| Comparative Example 1 | (4) | (2) | PA-2 | 1.67 | 0.133 | P-2 | 1.67 | 0 | 1.74 | 0.67 | 0.75 | 9 | 7 | 50,000 |
| Example 4 | (5) | (2) | PA-2 | 1.67 | 0.133 | P-3 | 2.11 | 0.44 | 1.74 | 0.66 | 0.66 | 10 | 10 | 70,000 |
| Example 5 | (6) | (2) | PA-2 | 1.67 | 0.133 | P-4 | 4.25 | 2.58 | 1.74 | 0.65 | 0.65 | 9 | 9 | 60,000 |
| Comparative Example 2 | (7) | (3) | PA-4 | 4.24 | 0.141 | P-2 | 1.67 | -2.57 | 1.72 | 0.78 | 0.86 | 5 | 3 | 50,000 |
| Comparative Example 3 | (8) | (3) | PA-4 | 4.24 | 0.141 | P-3 | 2.11 | -2.13 | 1.72 | 0.75 | 0.83 | 5 | 3 | 70,000 |
| Example 6 | (9) | (3) | PA-4 | 4.24 | 0.141 | P-4 | 4.25 | 0.01 | 1.72 | 0.66 | 0.66 | 9 | 9 | 60,000 |
| Comparative Example 4 | (10) | (4) | PA-5 | 1.76 | 0.111 | P-2 | 1.67 | -0.09 | 1.73 | 0.68 | 0.76 | 8 | 5 | 50,000 |
| Example7 | (11) | (4) | PA-5 | 1.76 | 0.111 | P-3 | 2.11 | 0.35 | 1.73 | 0.66 | 0.66 | 10 | 10 | 70,000 |
| Example 8 | (12) | (4) | PA-5 | 1.76 | 0.111 | P-4 | 4.25 | 2.49 | 1.73 | 0.65 | 0.65 | 9 | 9 | 60,000 |
| Comparative Example 5 | (13) | (5) | PA-6 | 2.11 | 0.122 | P-2 | 1.67 | -0.44 | 1.73 | 0.70 | 0.78 | 8 | 4 | 50,000 |
| Comparative Example 6 | (14) | (5) | PA-6 | 2.11 | 0.122 | P-3 | 2.11 | 0 | 1.73 | 0.67 | 0.75 | 9 | 7 | 70,000 |
| Example 9 | (15) | (5) | PA-6 | 2.11 | 0.122 | P-4 | 4.25 | 2.14 | 1.73 | 0.65 | 0.65 | 9 | 9 | 60,000 |
| Comparative Example 7 | (16) | (6) | PB-1 | 8.18 | 0.136 | P-8 | 9.43 | -1.25 | 1.72 | 0.75 | 0.83 | 5 | 3 | 50,000 |
| Comparative Example 8 | (17) | (6) | PB-1 | 8.18 | 0.136 | P-9 | 8.88 | -0.7 | 1.72 | 0.72 | 0.80 | 6 | 3 | 50,000 |
| Example 10 | (18) | (6) | PB-1 | 8.18 | 0.136 | P-18 | 7.53 | 0.65 | 1.72 | 0.66 | 0.66 | 10 | 10 | 60,000 |
| Example 11 | (19) | (7) | PB-2 | 11.69 | 0.118 | P-8 | 9.43 | 2.26 | 1.75 | 0.65 | 0.65 | 9 | 9 | 50,000 |
| Example 12 | (20) | (7) | PB-2 | 11.69 | 0.118 | P-9 | 8.88 | 2.81 | 1.75 | 0.65 | 0.65 | 9 | 9 | 50,000 |
| Example 13 | (21) | (7) | PB-2 | 11.69 | 0.118 | P-18 | 7.53 | 4.16 | 1.75 | 0.64 | 0.64 | 10 | 10 | 60,000 |
| Example 14 | (22) | (8) | PB-3 | 13.33 | 0.138 | P-8 | 9.43 | 3.9 | 1.76 | 0.64 | 0.64 | 9 | 9 | 50,000 |
| Example 15 | (23) | (8) | PB-3 | 13.33 | 0.138 | P-9 | 8.88 | 4.45 | 1.76 | 0.64 | 0.64 | 9 | 9 | 50,000 |
| Example 16 | (24) | (8) | PB-3 | 13.33 | 0.138 | P-18 | 7.53 | 5.8 | 1.76 | 0.64 | 0.64 | 10 | 10 | 60,000 |
| Comparative Example 9 | (25) | (9) | PB-4 | 9.41 | 0.129 | P-8 | 9.43 | -0.02 | 1.72 | 0.68 | 0.76 | 8 | 5 | 50,000 |
| Example 17 | (26) | (9) | PB-4 | 9.41 | 0.129 | P-9 | 8.88 | 0.53 | 1.72 | 0.66 | 0.66 | 9 | 9 | 50,000 |
| Example 18 | (27) | (9) | PB-4 | 9.41 | 0.129 | P-18 | 7.53 | 1.88 | 1.72 | 0.65 | 0.65 | 10 | 10 | 60,000 |
| Example 19 | (28) | (10) | PB-5 | 9.53 | 0.121 | P-8 | 9.43 | 0.1 | 1.73 | 0.66 | 0.66 | 9 | 9 | 50,000 |
| Example 20 | (29) | (10) | PB-5 | 9.53 | 0.121 | P-9 | 8.88 | 0.65 | 1.73 | 0.66 | 0.66 | 9 | 9 | 50,000 |
| Example 21 | (30) | (10) | PB-5 | 9.53 | 0.121 | P-18 | 7.53 | 2 | 1.73 | 0.65 | 0.65 | 10 | 10 | 60,000 |
| Example 22 | (31) | (11) | PB-6 | 12.52 | 0.119 | P-8 | 9.43 | 3.09 | 1.75 | 0.64 | 0.64 | 9 | 9 | 50,000 |
| Example 23 | (32) | (11) | P8-6 | 12.52 | 0.119 | P-9 | 8.88 | 3.64 | 1.75 | 0.64 | 0.64 | 9 | 9 | 50,000 |
| Example 24 | (33) | (11) | PB-6 | 12.52 | 0.119 | P-18 | 7.53 | 4.99 | 1.75 | 0.64 | 0.64 | 10 | 10 | 60,000 |

As is apparent from the results shown in Table A, the lithographic printing plate precursor according to the invention can prepare a lithographic printing plate excellent in the color remaining property in the non-image area and stain resistance during printing while maintaining good printing durability in spite of the development processing with the neutral developer having pH of 7. It is also found that these properties are well kept even when the lithographic printing plate precursor is subjected to the enforced preservation.

### Examples 25 to 26 and Comparative Example 10

### [Preparation of Lithographic Printing Plate Precursors (34) to (36)]

Lithographic Printing Plate Precursors (34) to (36) were prepared in the same manner as in the preparation of Lithographic Printing Plate Precursors (4) to (6) except for changing Coating Solution (1) for Photosensitive Layer to Coating Solution (2) for Photosensitive Layer shown below, respectively.

**<Coating Solution (2) for Photosensitive Layer>**

| | |
|---|---|
| Binder Polymer (4) shown below (weight average molecular weight: 70,000) | 0.54 g |
| Polymerizable Compound (2) shown below | 0.48 g |
| Sensitizing Dye (1) shown above | 0.06 g |
| Polymerization Initiator (1) shown above | 0.18 g |
| Co-sensitizer (1) shown above | 0.07 g |
| Organic pigment dispersion shown in Table B | 0.40 g |
| Thermal polymerization inhibitor N-nitrosophenylhydroxylamine aluminum salt | 0.01 g |
| Fluorine-Based Surfactant (1) shown above | 0.001 g |
| Polyoxyethylene-polyoxypropylene condensate (Pluronic L44, produced by ADEKA Corp.) | 0.04 g |
| 1-Methoxy-2-propanol | 3.5 g |
| Methyl ethyl ketone | 8.0 g |

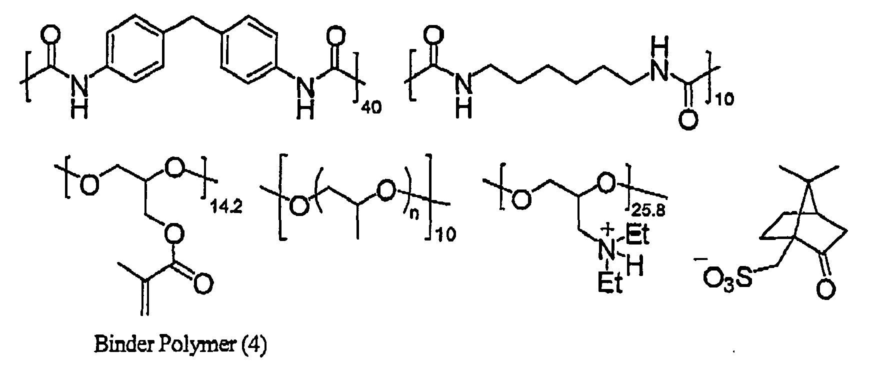

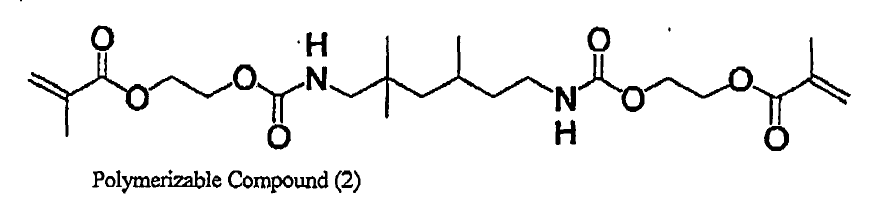

Each of Lithographic Printing Plate Precursors (34) to (36) was subjected to imagewise exposure of 50% halftone dot image using a semiconductor laser of 405 nm having an output of 100 mW under conditions of plate surface exposure amount of 80 µ/cm² and 100 lpi. Within 30 seconds after the image exposure, the exposed lithographic printing plate precursor was put in an oven and heated the entire surface of the lithographic printing plate precursor by blowing hot air to maintain at 110°C for 15 seconds. Thereafter, within 30 seconds, the development processing was performed in the same manner as in Example 1 except for changing Developer (1) to Developer (2) shown below to prepare a lithographic printing plate. The evaluations were conducted in the same manner as in Example 1. The results obtained are shown in Table B.

**Developer (2)**

| | |
|---|---|
| Water | 100.00 g |
| N-Lauryl dimethyl betaine (Pionin C157K, produced by Takemoto Oil & Fat Co., Ltd.) | 10.00 g |
| Polystyrenesulfonic acid | 1.00 g |
| Ammonium primary phosphate | 0.05 g |
| Citric acid | 0.05 g |
| Tetrasodium ethylenediaminetetraacetate (pH of the developer was adjusted to 4.5 using phosphoric acid) | 0.05 g |

**TABLE B**

| | Lithographic Printing Plate Precursor | Organic Pigment Dispersion | | | | Undercoat Layer | | pKa 2-Pka 1 | Coloring Property | Color Remaining Property | | Stain Resistance | | Printing Durability |
|---|---|---|---|---|---|---|---|---|---|---|---|---|---|---|
| | | No. | Pigment Dispersant | pKa 1 | Average Particle Size (µm) | Polymer Compound | pKa 2 | | | Without Enforced Preservation | With Enforced Preservation | Without Enforced Preservation | With Enforced Preservation | |
| Comparative Example 10 | (34) | (2) | PA-2 | 1.67 | 0.133 | P-2 | 1.67 | 0 | 1.74 | 0.67 | 0.75 | 9 | 7 | 60,000 |
| Example 25 | (35) | (2) | PA-2 | 1.67 | 0.133 | P-3 | 2.11 | 0.44 | 1.74 | 0.66 | 0.66 | 10 | 10 | 80,000 |
| Example 26 | (36) | (2) | PA-2 | 1.67 | 0.133 | P-4 | 4.25 | 2.58 | 1.74 | 0.65 | 0.65 | 9 | 9 | 70,000 |

As is apparent from the results shown in Table B, the lithographic printing plate precursor according to the invention can prepare a lithographic printing plate excellent in the color remaining property in the non-image area and stain resistance during printing while maintaining good printing durability in spite of the development processing with the weak acidic developer having pH of 4.5. It is also found that these properties are well kept even when the lithographic printing plate precursor is subjected to the enforced preservation.

### Examples 27 to 28 and Comparative Example 11

### [Preparation of Lithogaphic Printing Plate Precursors (37) to (39)]

Lithographic Printing Plate Precursors (37) to (39) were prepared in the same manner as in the preparation of Lithographic Printing Plate Precursors (10) to (12) except for changing Coating Solution (1) for Photosensitive Layer to Coating Solution (3) for Photosensitive Layer having the composition shown below and Coating Solution (1) for Protective Layer to Coating Solution (2) for Protective Layer having the composition shown below, respectively.

**<Coating Solution (3) for Photosensitive Layer>**

| | |
|---|---|
| Binder Polymer (3) shown below (weight average molecular weight: 50,000) | 0.54 g |
| Polymerizable Compound (2) shown below | 0.48 g |
| Sensitizing Dye (1) shown above | 0.06 g |
| Polymerization Initiator (1) shown above | 0.18 g |
| Co-sensitizer (1) shown above | 0.07 g |
| Organic pigment dispersion shown in Table C | 0.40 g |
| Thermal polymerization inhibitor N-nitrosophenylhydroxylamine aluminum salt | 0.01 g |
| Fluorine-Based Surfactant (I) shown above | 0.001 g |
| Polyoxyethylene-polyoxypropylene condensate (Pluronic L44, produced by ADEKA Corp.) | 0.04 g |
| 1-Methoxy-2-propanol | 3.5 g |
| Methyl ethyl ketone | 8.0 g |

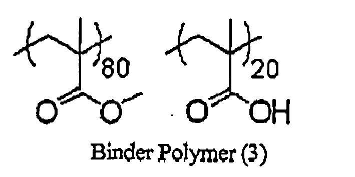

**<Coating Solution (2) for Protective Layer>**

| | |
|---|---|
| Dispersion of Mica (1) shown below | 13.0 g |
| Polyvinyl alcohol (saponification degree: 98% by mole; polymerization degree: 500) | 1.3 g |
| Sodium 2-ethylhexylsulfosuccinate | 0.2 g |
| Vinyl pyrrolidone/vinyl acetate (1/1) copolymer (molecular weight: 70,000) | 0.05 g |
| Surfactant (Emalex 710, produced by Nihon-Emulsion Co., Ltd.) | 0.05 g |
| Water | 133 g |

### (Preparation of Dispersion of Mica (1))

In 368 g of water was added 32 g of synthetic mica (Somasif ME-100, produced by CO-OP Chemical Co., Ltd.; aspect ratio: 1,000 or more) and the mixture was dispersed using a homogenizer until the average particle diameter (measured by a laser scattering method) became 0.5 µm to obtain Dispersion of Mica (1).
Each of Lithographic Printing Plate Precursors (37) to (39) was subjected to the image exposure, heating and development processing in the same manner as in Example 26 except for changing Developer (I) to Developer (3) shown below to prepare a lithographic printing plate. The evaluations were conducted in the same manner as in Example 26. The results obtained are shown in Table C.

**Developer (3)**

| | |
|---|---|
| Water | 100.00 g |
| Benzyl alcohol | 1.00 g |
| Polyoxyethylene naphthyl ether (average number of oxyethylene: n = 13) | 1.00 g |
| Sodium salt of dioctylsulfosuccinic acid ester | 0.50 g |
| Gum Arabic (weight average molecular weight: 200,000) | 1.00 g |
| Ethylene glycol | 0.50 g |
| Ammonium primary phosphate | 0.05 g |
| Citric acid | 0.05 g |
| Sodium carbonate | 1.40 g |
| Sodium hydrogen carbonate | 0.59 g |
| (pH of the developer was adjusted to 9.8 using phosphoric acid and sodium hydroxide) | |

**TABLE C**

| | Lithographic Printing Plate Precursor | Organic Pigment Dispersion | | | | Undercoat Layer | | pKa 2-Pka 1 | Coloring Property | Color Remaining Property | | Stain Resistance | | Printing Durability |
|---|---|---|---|---|---|---|---|---|---|---|---|---|---|---|
| | | No. | Pigment Dispersant | pKa 1 | Average Particle Size (µm) | Polymer Compound | pKa 2 | | | Without Enforced Preservation | With Enforced Preservation | Without Enforced Preservation | With Enforced Preservation | |
| Comparative Example 11 | (37) | (4) | PA-5 | 1.76 | 0.111 | P-2 | 1.67 | -0.09 | 1.73 | 0.7 | 0.76 | 8 | 4 | 80,000 |
| Example 27 | (38) | (4) | PA-5 | 1,76 | 0.111 | P-3 | 2.11 | 0.35 | 1.73 | 0.66 | 0.68 | 9 | 7 | 80,000 |
| Example 28 | (39) | (4) | PA-5 | 1.76 | 0.111 | P-4 | 4.25 | 2.49 | 1.73 | 0.65 | 0.65 | 9 | 9 | 70,000 |

As is apparent from the results shown in Table C, the lithographic printing plate precursor according to the invention can prepare a lithographic printing plate excellent in the color remaining property in the non-image area and stain resistance during printing while maintaining good printing durability in spite of the development processing with the weak alkaline developer having pH of 9.8. It is also found that these properties are well kept even when the lithographic printing plate precursor is subjected to the enforced preservation.

### Examples 29 to 32 and Comparative Examples 12 to 13

### [Preparation of Lithographic Printing Plate Precursors (40) to (45)]

### [Preparation of Aluminum Support 2]

An aluminum plate (material: JIS A1050) having a thickness of 0.3 mm was subjected to surface treatment by performing processes (a) to (k) shown below in this order.
(a) Mechanical surface roughening treatment
   Mechanical surface roughening of the aluminum plate was conducted by means of rotating roller-form nylon brushes while supplying a suspension (having specific gravity of 1.12) of an abrasive (silica sand) in water as an abrasion slurry solution to the surface of the aluminum plate. The average particle size of the abrasive was 8 µm and the maximum particle size was 50 µm. The material of the nylon brush was 6·10 nylon, and the brush has a bristle length of 50 mm and a bristle diameter of 0.3 mm. The nylon brush was made by making holes in a stainless steel cylinder having a diameter of 300 mm and densely filling the brush bristles. Three of the rotating nylon brushes were used. Two supporting rollers (each having a diameter of 200 mm) provided under the brush rollers were spaced 300 mm. The brush rollers were pressed against the aluminum plate till the load applied to a driving motor for rotating the brush became 7 kW greater than the load before pressing the brush rollers against the aluminum plate. The rotating direction of the brushes was the same as the moving direction of the aluminum plate. The rotation number of the brushe was 200 rpm.
(b) Alkali etching treatment
   Etching treatment of the aluminum plate was conducted by spraying an aqueous sodium hydroxide solution (sodium hydroxide concentration: 26% by weight, aluminum ion concentration: 6.5% by weight) having temperature of 70°C to dissolve the aluminum plate in an amount of 6 g/m², followed by washing by spraying well water.
(c) Desmut treatment
   Desmut treatment of the aluminum plate was conducted by spraying an aqueous 1% by weight nitric acid solution (containing 0.5% by weight of aluminum ion) having temperature of 30°C, followed by washing with water by spraying. The aqueous nitric acid solution used for the desmut treatment was a waste solution of the process of conducting electrochemical surface roughening treatment using alternating current in an aqueous nitric acid solution.
(d) Electrochemical surface roughening treatment
   Electrochemical surface roughening treatment of the aluminum plate was continuously conducted by applying 60 Hz alternating current voltage. The electrolytic solution used was an aqueous solution containing 10.5 g/liter of nitric acid (containing 5 g/liter of aluminum ion) and the solution temperature was 50°C. The electrochemical surface roughening treatment was conducted using an alternating current source, which provided a trapezoidal rectangular wave alternating current where time (TP) for reaching the current to its peak from zero was 0.8 msec and a duty ratio was 1:1, and using a carbon electrode as a counter electrode. A ferrite was used as an auxiliary anode. The electrolytic cell used was a radial cell type. The current density was 30 A/dm² at the peak current, and the electric amount was 220 C/dm² in terms of the total electric quantity during the aluminum plate functioning as an anode. To the auxiliary anode, 5% of the current from the electric source was divided. Subsequently, the plate was washed by spraying well water.
(e) Alkali etching treatment
   Etching treatment of the aluminum plate was conducted at 32°C by spraying an aqueous solution having a sodium hydroxide concentration of 26% by weight and an aluminum ion concentration of 6.5% by weight to dissolve the aluminum plate in an amount of 0.20 g/m². Thus, the smut component mainly comprising aluminum hydroxide formed in the precedent process of conducting electrochemical surface roughening treatment using alternating current was removed and an edge portion of the pit formed was dissolved to smoothen the edge portion. Subsequently, the plate was washed by spraying well water.
(f) Desmut treatment
   Desmut treatment of the aluminum plate was conducted by spraying an aqueous 15% by weight nitric acid solution (containing 4.5% by weight of aluminum ion) having temperature of 30°C, followed by washing by spraying well water. The aqueous nitric acid solution used for the desmut treatment was a waste solution of the process of conducting electrochemical surface roughening treatment using alternating current in an aqueous nitric acid solution.
(g) Electrochemical surface roughening treatment.
   Electrochemical surface roughening treatment of the aluminum plate was continuously conducted by applying 60 Hz alternating current voltage. The electrolytic solution used was an aqueous solution containing 7.5 g/liter of hydrochloric acid (containing 5 g/liter of aluminum ion) and the solution temperature was 35°C. The electrochemical surface roughening treatment was conducted using an alternating current source which provided a rectangular wave alternating current and using a carbon electrode as a counter electrode. A ferrite was used as an auxiliary anode. The electrolytic cell used was a radial cell type. The current density was 25 A/dm² at the peak current, and the electric amount was 50 C/dm² in terms of the total electric quantity during the aluminum plate functioning as an anode. Subsequently, the plate was washed by spraying well water.
(h) Alkali etching treatment
   Etching treatment of the aluminum plate was conducted at 32°C by spraying an aqueous solution having a sodium hydroxide concentration of 26% by weight and an aluminum ion concentration of 6.5% by weight to dissolve the aluminum plate in an amount of 0.10 g/m². Thus, the smut component mainly comprising aluminum hydroxide formed in the precedent process of conducting electrochemical surface roughening treatment using alternating current was removed and an edge portion of the pit formed was dissolved to smoothen the edge portion. Subsequently, the plate was washed by spraying well water.
(i) Desmut treatment
   Desmut treatment of the aluminum plate was conducted by spraying an aqueous 25% by weight sulfuric acid solution (containing 0.5% by weight of aluminum ion) having temperature of 60°C, followed by washing by spraying well water.
(j) Anodizing treatment
   Anodizing treatment of the aluminum plate was conducted using sulfuric acid as an electrolytic solution. The sulfuric acid concentration of the electrolytic solution was 170 g/liter (containing 0.5% by weight of aluminum ion) and the temperature was 43°C. The current density was about 30 A/dm². Subsequently, the plate was washed by spraying well water. The amount of the final anodic oxide film was 2.7 g/m².
(k) Alkali metal silicate treatment
   Alkali metal silicate treatment (silicate treatment) of the aluminum plate was conducted by immersing the aluminum plate in an aqueous 1% by weight sodium silicate No. 3 solution having temperature of 30°C for 10 seconds. Subsequently, the plate was washed by spraying well water, whereby Aluminum Support 2 was prepared. The adhesion amount of the silicate was 3.6 mg/m².

### (Formation of Undercoat layer)

A coating solution for undercoat layer having the composition shown below was coated on the surface of Aluminum Support 2 so as to have a dry coating amount of 10 mg/m² and dried at 100°C for one minute to form an undercoat layer.

**<Coating solution for Undercoat layer>**

| | |
|---|---|
| Polymer compound shown in Table D | 1 g |
| Methanol | 1,000 g |

### (Formation of Photosensitive layer)

Then, Coating Solution (4) for Photosensitive Layer having the composition shown below was coated using a bar and dried in an oven at 70°C for 60 seconds to from a photosensitive layer having a dry coating amount of 1.0 g/m².

**<Coating Solution (4) for Photosensitive Layer>**

| | |
|---|---|
| Binder Polymer (2) shown below (weight average molecular weight: 80,000) | 0.50 g |
| Polymerizable compound Isocyanuric acid EO-modified triacrylate (NK Ester M-315, produced by Shin-Nakamura Chemical Co., Ltd.) | 1.15 g |
| Polymerization Initiator (1) shown below | 0.20 g |
| Infrared Absorbing Agent (1) shown below | 0.05 g |
| Microcapsule Solution (1) shown below | 2.00 g |
| Fluorine-Based Surfactant (1) shown below (weight average molecular weight: 11,000) | 0.05 g |
| Organic pigment dispersion shown in Table D | 0.40 g |
| 1-Methoxy-2-propanol | 18.00 g |

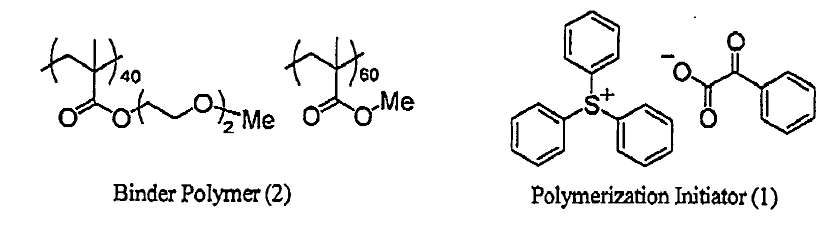

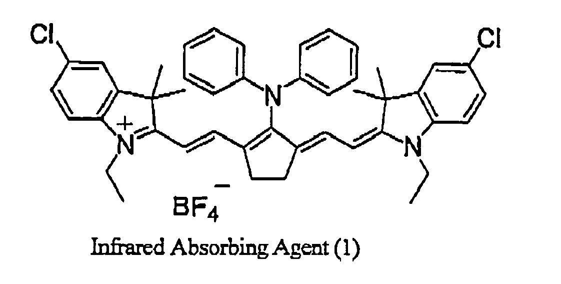

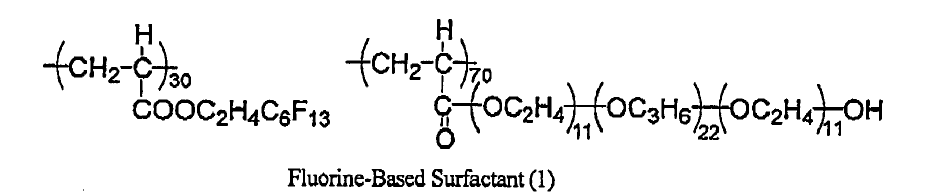

### <Microcapsule Solution (1)>

As an oil phase component, 10 g of adduct of trimethylolpropane and xylene diisocyanate (Takenate D-110N, produced by Mitsui Takeda Chemicals, Inc.), 3.15 g of pentaerythritol triacrylate (SR444, produced by Nippon Kayaku Co., Ltd.), 0.35 g of Infrared Absorbing Agent (2) shown below and 0.1 g of Pionin A-41C (produced by Takemoto Oil & Fat Co., Ltd.) were dissolved in 17 g of ethyl acetate. As an aqueous phase component, 40 g of an aqueous 4% by weight PVA-205 solution was prepared. The oil phase component and the aqueous phase component were mixed and emulsified using a homogenizer at 12,000 rpm for 10 minutes. The resulting emulsion was added to 25 g of distilled water and the mixture was stirred at room temperature for 30 minutes and then stirred at 40°C for 3 hours. The thus-obtained microcapsule solution was diluted with distilled water to have a solid content concentration of 20% by weight to prepare Microcapsule Solution (1). The average particle size of the microcapsule was 0.3 µm.

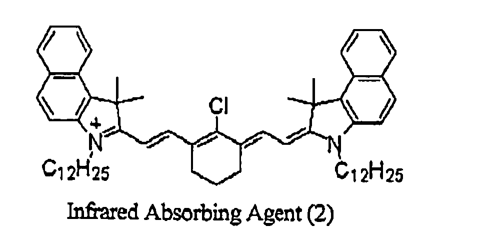

### (Formation of Protective layer)

Coating Solution (2) for Protective Layer described above was coated on the photosensitive layer so as to have a dry coating amount of 0.5 g/m² and dried at 100°C for one minute to form a protective layer, thereby preparing Lithographic Printing Plate Precursors (40) to (45), respectively.
Each of Lithographic Printing Plate Precursors (40) to (45) was subjected to imagewise exposure of 50% halftone dot image by Trendsetter 3244VX, produced by Creo Co., equipped with a water-cooled 40 W infrared semiconductor laser under the conditions of output of 9W, a rotational number of an external drum of 210 rpm and resolution of 2,400 dpi. and subjected to the development processing in the same manner as in Example 1 to prepare a lithographic printing plate. The evaluations were conducted in the same manner as in Example 1. The results obtained are shown in Table D.

**TABLED**

| | Lithographic Printing Plate Precursor | Organic Pigment Dispersion | | | | Undercoat Layer | | pKa 2-Pka 1 | Coloring Property | Color Remaining Property | | Stain Resistance | | Printing Durability |
|---|---|---|---|---|---|---|---|---|---|---|---|---|---|---|
| | | No. | Pigment Dispersant | pKa 1 | Average Particle Size (µm) | Polymer Compound | pKa 2 | | | Without Enforced Preservation | With Enforced Preservation | Without Enforced Preservation | With Enforced Preservation | |
| Comparative Example 12 | (40) | (2) | PA-2 | 1.67 | 0.133 | P-2 | 1.67 | 0 | 1.74 | 0.68 | 0.76 | B | 5 | 20,000 |
| Example 29 | (41) | (2) | PA-2 | 1.67 | 0.133 | P-3 | 2.11 | 0.44 | 1.74 | 0.66 | 0.66 | 10 | 10 | 30.000 |
| Example 30 | (42) | (2) | PA-2 | 1.67 | 0.133 | P-4 | 4.25 | 2.58 | 1.74 | 0.65 | 0.65 | 9 | 9 | 25,000 |

| TABLE D (cont'd) | | | | | | | | | | | | | | |
|---|---|---|---|---|---|---|---|---|---|---|---|---|---|---|
| | Lithographic Printing Plate Precursor | Organic Pigment Dispersion | | | | Undercoat Layer | | pKa 2-Pka 1 | Coloring Properly | Color Remaining Property | | Stain Resistance | | Printing Durability |
| | | No. | Pigment Dispersant | pKa 1 | Average Particle Size (µm) | Polymer Compound | pKa 2 | | | Without Enforced Preservation | With Enforced Preservation | Without Enforced Preservation | With Enforced Preservation | |
| Comparative Example 13 | (43) | (9) | P&4 | 9.41 | 0.129 | P-8 | 9.43 | -0.02 | 1.72 | 0.68 | 0.76 | 8 | 5 | 25.000 |
| Example 31 | (44) | (9) | PB-4 | 9.41 | 0.129 | P-9 | 8.88 | 0.53 | 1.72 | 0.66 | 0.66 | 9 | 9 | 25.000 |
| Example 32 | (45) | (9) | PB-4 | 9.41 | 0.129 | P-18 | 7.53 | 1.88 | 1.72 | 0.66 | 0.65 | 10 | 10 | 25.000 |

As is apparent from the results shown in Table D, in case of changing the exposure light source, the lithographic printing plate precursor according to the invention can also prepare a lithographic printing plate excellent in the color remaining property in the non-image area and stain resistance during printing while maintaining good printing durability in spite of the development processing with the neutral developer having pH of 7. It is also found that these properties are well kept even when the lithographic printing plate precursor is subjected to the enforced preservation.

## Claims

1. A lithographic printing plate precursor capable of being developed with a developer having pH of from 2 to 11, comprising, in the following order:
a support;
au undercoat layer comprising a polymer compound having at least a unit containing a support-adsorbing group and a unit containing a hydrophilic group; and
a photosensitive layer comprising a pigment which does not adsorb to the polymer compound.

2. The lithographic printing plate precursor as claimed in claim 1, wherein the pigment is dispersed with a pigment dispersant having a unit containing a pigment-adsorbing group, and the hydrophilic group and the pigment-adsorbing group satisfy at least one of the following conditions 1 and 2:
Condition 1: When the hydrophilic group is an acidic group and the pigment-adsorbing group is an acidic group, pKa of the hydrophilic group > pKa of the pigment-adsorbing group;
Condition 2: When the hydrophilic group is a basic group and the pigment-adsorbing group is a basic group, pKa of a conjugate acid of the hydrophilic group < pKa of a conjugate acid of the pigment-adsorbing group.

3. The lithographic printing plate precursor as claimed in claim 2, wherein the acidic group is selected from a carboxyl group, a sulfonic acid group, a phosphoric acid group, a phosphonic acid group and a sulfuric acid group, and the basic group is selected from an amino group.

4. The lithographic printing plate precursor as claimed in claim 2, wherein the pigment-adsorbing group is selected from functional groups represented by the following formulae (A-1) to (A-5) and (B-1): 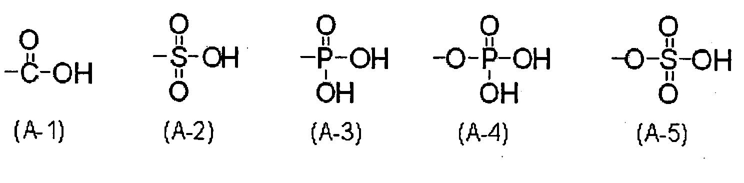 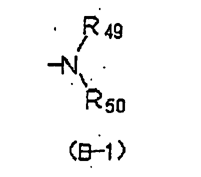 wherein, in the formula (B-1), R₄₉ and R₅₀ each independently represents an alkyl group, an aryl group, an alkenyl group, an alkynyl group, -OR, -NRR', -SR, -COR, -COOR, -CONRR',
- OCOR, -OCONRR', -OCOOR, -NRCOR', -NRCOOR', -NRCONR'R", -N=R, -SO₂F, -SO₃R,
- SO₂NRR', a hydrogen atom, a halogen atom, a cyano group, a nitro group, a hydroxy group or a mercapto group in which R, R' and R" each independently represents an alkyl group, an aryl group, an alkenyl group, an alkynyl group or a hydrogen atom or may be connected with each other to form a ring, or R₄₉ and R₅₀ may be connected with each other to form a ring.

5. The lithographic printing plate precursor as claimed in claim 4, wherein the pigment-adsorbing group is selected from the functional groups represented by the formulae (A-2), (A-5) and (B-1).

6. The lithographic printing plate precursor as claimed in any one of claims 1 to 5, wherein the photosensitive layer further comprises a radical polymerizable compound, a radical polymerization initiator, a sensitizing dye, a co-sensitizer and a binder polymer.

7. The lithographic printing plate precursor as claimed in any one of claims 1 to 6, which further comprises a protective layer, so that the support, the undercoat layer, the photosensitive layer and the protective layer are provided in this order.

8. A method for preparing a lithographic printing plate comprising:
exposing imagewise a lithographic printing plate precursor comprising in the following order, a support, au undercoat layer containing a polymer compound having at least a unit containing a support-adsorbing group and a unit containing a hydrophilic group and a photosensitive layer containing a pigment which does not adsorb to the polymer compound with a laser; and
removing an unexposed area of the photosensitive layer in the presence of a developer having pH of from 2 to 11.

9. The method for preparing a lithographic printing plate as claimed in claim 8, wherein the pigment is dispersed with a pigment dispersant having a unit containing a pigment-adsorbing group, and the hydrophilic group and the pigment-adsorbing group satisfy at least one of the following conditions 1 and 2:
Condition 1: When the hydrophilic group is an acidic group and the pigment-adsorbing group is an acidic group, pKa of the hydrophilic group > pKa of the pigment-adsorbing group;
Condition 2: When the hydrophilic group is a basic group and the pigment-adsorbing group is a basic group, pKa of a conjugate acid of the hydrophilic group < pKa of a conjugate acid of the pigment-adsorbing group.

10. The method for preparing a lithographic printing plate as claimed in claim 9, wherein the acidic group is selected from a carboxyl group, a sulfonic acid group, a phosphoric acid group, a phosphonic acid group and a sulfuric acid group, and the basic group is selected from an amino group.

11. The method for preparing a lithographic printing plate as claimed in claim 9, wherein the pigment-adsorbing group is selected from functional groups represented by the following fonnulae (A-1) to (A-5) and (B-1): 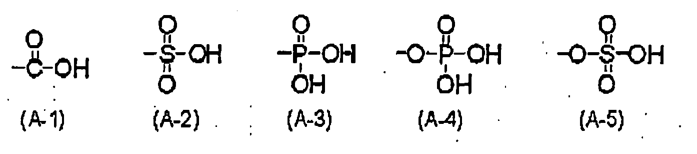 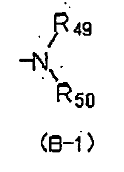 wherein, in the formula (B-1), R₄₉ and R₅₀ each independently represents an alkyl group, an aryl group, an alkenyl group, an alkynyl group, -OR, -NRR', -SR, -COR, -COOR, -CONRR',
- OCOR, -OCONRR', -OCOOR, -NRCOR', -NRCOOR', -NRCONR'R", -N=R, -SO₂R, -SO₃R,
- SO₂NRR', a hydrogen atom, a halogen atom, a cyano group, a nitro group, a hydroxy group or a mercapto group in which R, R' and R" each independently represents an alkyl group, an aryl group, an alkenyl group, an alkynyl group or a hydrogen atom or may be connected with each other to form a ring, or R₄₉ and R₅₀ may be connected with each other to form a ring.

12. The method for preparing a lithographic printing plate as claimed in claim 11, wherein the pigment-adsorbing group is selected from the functional groups represented by the formulae (A-2), (A-5) and (B-1).

13. The method for preparing a lithographic printing plate as claimed in any one of claims 8 to 12, wherein the photosensitive layer further contains a radical polymerizable compound, a radical polymerization initiator, a sensitizing dye, a co-sensitizer and a binder polymer.

14. The method for preparing a lithographic printing plate as claimed in any one of claims 8 to 13, wherein the lithographic printing plate precursor further comprises a protective layer, so that the support, the undercoat layer, the photosensitive layer and the protective layer are provided in this order.

15. The method for preparing a lithographic printing plate as claimed in any one of claims 8 to 14, wherein after the imagewise exposure of the lithographic printing plate precursor with a laser, the exposed lithographic printing plate precursor is heated at temperature of 70°C or more and then the unexposed area of the photosensitive layer is removed in the presence of a developer having pH of from 2 to 11.
